(19) Europäisches Patentamt / European Patent Office / Office européen des brevets

(11) **EP 4 418 687 A1**

(12) **EUROPEAN PATENT APPLICATION**
published in accordance with Art. 153(4) EPC

(43) Date of publication:
**21.08.2024 Bulletin 2024/34**

(21) Application number: **22947552.0**

(22) Date of filing: **28.07.2022**

(51) International Patent Classification (IPC):
**H04R 17/00** $^{(2006.01)}$

(52) Cooperative Patent Classification (CPC):
**H04R 1/02; H04R 1/28; H04R 17/00**

(86) International application number:
**PCT/CN2022/108479**

(87) International publication number:
**WO 2023/245807 (28.12.2023 Gazette 2023/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.06.2022 CN 202210707415**

(71) Applicant: **Shenzhen Shokz Co., Ltd.**
**Shenzhen, Guangdong 518108 (CN)**

(72) Inventors:
• **ZHOU, Wenbing**
  **Guangdong 518108 (CN)**
• **ZHANG, Lei**
  **Guangdong 518108 (CN)**
• **WANG, Qingyi**
  **Guangdong 518108 (CN)**
• **QI, Xin**
  **Guangdong 518108 (CN)**
• **LIAO, Fengyun**
  **Guangdong 518108 (CN)**

(74) Representative: **Wang, Bo**
**Panovision IP**
**Ebersberger Straße 3**
**85570 Markt Schwaben (DE)**

(54) **LOUDSPEAKER**

(57) The present disclosure provides a loudspeaker, comprising: a driving component configured to generate a vibration based on an electrical signal; a vibration component configured to receive the vibration of the driving component to vibrate; and a housing, wherein the driving component and the vibration component are disposed in a cavity formed by the housing. The cavity includes a front cavity disposed at one side of the vibration component and one or more rear cavities disposed at another side of the vibration component. The housing includes a rear cavity plate. At least one of the one or more rear cavities is at least enclosed by the driving component, the vibration component, and the rear cavity plate. The rear cavity plate is provided with one or more through holes.

FIG. 30

## Description

### CROSS-REFERENCE TO RELATED APPLICATIONS

This application claims priority to Chinese Application No. 202210707415.7, filed on June 21, 2022, the entire contents of each of which are incorporated herein by reference.

### TECHNICAL FIELD

The present application relates to the field of acoustic technology, and in particular to a loudspeaker.

### BACKGROUND

A loudspeaker is a commonly used electroacoustic transducer device, which mainly includes a housing, and a vibration component and a driving component disposed in the housing. The vibration component generally separates the interior of the housing into two cavities, for example, a front cavity and a rear cavity. The driving component is disposed in the rear cavity. As the air in the rear cavity acts on the vibration component and the driving component, the performance of the loudspeaker may be affected. Accordingly, it is desirable to provide a loudspeaker that improves the effect of air in the rear cavity on the performance of the loudspeaker.

### SUMMARY

Embodiments of the present disclosure provide a loudspeaker, comprising: a driving component configured to generate a vibration based on an electrical signal; a vibration component configured to receive the vibration of the driving component to vibrate; and a housing, wherein the driving component and the vibration component may be disposed in a cavity formed by the housing. The cavity may include a front cavity disposed at one side of the vibration component and one or more rear cavities disposed at another side of the vibration component. The housing may include a rear cavity plate. At least one of the one or more rear cavities may be at least enclosed by the driving component, the vibration component, and the rear cavity plate. The rear cavity plate may be provided with one or more through holes.

In some embodiments, a vibration surface of the driving component may form at least a portion of a sidewall of the at least one of the one or more rear cavities.

In some embodiments, the driving component may include a piezoelectric acoustic driver.

In some embodiments, the piezoelectric acoustic driver may include cantilever beams.

In some embodiments, a gap between the adjacent cantilever beams may not be greater than 25 $\mu$m.

In some embodiments, no less than 90% of a surface region on the vibration surface of the driving component may be continuous.

In some embodiments, the driving component may include a piezoelectric membrane.

In some embodiments, the one or more rear cavities may include at least two rear cavities, and the at least two rear cavities may communicate with each other through the one or more through holes.

In some embodiments, the housing may include a rear cavity portion. The rear cavity portion, the rear cavity plate, and the driving component may enclose a first rear cavity. The driving component, the vibration component, the rear cavity portion, and the rear cavity plate may enclose a second rear cavity.

In some embodiments, the rear cavity portion may include a side plate and a sealing plate.

In some embodiments, the at least two rear cavities may communicate with an outside through one or more sound guiding holes disposed on the rear cavity portion.

In some embodiments, a difference between a distance from a centerline of at least one of the one or more through holes to a centerline of the cavity and an equivalent radius of the driving component and a difference between an equivalent radius of the cavity and the equivalent radius of the driving component may have a first preset ratio. The first preset ratio may be within a range of 0.3-0.9.

In some embodiments, in a plane perpendicular to the centerline of the cavity, a sum of projection areas of the one or more through holes in the plane and a difference between a projection area of the cavity in the plane and a projection area of the driving component in the plane may have a second preset ratio. The second preset ratio may be within a range of 0.02-1.

In some embodiments, an aperture diameter of at least one of the one or more through holes may be within a range of 0.2 mm-2 mm.

In some embodiments, at least one of the one or more through holes may be provided with a damping net.

In some embodiments, an acoustic impedance of the damping net may be within a range of 3 MKS rayls-10000 MKS rayls.

In some embodiments, a pore size of the damping net may be within a range of 18 $\mu$m-285 $\mu$m.

In some embodiments, a porosity of the damping net may be within a range of 13%-44%.

### BRIEF DESCRIPTION OF THE DRAWINGS

The present disclosure will be further illustrated by way of exemplary embodiments, which will be described in detail with reference to the accompanying drawings. These embodiments are not limiting, and in these embodiments, the same numbering denotes the same structure, wherein:

FIG. 1 is a schematic diagram illustrating a vibration component and an equivalent vibration model thereof according to some embodiments of the present disclosure;

FIG. 2 is a schematic diagram illustrating a deformation of a vibration component at a first resonance peak according to some embodiments of the present disclosure;

FIG. 3 is a schematic diagram illustrating deformations of a vibration component at a second resonance peak according to some embodiments of the present disclosure;

FIG. 4 is a schematic diagram illustrating deformations of a vibration component at a third resonance peak according to some embodiments of the present disclosure;

FIG. 5 is a schematic diagram illustrating a deformation of a vibration component at a fourth resonance peak according to some embodiments of the present disclosure;

FIG. 6 is a schematic diagram illustrating frequency response curves of vibration components with different differences between a frequency of a third resonance peak and a frequency of a fourth resonance peak according to some embodiments of the present disclosure;

FIG. 7A is a schematic diagram illustrating a frequency response curve of a vibration component according to some embodiments of the present disclosure;

FIG. 7B is a schematic diagram illustrating a frequency response curve of a vibration component according to some embodiments of the present disclosure;

FIG. 7C is a schematic diagram illustrating a frequency response curve of a vibration component according to some embodiments of the present disclosure;

FIG. 7D is a schematic diagram illustrating a frequency response curve of a vibration component according to some embodiments of the present disclosure;

FIG. 8A is a schematic structural diagram illustrating a vibration component according to some embodiments of the present disclosure;

FIG. 8B is a schematic diagram illustrating frequency response curves of vibration components according to some other embodiments of the present disclosure;

FIG. 9A is a schematic diagram illustrating a partial structure of a vibration component according to some embodiments of the present disclosure;

FIG. 9B is a schematic diagram illustrating frequency response curves of vibration components according to some embodiments of the present disclosure;

FIG. 9C is a schematic diagram illustrating frequency response curves of vibration components according to some embodiments of the present disclosure;

FIG. 10A is a schematic diagram illustrating a deformation of a vibration component at a fourth resonance peak according to some embodiments of the present disclosure;

FIG. 10B is a schematic diagram illustrating frequency response curves of vibration components according to some embodiments of the present disclosure;

FIG. 10C is a schematic diagram illustrating frequency response curves of vibration components according to some embodiments of the present disclosure;

FIG. 11 is a schematic diagram illustrating deformations of vibration components at a fourth resonance peak according to some embodiments of the present disclosure;

FIG. 12A is a schematic diagram illustrating frequency response curves of the vibration components in FIG. 11;

FIG. 12B is a schematic diagram illustrating frequency response curves of vibration components according to some embodiments of the present disclosure;

FIG. 13A is a schematic structural diagram illustrating a vibration component according to some embodiments of the present disclosure;

FIG. 13B is a schematic structural diagram illustrating a vibration component according to some embodiments of the present disclosure;

FIG. 14A is a schematic structural diagram illustrating a vibration component according to some embodiments of the present disclosure;

FIG. 14B is a schematic structural diagram illustrating a vibration component according to some embodiments of the present disclosure;

FIG. 14C is a schematic structural diagram illustrating a vibration component according to some embodiments of the present disclosure;

FIG. 14D is a schematic structural diagram illustrating a vibration component according to some embodiments of the present disclosure;

FIG. 15A is a schematic structural diagram illustrating a vibration component according to some embodiments of the present disclosure;

FIG. 15B is a schematic structural diagram illustrating a vibration component according to some embodiments of the present disclosure;

FIG. 16A is a schematic structural diagram illustrating a vibration component according to some embodiments of the present disclosure;

FIG. 16B is a schematic structural diagram illustrating a vibration component according to some embodiments of the present disclosure;

FIG. 16C is a schematic structural diagram illustrating a vibration component according to some embodiments of the present disclosure;

FIG. 16D is a schematic structural diagram illustrating a vibration component according to some embodiments of the present disclosure;

FIG. 16E is a schematic structural diagram illustrating a vibration component according to some embodiments of the present disclosure;

FIG. 16F is a schematic diagram illustrating frequency response curves of vibration components according to some embodiments of the present disclosure;

FIG. 17A is a schematic structural diagram illustrating a vibration component according to some embodiments of the present disclosure;

FIG. 17B is a schematic structural diagram illustrating a vibration component according to some embodiments of the present disclosure;

FIG. 17C is a schematic diagram illustrating frequency response curves of vibration components according to some embodiments of the present disclosure;

FIG. 18A is a schematic structural diagram illustrating a vibration component according to some embodiments of the present disclosure;

FIG. 18B is a schematic structural diagram illustrating a vibration component according to some embodiments of the present disclosure;

FIG. 18C is a schematic structural diagram illustrating a vibration component according to some embodiments of the present disclosure;

FIG. 19 is a schematic structural diagram illustrating a vibration component according to some embodiments of the present disclosure;

FIG. 20A is a schematic structural diagram illustrating a vibration component according to some embodiments of the present disclosure;

FIG. 20B is a schematic diagram illustrating frequency response curves of vibration components according to some embodiments of the present disclosure;

FIG. 21A is a schematic structural diagram illustrating a vibration component according to some embodiments of the present disclosure;

FIG. 21B is a schematic structural diagram illustrating a vibration component according to some embodiments of the present disclosure;

FIG. 21C is a schematic structural diagram illustrating a vibration component according to some embodiments of the present disclosure;

FIG. 21D is a schematic structural diagram illustrating a vibration component according to some embodiments of the present disclosure;

FIG. 21E is a schematic structural diagram illustrating a vibration component according to some embodiments of the present disclosure;

FIG. 22 is a schematic structural diagram illustrating a vibration component according to some embodiments of the present disclosure;

FIG. 23 is a schematic structural diagram illustrating a vibration component according to some embodiments of the present disclosure;

FIG. 24A is a schematic structural diagram illustrating a vibration component according to some embodiments of the present disclosure;

FIG. 24B is a schematic structural diagram illustrating a vibration component according to some embodiments of the present disclosure;

FIG. 24C is a schematic diagram illustrating frequency response curves of vibration components according to some embodiments of the present disclosure;

FIG. 25A is a schematic structural diagram illustrating a vibration component according to some embodiments of the present disclosure;

FIG. 25B is a schematic structural diagram illustrating a vibration component according to some embodiments of the present disclosure;

FIG. 25C is a schematic structural diagram illustrating a vibration component according to some embodiments of the present disclosure;

FIG. 26A is a schematic structural diagram illustrating a vibration component according to some embodiments of the present disclosure;

FIG. 26B is a schematic structural diagram illustrating a vibration component according to some embodiments of the present disclosure;

FIG. 26C is a schematic structural diagram illustrating a vibration component according to some embodiments of the present disclosure;

FIG. 26D is a schematic structural diagram illustrating a vibration component according to some embodiments of the present disclosure;

FIG. 26E is a schematic diagram illustrating a cross-sectional structure of a reinforcing member according to some embodiments of the present disclosure;

FIG. 27 is a schematic structural diagram illustrating an exemplary loudspeaker according to some embodiments of the present disclosure;

FIG. 28 is a schematic structural diagram illustrating a loudspeaker according to some embodiments of the present disclosure;

FIG. 29 is a schematic diagram illustrating a loudspeaker and an equivalent model thereof according to some embodiments of the present disclosure;

FIG. 30 is a schematic diagram illustrating a loudspeaker and an equivalent model thereof according to some embodiments of the present disclosure;

FIG. 31 is a schematic diagram illustrating a portion of a stereoscopic structure of a loudspeaker according to some embodiments of the present disclosure;

FIG. 32 is a cross-sectional view illustrating a loudspeaker parallel to an axial direction of a cavity of a housing according to some embodiments of the present disclosure;

FIG. 33 is a view illustrating a loudspeaker perpendicular to an axial direction of a cavity of a housing according to some embodiments of the present disclosure;

FIG. 34 is a schematic diagram illustrating a frequency response curve of a loudspeaker according to some embodiments of the present disclosure;

FIG. 35A is a schematic diagram illustrating a distribution of one or more through holes in a rear cavity plate according to some embodiments of the present disclosure;

FIG. 35B is a schematic diagram illustrating a distribution of one or more through holes in a rear cavity plate according to some embodiments of the present disclosure;

FIG. 35C is a schematic diagram illustrating a distribution of one or more through holes in a rear cavity plate according to some embodiments of the present disclosure;

FIG. 35D is a schematic diagram illustrating a distribution of one or more through holes in a rear cavity plate according to some embodiments of the present disclosure;

FIG. 35E is a schematic diagram illustrating a distribution of one or more through holes in a rear cavity plate according to some embodiments of the present disclosure;

FIG. 35F is a schematic diagram illustrating a distribution of one or more through holes in a rear cavity plate according to some embodiments of the present disclosure;

FIG. 36 is a schematic diagram illustrating a frequency response curve of a loudspeaker at different first preset ratios α according to some embodiments of the present disclosure;

FIG. 37 is a view illustrating a loudspeaker perpendicular to an axial direction of a cavity of a housing according to some embodiments of the present disclosure;

FIG. 38 is a view illustrating a loudspeaker perpendicular to an axial direction of a cavity of a housing according to some embodiments of the present disclosure;

FIG. 39 is a schematic diagram illustrating frequency response curves of a loudspeaker at different second preset ratios β when one or more through holes are round holes according to some embodiments of the present disclosure;

FIG. 40 is a schematic diagram illustrating frequency response curves of a loudspeaker at different second preset ratios β when one or more through holes are fan ring holes according to some embodiments of the present disclosure;

FIG. 41 is a cross-sectional view illustrating a loudspeaker parallel to an axial direction of a cavity of a housing according to some embodiments of the present disclosure;

FIG. 42 is a cross-sectional view illustrating a loudspeaker parallel to an axial direction of a cavity of a housing according to some embodiments of the present disclosure;

FIG. 43 is a cross-sectional view illustrating a loudspeaker parallel to an axial direction of a cavity of a housing according to some embodiments of the present disclosure;

FIG. 44 is a cross-sectional view illustrating a loudspeaker perpendicular to an axial direction of a cavity of a housing according to some embodiments of the present disclosure;

FIG. 45 is a schematic diagram illustrating a frequency response curve of a loudspeaker according to some embodiments of the present disclosure;

FIG. 46 is a cross-sectional view illustrating a loudspeaker parallel to an axial direction of a cavity of a housing according to some embodiments of the present disclosure;

FIG. 47 is a schematic structural diagram illustrating a damping net according to some embodiments of the present disclosure;

FIG. 48 is a schematic structural diagram illustrating a driving unit according to some embodiments of the present disclosure; and

FIG. 49 is a schematic diagram illustrating a frequency displacement curve of a driving unit according to some embodiments of the present disclosure.

Illustration of reference signs: vibration component: 100, 2710; elastic element: 110, 2711; 112, central region: 2711A; suspension region: 1121, 2711E; folded ring region: 114, 2711B; connection region: 115, 2711D; fixed region: 116, 2711C; reinforcing member: 120, 2712; ring structure: 122; first ring structure: 1221; second ring structure: 1222; third ring structure: 1223; central connection part: 123; strip structure: 124; first strip structure: 1241; second strip structure: 1242; third strip structure: 1243; reinforcing portion: 125; local mass structure: 126; hollow-out portion: 127; first resonance peak: 210; second resonance peak: 220; third resonance peak: 230; fourth resonance peak: 240; frequency response curve: 710; frequency response curve: 720; frequency response curve: 810, 820, 830, 910, 920, 940, 950, 1010, 1020, 1030, 1040, 1050, 1060, 1210, 1220, 1230; loudspeaker: 2700, 2800; driving component: 2720; driving unit: 2722; piezoelectric beam: 27221; elastic connector: 27222; gap width: 27223; vibration transmission unit: 2724; housing: 2730; front cavity: 2731; first hole portion: 2732; rear cavity: 2733; first rear cavity: 27331; second rear cavity: 27332; second hole portion: 2734; front cavity plate: 2735; rear cavity plate: 2736; side plate: 2737; sealing plate: 2738; damping net: 27362; gauze wire: 27363; pore: 27364; solder joint: 27365; support element: 2740; through hole: 27361; 27367: central through hole; curve: L341, L342, L343, L361, L362, L363, L364, L391, L392, L393, L394, L395, L401, L402, L403, L404. L451, L452, L491, L492; resonance peak: 4511, 4521; and resonance valley: 3431.

## DETAILED DESCRIPTION

In order to more clearly illustrate the technical solutions related to the embodiments of the present disclosure, a brief introduction of the drawings referred to the description of the embodiments is provided below. Obviously, the drawings described below are only some examples or embodiments of the present disclosure. Those having ordinary skills in the art, without further creative efforts, may apply the present disclosure to other similar scenarios according to these drawings. Unless obviously obtained from the context or the context illustrates otherwise, the same numeral in the drawings refers to the same structure or operation.

The embodiments of the present disclosure provide a vibration component that is applicable to various acoustic output devices including, but not limited to, a loudspeaker, a hearing aid, etc. The vibration component provided in the embodiments of the present disclosure may mainly include an elastic element and a reinforcing member. The elastic element or the reinforcing member may be connected with a driving part of the loudspeaker. An edge of the elastic element may be fixed (e.g., connected with a housing of the loudspeaker). The driving part of the loudspeaker may serve as an electrical energy-mechanical energy conversion unit, which provides a driving force for the loudspeaker by converting electrical energy into mechanical energy. The vibration component may receive a force or displacement transmitted by the driving part and generate a corresponding vibration output, thereby pushing the air to move to generate a sound pressure. The elastic element may be regarded as being connected with an air inertia load through a spring and/or damping to radiate the sound pressure by pushing the air to move.

The elastic element may mainly include a central region, a folded ring region disposed at a periphery of the central region, and a fixed region disposed at a periphery of the folded ring region. In some embodiments, in order to make the loudspeaker have a relatively flat sound pressure level output within a relatively large range (e.g., 20 Hz-20 kHz), preset patterns may be designed in the folded ring region of the elastic element to destroy a vibration mode of the folded ring region of the elastic element in the corresponding frequency range, thereby avoiding sound cancellation caused by local segmented vibration of the elastic element. Meanwhile, the local stiffness of the elastic element may be increased by the design of the patterns. Furthermore, by designing a thickened structure in the central region of the elastic element, the stiffness of the central region of the elastic element may be increased, thereby avoiding sound cancellation caused by a segmented vibration mode of the central region of the elastic element of the loudspeaker within a range of 20 Hz-20 kHz. However, designing the thickened structure directly in the central region of the elastic element may increase the overall mass of the vibration component, increasing the load of the loudspeaker, and causing an impedance mismatch between a driving end and a load end, resulting in a reduction in the sound pressure level output by the loudspeaker. The vibration component provided by the embodiments of the present disclosure provides a structural design of the elastic element and the reinforcing member. The reinforcing member may include one or more ring structures and one or more strip structures. Each of the one or more strip structures may be connected with at least one of the one or more ring structures, so that the vibration component may present a required high-order mode at medium and high frequencies (above 3 kHz), thereby generating a plurality of resonance peaks on a frequency response curve of the vibration component, and making the vibration component having a relatively high sensitivity within a wide frequency range. Meanwhile, by the structural design of the reinforcing member, the mass of the vibration component may be smaller, which improves the overall sensitivity of the vibration component. In addition, by reasonably providing the reinforcing member and providing a plurality of hollow-out regions in the central region of the elastic element, the local stiffness of the central region of the elastic element is controllable and adjustable, thereby realizing controllable adjustment of the plurality of resonance peaks output by the vibration component using the segmented vibration modes of the plurality of hollow-out regions of the central region, and making the vibration component have a relatively flat sound pressure level curve. More details regarding the vibration component, the elastic element, and the reinforcing member may be found in the descriptions hereinafter.

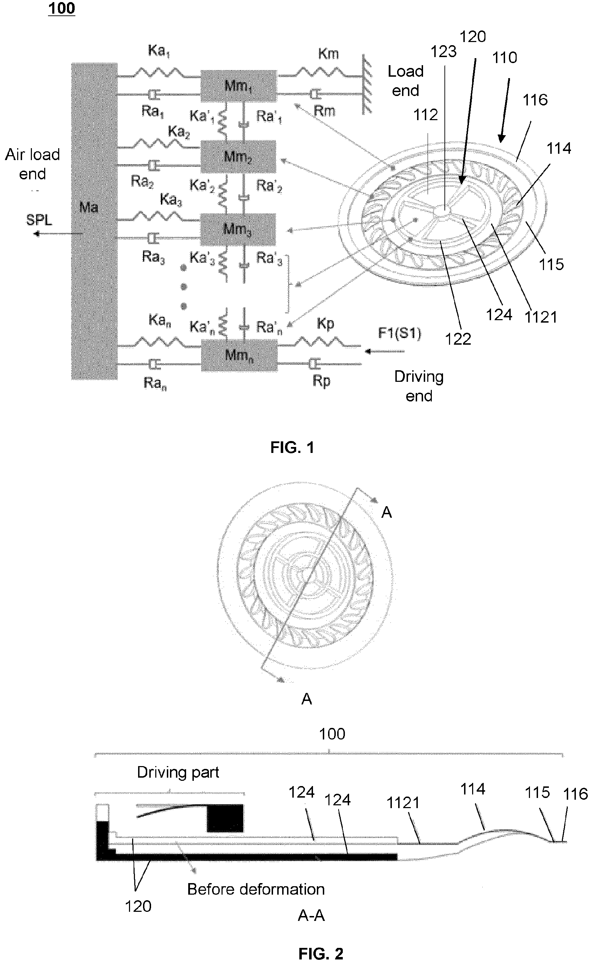

Referring to FIG. 1, FIG. 1 is a schematic diagram illustrating a vibration component and an equivalent vibration model thereof according to some embodiments of the present disclosure.

In some embodiments, a vibration component 100 may mainly include an elastic element 110. The elastic element 110 may include a central region 112, a folded ring region 114 disposed at a periphery of the central region 112, and a fixed region 116 disposed at a periphery of the folded ring region 114. The elastic element 110 may be configured to vibrate in a direction perpendicular to the central region 112 to transmit a force and displacement received by the vibration component 100 to push the air to move. The reinforcing member 120 may be connected with the central region 112. The reinforcing member 120 may include one or more ring structures 122 and one or more strip structures 124. Each of the one or more strip structures 124 may be connected with at least one of the one or more ring structures 122. At least one of the one or more strip structures 124 may extend toward a center of the central region 112. By reasonably configuring the reinforcing member 120 and providing a plurality of hollow-out regions in the central region 112 of the elastic element 110, a local stiffness of the central region 112 of the elastic element 110 is controllable and adjustable, thereby realizing controllable adjustment of a plurality of resonance peaks output by the vibration component using segmented vibration modes of the plurality of hollow-out regions of the central region 112, and making the vibration component 100 have a relatively flat sound pressure level curve. Meanwhile, the one or more ring structures 122 and the one or more strip structures 124 may cooperate with each other, so that the reinforcing member 120 may have an appropriate proportion of reinforcing portions and hollow-out portions (i.e., hollow-out parts), thereby reducing a mass of the reinforcing member 120 and improving an overall sensitivity of the vibration component 100. In addition, by designing shapes, dimensions, and counts of the one or more ring structures 122 and the one or more strip structures 124, positions of the plurality of resonance peaks of the vibration component 100 may be adjusted, thereby controlling a vibration output of the vibration component 100.

The elastic element 110 refers to an element capable of elastically deforming under the action of an external load. In some embodiments, the elastic element 110 may be a high-temperature-resistant material, so that the elastic element 110 can maintain performance during a manufacturing process when the vibration component 100 is applied to a loudspeaker. In some embodiments, when the elastic element 110 is in an environment of 200°C-300°C, Young's modulus and a shear modulus of the elastic element 110 may have no change or a very small change (e.g. a change within 5%). Young's modulus characterizes the deformation capacity of the elastic element 110 when the elastic element 110 is stretched or compressed. The shear modulus characterizes the deformation capacity of the elastic element 110 when the elastic element 110 is sheared. In some embodiments, the elastic element 110 may be a material with a good elasticity (i.e., easy to elastically deform), so that the vibration component 100 may have a good vibration response capability. In some embodiments, a material of the elastic element 110 may be one or more of an organic polymer material, a glue material, or the like. In some embodiments, the organic polymer material may include polycarbonate (PC), polyamides (PA), acrylonitrile butadiene styrene (ABS), polystyrene (PS), high impact polystyrene (HIPS), polypropylene (PP), polyethylene terephthalate (PET), polyvinyl chloride (PVC), polyurethanes ( PU), polyethylene (PE), phenol formaldehyde (PF), urea-formaldehyde (UF), melamine-formaldehyde (MF), polyarylate (PAR), polyetherimide (PEI), polyimide (PI), polyethylene naphthalate two formic acid glycol ester (PEN), polyetheretherketone (PEEK), carbon fibers, graphene, silica gel, or the like, or any combination thereof. In some embodiments, the organic polymer material may also include various adhesives, including but are not limited to gels, organic silica gels, acrylics, polyurethanes, rubbers, epoxy adhesives, hot melt adhesives, light curing adhesives, or the like. In some embodiments, the organic polymer material may include silicone bonding glues or silicone sealing glues.

In some embodiments, a Shore hardness of the elastic element 110 may be within a range of 1-50 HA. In some embodiments, the Shore hardness of the elastic element 110 may be within a range of 1-15 HA. In some embodiments, the Shore hardness of the elastic element 110 may be within a range of 14.9-15.1 HA.

In some embodiments, Young's modulus of the elastic element 110 may be within a range of 5E8 Pa-1 E10 Pa. In some embodiments, Young's modulus of the elastic element 110 may be within a range of 1E9 Pa-5E9 Pa. In some embodiments, Young's modulus of the elastic element 110 may be within a range of 1 E9 Pa-4E9 Pa. In some embodiments, Young's modulus of the elastic element 110 may be within a range of 2E9 Pa-5E9 Pa.

In some embodiments, a density of the elastic element 110 may be within a range of 1E3 kg/m$^3$-4E3 kg/m$^3$. In some embodiments, the density of the elastic element 110 may be within a range of 1E3 kg/m$^3$-2E3 kg/m$^3$. In some embodiments, the density of the elastic element 110 may be within a range of 1E3 kg/m$^3$-3E3 kg/m$^3$. In some embodiments, the density of the elastic element 110 may be within a range of 1E3 kg/m$^3$-1.5 E3kg/m$^3$. In some embodiments, the density of the elastic element 110 may be within a range of 1.5E3 kg/m$^3$ -2E3 kg/m$^3$.

In some embodiments, when the vibration component is applied to the loudspeaker, the central region 112 of the elastic element 110 may be directly connected with a driving part of the loudspeaker. In some embodiments, the reinforcing member 120 disposed in the central region 112 of the elastic element 110 may be directly connected with the driving part of the loudspeaker. The central region 112 and the reinforcing member 120 of the elastic element 110 may transmit a force and displacement of the driving part to push the air to move and output sound pressure.

The central region 112 refers to a region of the elastic element 110 extending from a center (e.g., a centroid) to a circumferential side for a certain area. The reinforcing member 120 may be connected with the central region 112. The elastic element 110 may be configured to vibrate in a direction perpendicular to the central region 112. The central region 112 may serve as a main vibration region of the elastic element 110 to transmit the force and the displacement and output a vibration response.

The folded ring region 114 may be located on the outer side of the central region 112. In some embodiments, the folded ring region 114 may be designed with patterns of a specific shape, thereby destroying a vibration mode of the folded ring region 114 of the elastic element 110 within a corresponding frequency range, and avoiding sound cancellation caused by local segmented vibration of the elastic element 110. In addition, the local stiffness of the elastic element 110 may be increased by the design of the patterns.

In some embodiments, the folded ring region 114 may include a folded ring structure. In some embodiments, by adjusting a folded ring width, a folded ring arch height, and other parameters of the folded ring structure, the stiffness of the folded ring region 114 corresponding to the folded ring structure may be different, and a frequency range of a corresponding high-frequency local segmented vibration mode may also be different. The folded ring width refers to a radial width of a projection of the folded ring region 114 in a vibration direction of the elastic element 110. The folded ring arch height refers to a height of the folded ring region 114 protruding from the central region 112 or the fixed region 116 in the vibration direction of the elastic element 110.

In some embodiments, a maximum area of projections of the one or more ring structures 122 of the reinforcing member 120 in the vibration direction of the elastic element 110 may be smaller than an area of the central region 112. That is, a region not supported by the reinforcing member 120 may be provided between an outermost side of the projection of the reinforcing member 120 and the folded ring region 114. According to the present disclosure, a part of the central region 112 between the folded ring region 114 and the reinforcing member 120 may be referred to as a suspension region 1121. In some embodiments, an area of the suspension region 1121 may be adjusted by adjusting a maximum contour of the reinforcing member 120, thereby adjusting a modal vibration mode of the vibration component.

The fixed region 116 may be disposed at the periphery of the folded ring region 114. The elastic element 110 may be connected and fixed through the fixed region 116. For example, the elastic element 110 may be connected and fixed to a housing of the loudspeaker, or the like, through the fixed region 116. In some embodiments, the fixed region 116 may be installed and fixed in the housing of the loudspeaker and may be regarded as not participating in the vibration of the elastic element 110. In some embodiments, the fixed region 116 of the elastic element 110 may be connected to the housing of the loudspeaker through a support element. In some embodiments, the support element may include a soft material that is easy to deform, so that the support element can also deform during the vibration of the vibration component 100, thereby providing a greater displacement amount for the vibration of the vibration component 100. In some embodiments, the support element may also include a rigid material that is not easy to deform.

In some embodiments, the elastic element 110 may further include a connection region 115 disposed between the folded ring region 114 and the fixed region 116. In some embodiments, the connection region 115 may provide additional stiffness and damping for the vibration of the elastic element 110, thereby adjusting the modal vibration mode of the vibration component 100.

In order to enable the elastic element 110 to provide an appropriate stiffness, a thickness and an elastic coefficient of the elastic element 110 may be set within a reasonable range. In some embodiments, the thickness of the elastic element 110 may be within a range of 3 $\mu$m-100 $\mu$m. In some embodiments, the thickness of the elastic element 110 may be within a range of 3 $\mu$m-50 $\mu$m. In some embodiments, the thickness of the elastic element 110 may be within a range of 3 $\mu$m-30 $\mu$m.

The reinforcing member 120 refers to an element configured to increase the stiffness of the elastic element 110. In some embodiments, the reinforcing member 120 may be connected with the central region 112. The reinforcing member 120 and/or the central region 112 may be connected with the driving part of the loudspeaker to transmit the force and/or displacement, thereby causing the vibration component 100 to push the air to move and output the sound pressure. The reinforcing member 120 may include the one or more ring structures 122 and the one or more strip structures 124. Each of the one or more strip structures 124 may be connected with at least one of the one or more ring structures 122 to form a staggered support in the central region 112 of the elastic element 110. At least one of the one or more strip structures 124 may extend toward the center of the central region 112. In some embodiments, the one or more strip structures 124 may pass through the center of the central region 112 to support the center of the central region 112. In some embodiments, the reinforcing member 120 may further include a central connection part 123. The one or more strip structures 124 may not pass through the center of the central region 112. The central connection part 123 may cover the center of the central region 112. The one or more strip structures 124 may be connected with the central connection part 123.

The ring structure 122 refers to a structure extending around a specific center. In some embodiments, the center around which the ring structure 122 extends may be the center of the central region 112. In some embodiments, the center around which the ring structure(s) 122 extend may also be another position of the central region 112 that is off-center. In some embodiments, the ring structure 122 may be a structure with a closed contour line. In some embodiments, a projection shape of the ring structure 122 in the vibration direction of the elastic element 110 may include, but is not limited to, any one of a circular ring shape, a polygonal ring shape, a curved ring shape, or an elliptical ring shape, or any combination thereof. In some embodiments, the ring structure 122 may also be a structure with a contour line that is not closed. For example, the ring structure 122 may include, but is not limited to, any one of a circular ring shape with a notch, a polygonal ring shape with a notch, a curved ring shape with a notch, or an elliptical ring shape with a notch, or any combination thereof. In some embodiments, a count of the ring structure(s) 122 may be one. In some embodiments, the count of the ring structure(s) 122 may exceed one and the ring structures 122 may have a same centroid. In some embodiments, the count of the one or more ring structures 122 may be within a range of 1-10. In some embodiments, the count of the one or more ring structures 122 may be within a range of 1-5. In some embodiments, the count of the one or more ring structures 122 may be within a range of 1-3. If the count of the one or more ring structures 122 is too large, the mass of the reinforcing member 120 may be too large, thereby reducing the overall sensitivity of the vibration component 100. In some embodiments, the mass and the stiffness of the reinforcing member 120 may be adjusted by designing the count of the one or more ring structures 122. In some embodiments, a dimension of a ring structure 122 located at the outermost periphery of the reinforcing member 120 may be regarded as a maximum dimension of the reinforcing member. In some embodiments, a dimension (or an area) of the suspension region 1121 between the folded ring region 114 and the reinforcing member 120 may be adjusted by adjusting the dimension of the ring structure 122 located at the outermost periphery of the reinforcing member 120, thereby changing the modal vibration mode of the vibration component 100.

In some embodiments, the one or more ring structures 122 may include a first ring structure and a second ring structure. A radial dimension of the first ring structure may be less than a radial dimension of the second ring structure. In some embodiments, the first ring structure may be disposed at an inner side of the second ring structure. In some embodiments, a centroid of the first ring structure may coincide with a centroid of the second ring structure. In some embodiments, the centroid of the first ring structure may not coincide with the centroid of the second ring structure. In some embodiments, the first ring structure and the second ring structure may be connected through the one or more strip structures 124. In some embodiments, the first ring structure and the second ring structure may be adjacent ring structures. In some embodiments, the first ring structure and the second ring structure may also be non-adjacent ring structures. The one or more ring structures may be disposed between the first ring structure and the second ring structure.

The strip structure 124 refers to a structure with a certain extension rule. In some embodiments, the one or more strip structures 124 may extend along a straight line. In some embodiments, the one or more strip structures 124 may also extend along a curve. In some embodiments, the curve extension may include, but is not limited to, an arc-shaped extension, a spiral extension, a spline-shaped extension, a circular-arc-shaped extension, an S-shaped extension, or the like. In some embodiments, the one or more strip structures 124 may be connected with the one or more ring structures 122 to divide the reinforcing member 120 into a plurality of hollow-out portions. In some embodiments, regions of the central region 112 corresponding to the plurality of hollow-out portions may be referred to as hollow-out regions. In some embodiments, a count of the one or more strip structures 124 may be one. For example, one strip structure 124 may be arranged along any diameter direction of one ring structure 122 (e.g., any one of the one or more ring structures). In some embodiments, the strip structure 124 may be simultaneously connected with the center of the central region (i.e., the centroid of any one of the one or more ring structures 122) and any one of the one or more ring structures 122. In some embodiments, the one or more strip structures 124 may include a plurality of strip structures 124. In some embodiments, the plurality of strip structures 124 may be disposed in a plurality of diameter directions of the one or more ring structures 122. In some embodiments, at least a part of the plurality of strip structures 124 may extend toward the center of the central region 112, which may be the centroid of the elastic element 110. In some embodiments, the plurality of strip structures 124 may include another part of strip structures 124 extending in other directions. In some embodiments, at least a part of the plurality of strip structures 124 may be connected to the center of the central region and form the central connection part 123 at the center. In some embodiments, the central connection part 123 may also be a separate structure, and at least a part of the plurality of strip structures 124 may be connected with the central connection part 123. In some embodiments, a shape of the central connection part 123 may include, but is not limited to, a circle, a square, a polygon, an ellipse, or the like. In some embodiments, the shape of the central connection part 123 may also be set arbitrarily. In some embodiments, when the one or more ring structures 122 include the plurality of ring structures 122, adjacent ring structures 122 may be connected through the one or more strip structures 124. In some embodiments, the strip structures 124 connected between the adjacent ring structures 122 may extend toward the center of the central region 112, or may not extend toward the center of the central region 112.

In some embodiments, the count of the one or more strip structures 124 may be within a range of 1-100. In some embodiments, the count of the one or more strip structures 124 may be within a range of 1-80. In some embodiments, the count of the one or more strip structures 124 may be within a range of 1-50. In some embodiments, the count of the one or more strip structures 124 may be within a range of 1-30. By setting the count of the one or more strip structures 124, the overall mass of the vibration component 100, the stiffness of the reinforcing member 120, and the area of the plurality of hollow-out regions of the elastic element 110 may be adjusted, thereby changing the modal vibration mode of the vibration component.

In some embodiments, a shape of a projection of the strip structure 124 in the vibration direction of the elastic element 110 may include at least one of a rectangle, a trapezoid, a curve, an hourglass shape, and a petal shape. By designing different shapes of strip structures 124, a mass distribution (e.g., a centroid position) of the reinforcing member 120, the stiffness of the reinforcing member 120, and the area of the plurality of hollow-out regions may be adjusted, thereby changing the modal vibration mode of the vibration component.

It should be noted that the structural description of the one or more ring structures 122 and the one or more strip structures 124 in the embodiments of the present disclosure is only an optional structure selected to facilitate the reasonable arrangement of the structure of the reinforcing member 120, and should not be understood as a limitation to the shapes of the reinforcing member 120 and components thereof. In fact, the reinforcing member 120 in the embodiments of the present disclosure may form a reinforcing portion and a plurality of hollow-out portions (i.e., the plurality of hollow-out portion corresponding to the plurality of hollow-out regions of the central region 112) located between the one or more ring structures 122 and the one or more strip structures 124. A region where the one or more ring structures 122 are located and a region where the one or more strip structures 124 are located may form the reinforcing portion. Within a projection range of a largest contour of the reinforcing member 120 in the vibration direction of the elastic element 110, regions not covered by the one or more ring structures 122 and the one or more strip structures 124 may form the plurality of hollow-out portions. By adjusting parameters (e.g., an area, a thickness of the reinforcing portion, etc.) of the reinforcing portion and the plurality of hollow-out portions, vibration characteristics (e.g., a count and a frequency range of resonance peaks) of the vibration component 100 may be adjusted. In other words, any shape of reinforcing member with the reinforcing portions and the plurality of hollow-out portions may be set using a parameter setting manner of the reinforcing portions and the plurality of hollow-out portions provided in the present disclosure to adjust vibration performance (e.g., the count and positions of the resonance peaks, a shape of a frequency response curve, etc.) of the vibration component, which should be included in the scope of the present disclosure.

In some embodiments, referring to FIG. 1, the connection region 115 between the fixed region 116 of the elastic element 110 and the folded ring region 114 may be suspended. An equivalent mass of the connection region 115 may be $Mm_1$. Since the elastic element 110 can provide elasticity and damping, the connection region 115 may be equivalent to being fixedly connected with the housing through a spring Km and damping Rm. Meanwhile, the connection region 115 may be connected with a front air load of the elastic element 110 through a spring $Ka_1$ and damping $Ra_1$ to transmit the force and the displacement, thereby pushing the air to move.

In some embodiments, the folded ring region 114 of the elastic element 110 may have a local equivalent mass $Mm_2$, and the folded ring region 114 may be connected with the connection region 115 of the elastic element 110 through a spring $Ka_1'$ and damping $Ra_1'$. Meanwhile, the folded ring region 114 may be connected with the front air load of the elastic element 110 through a spring $Ka_2$ and damping $Ra_2$ to transmit the force and the displacement, thereby pushing the air to move.

In some embodiments, the reinforcing member 120 may be disposed in the central region 112 of the elastic element 110. The reinforcing member 120 may be connected with the central region 112 of the elastic element 110. A contact area between the reinforcing member 120 and the central region 112 is less than an area of the central region 112, so that a suspension region 1121 may be disposed between a region of the central region 112 of the elastic element 110 supported by the reinforcing member 120 and the folded ring region 114. The suspension region 1121 may have a local equivalent mass Mms and may be connected with the folded ring region 114 through a spring $Ka_2'$ and damping $Ra_2'$. Meanwhile, the region where the reinforcing member 120 is located may be connected with the front air load of the elastic element 110 through a spring Kas and damping Ras to transmit the force and the displacement, thereby pushing the air to move.

In some embodiments, due to the design of the reinforcing member 120, the central region 112 of the elastic element 110 corresponding to the reinforcing member 120 may have not less than one hollow-out region. Each hollow-out region may be equivalent to a mass-spring-damping system and have an equivalent mass $Mm_i$, equivalent stiffnesses $Ka_i$ and $Ka_i'$, and equivalent damping $Ra_i$ and $Ra_i'$, wherein i denotes a natural number. The hollow-out region may be connected with an adjacent hollow-out region through the spring $Ka_i'$ and the damping $Ra_i'$. The hollow-out region may also be connected with, through the spring $Ka_i'$ and the damping $Ra_i'$, the suspension region 1121 disposed between the region supported by the reinforcing member 120 in the central region 112 and the folded ring region 114. Meanwhile, the suspension region 1121 may be connected with the front air load of the elastic element 110 through the spring $Ka_i$ and the damping $Ra_i$ to transmit the force and the displacement, thereby pushing the air to move.

In some embodiments, the reinforcing member 120 may have an equivalent mass $Mm_n$, and the reinforcing member 120 may be connected with the central region 112 through a spring $Ka_n'$ and damping $Ra_n'$, while the reinforcing member 120 may be connected with the front air load of the elastic element 110 through a spring $Ka_n$ and damping $Ra_n$. When the reinforcing member 120 generates a resonance, the reinforcing member 120 may drive the central region 112 to drive the elastic element 110 to produce a relatively large movement speed and displacement, thereby producing a relatively large sound pressure level.

According to the dynamic characteristics of the mass-spring-damping system, each mass-spring-damping system has its own resonance peak frequency $f_0$. A large movement speed and displacement may occur at $f_0$. By designing different parameters (e.g., structural parameters of the elastic element 110 and/or the reinforcing member 120) of the vibration component 100, the mass-spring-damping systems formed by structures at different positions of the vibration component 100 may resonate within a required frequency range, thereby causing a frequency response curve of the vibration component 100 to have a plurality of resonance peaks, which greatly broadens an effective frequency band of the vibration component 100. In addition, by designing the reinforcing member 120, the vibration component 100 may have a lighter mass, and the vibration component 100 may have a higher sound pressure level output.

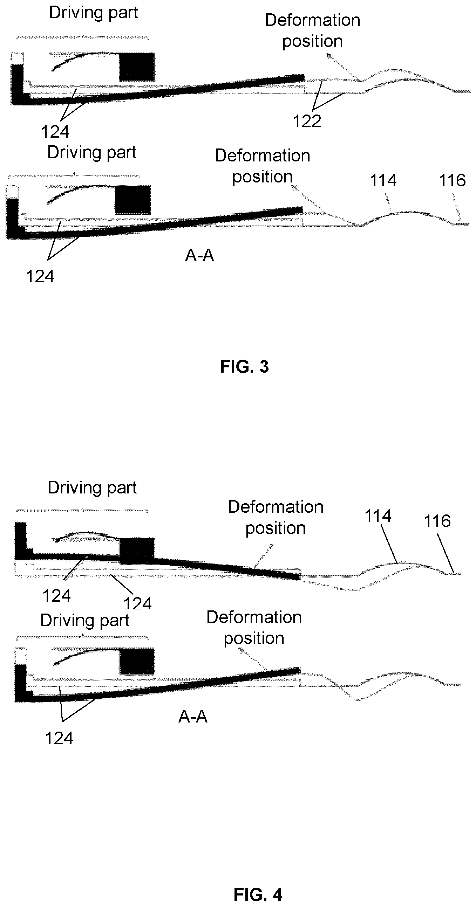

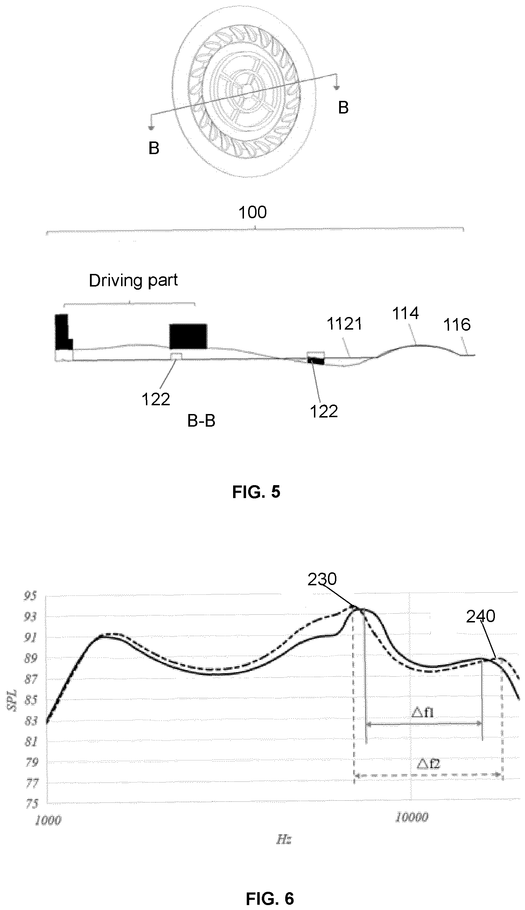

FIG. 2 is a schematic diagram illustrating a deformation of a vibration component at a first resonance peak according to some embodiments of the present disclosure. FIG. 3 is a schematic diagram illustrating deformations of a vibration component at a second resonance peak according to some embodiments of the present disclosure. FIG. 4 is a schematic diagram illustrating deformations of a vibration component at a third resonance peak according to some embodiments of the present disclosure. FIG. 5 is a schematic diagram illustrating a deformation of a vibration component at a fourth resonance peak according to some embodiments of the present disclosure.

According to the schematic diagram of the equivalent vibration model of the vibration component 100 illustrated in FIG. 1, the various parts of the vibration component 100 may generate speed resonances in different frequency ranges, causing to output a relatively large speed value in a corresponding frequency band, thereby causing the frequency response curve of the vibration component 100 to have a relatively large sound pressure value in the corresponding frequency range and have a corresponding resonance peak. Meanwhile, a frequency response of the vibration component 100 may have a relatively high sensitivity within an audible range (e.g., 20 Hz-20 kHz) through the plurality of resonance peaks.

As illustrated in FIG. 1 and FIG. 2, in some embodiments, a mass of the reinforcing member 120, a mass of the elastic element 110, an equivalent air mass, and a driving end equivalent mass may be combined to form a total equivalent mass $Mt$, and the equivalent damping of the various parts may form a total equivalent damping $Rt$. The elastic element 110 (especially the folded ring region 114, and the elastic element 110 in the suspension region between the folded ring region 114 and the reinforcing member 120) may have great compliance, providing a stiffness $Kt$ for the system, thereby forming a mass $Mt$-spring $Kt$-damping $Rt$ system having a resonance frequency. When a driving end excitation frequency is close to a speed resonance frequency of the system, the system may generate a resonance (as illustrated in FIG. 2), and output a relatively large speed value $v_a$ within a frequency range near the speed resonance frequency of the $Mt$-$Kt$-$Rt$ system. Since an output sound pressure amplitude of the vibration component 100 is positively correlated to the sound speed ($p_a \propto v_a$), a resonance peak may appear in the frequency response curve, which is defined as a first resonance peak of the vibration component 100 in the present disclosure. In some embodiments, referring to FIG. 2, FIG. 2 illustrates a vibration condition of the vibration component 100 at an A-A cross-sectional position. A white structure in FIG. 2 represents a shape and a position of the reinforcing member 120 before deformation, and a black structure in FIG. 2 represents a shape and a position of the reinforcing member 120 at the first resonance peak. It should be noted that FIG. 2 only illustrates a structural condition of the vibration component 100 from a center of the reinforcing member 120 to one edge of the elastic element 110 on the A-A cross-section, i.e., a half of the A-A cross-section. The other half of the A-A cross-section not shown is symmetrical to the structural condition illustrated in FIG. 2. It can be seen from the vibration of the vibration component 100 at the A-A cross-sectional position that at the position of the first resonance peak, a main deformation position of the vibration component 100 may be a part of the elastic element 110 connected with the fixed region 116. In some embodiments, a frequency of the first resonance peak of the vibration component 100 (also referred to as a first resonance frequency) may be related to a ratio of a mass of the vibration component 100 to an elastic coefficient of the elastic element 110. In some embodiments, the frequency of the first resonance peak may be within a range of 180 Hz- 3000 Hz. In some embodiments, the frequency of the first resonance peak may be within a range of 200 Hz-3000 Hz. In some embodiments, the frequency of the first resonance peak may be within a range of 200 Hz-2500 Hz. In some embodiments, the frequency of the first resonance peak may be within a range of 200 Hz-2000 Hz. In some embodiments, the frequency of the first resonance peak may be within a range of 200 Hz-1000 Hz. In some embodiments, by configuring the structure of the reinforcing member 120, the first resonance peak of the vibration component 100 may be located within the above frequency range.

As illustrated in FIG. 1 and FIG. 3, the connection region 115 between the fixed region 116 of the elastic element 110 and the folded ring region 114 may be suspended. This region may have an equivalent mass $Mm_1$, and this region may be fixedly connected with the housing through a spring $Km$ and damping $Rm$. Meanwhile, the connection region 115 may be connected with a front air load of the elastic element 110 through a spring $Ka_1$ and damping $Ra_1$ to transmit a force and a displacement, thereby pushing the air to move.

The folded ring region 114 may have a local equivalent mass $Mm_2$, and this region may be connected with the connection region 115 through a spring $Ka_1'$ and damping $Ra_1'$. Meanwhile, the folded ring region 114 may be connected with the front air load of the elastic element 110 through a spring $Ka_2$ and damping $Ra_2$ to transmit the force and the displacement, thereby pushing the air to move.

The suspension region 1121 may be disposed between a region of the central region 112 provided with the reinforcing member 120 and the folded ring region 114. The suspension region 1121 may have a local equivalent mass $Mm_3$, and the suspension region 1121 may be connected with the folded ring region 114 through a spring $Ka_2'$ and damping $Ra_2'$. Meanwhile, the region where the reinforcing member 120 is located may be connected with the front air load of the elastic element 110 through a spring $Kas$ and damping $Ras$ to transmit the force and the displacement, thereby pushing the air to move.

The above three parts may form an equivalent mass $Ms$, an equivalent stiffness $Ks$, and an equivalent damping $Rs$, forming a mass $Ms$-spring $Ks$-damping $Rs$ system. Furthermore, the system may have a resonance frequency. When a driving end excitation frequency is close to a speed resonance frequency of the $Ms$-$Ks$-$Rs$ system, the system may generate a resonance and output a relatively large speed value $v_a$ within a frequency range near a speed resonance frequency of the $Ms$-$Ks$-

Rs system. Since an output sound pressure amplitude of the vibration component 100 is positively correlated to the sound speed ($p_a \propto v_a$), a resonance peak may appear in a frequency response curve, which is defined as a second resonance peak of the vibration component 100 in the present disclosure. The second resonance peak may be mainly generated by a vibration mode of the connection region 115, the folded ring region 114, and the suspension region disposed between the region of the central region 112 provided with the reinforcing member 120 and the folded ring region 114. As illustrated in FIG. 3, FIG. 3 illustrates the deformation positions of the vibration component 100 before the second resonance peak (an upper structural diagram in FIG. 3) and after the second resonance peak (a lower structural diagram in FIG. 3), respectively. In some embodiments, as illustrated in FIG. 3, it can be seen from the vibration of the vibration component 100 at the A-A cross-sectional position that before and after a frequency of the second resonance peak, main deformation positions of the vibration component 100 may be the folded ring region 114 and the suspension region 1121. In some embodiments, the frequency (also referred to as the second resonance frequency) of the second resonance peak of the vibration component 100 may be related to a ratio of a mass of the elastic element 110 to an elastic coefficient of the elastic element 110. In some embodiments, the frequency of the second resonance peak of the vibration component 100 may be within a range of 1000 Hz-10000 Hz. In some embodiments, the frequency of the second resonance peak of the vibration component 100 may be within a range of 3000 Hz-7000 Hz. In some embodiments, the frequency of the second resonance peak of the vibration component 100 may be within a range of 3000 Hz- 6000 Hz. In some embodiments, the frequency of the second resonance peak of the vibration component 100 may be within a range of 4000 Hz-6000 Hz. In some embodiments, by arranging the structure of the reinforcing member 120, the frequency of the second resonance peak of the vibration component 100 may be within the above frequency range.

As illustrated in FIG. 1 and FIG. 4, the reinforcing member 120 may have an equivalent mass $Mm_n$, and the reinforcing member 120 may be connected with the central region 112 through the spring $Ka_n'$ and the damping $Ra_n'$, while the reinforcing member 120 may be connected with the front air load of the elastic element 110 through the spring $Ka_n$ and the damping $Ra_n$. When the reinforcing member 120 generates the resonance, the reinforcing member 120 may drive the central region 112 to drive the elastic element 110 to produce a relatively large movement speed and displacement, thereby producing a relatively large sound pressure level.

The reinforcing member 120, the connection region 115, the folded ring region 114, the suspension region 1121 disposed between the region of the central region 112 provided with the reinforcing member 120 and the folded ring region 114, the equivalent air mass, and a driving end equivalent mass may be combined to form a total equivalent mass $Mt_1$, and the equivalent damping of the various parts may form total equivalent damping $Rt_1$. The reinforcing member 120 and the elastic element 110 (especially a portion of the central region 112 covered by the reinforcing member 120) may have a relatively large stiffness, providing a stiffness $Kt_1$ for the system, thereby forming a mass $Mt_1$- spring Kti-damping $Rt_1$ system. The system may have a vibration mode of flipping motion in which a ring region in a diameter direction of the central region 112 is taken as an equivalent fixed fulcrum and movements inside and outside the ring region are in opposite directions. The connection region 115, the folded ring region 114, and the suspension region 1121 disposed between the region of the central region 112 provided with the reinforcing member 120 and the folded ring region may be driven by the reinforcing member 120 to vibrate, thereby achieving a resonance mode with the flipping motion as the vibration mode (as illustrated in FIG. 4). The resonance may also be a resonance frequency point of the equivalent mass Mti-spring Kti-damping $Rt_1$ system. When the driving end excitation frequency is close to the speed resonance frequency of the system, the $Mt_1$-$Kt_1$ -$Rt_1$ system may generate a resonance, and output a relatively large speed value $v_a$ within a frequency range near the speed resonance frequency of the $Mt_1$-$Kt_1$ -$Rt_1$ system. Since an output sound pressure amplitude of the vibration component 100 is positively correlated to the sound speed ($p_a \propto v_a$), a resonance peak may appear in a frequency response curve, which is defined as a third resonance peak of the vibration component 100 in the present disclosure. As illustrated in FIG. 4, FIG. 4 illustrates deformation positions of the vibration component 100 before the third resonance peak (an upper structural diagram in FIG. 4) and after the third resonance peak (a lower structural diagram in FIG. 4), respectively. It can be seen from the vibration of the vibration component 100 at the A-A cross-sectional position that before and after a frequency of the third resonance peak, main deformation positions of the vibration component 100 may be the flipping deformation of the reinforcing member 120. In some embodiments, the third resonance peak of the vibration component may be correlated to the stiffness of the reinforcing member 120. In some embodiments, a frequency of the third resonance peak may be within a range of 5000 Hz-12000 Hz. In some embodiments, the frequency of the third resonance peak may be within a range of 6000 Hz-12000 Hz. In some embodiments, the frequency of the third resonance peak may be within a range of 6000 Hz-10000 Hz. In some embodiments, by arranging the structure of the reinforcing member 120, the frequency of the third resonance peak of the vibration component 100 may be within the above frequency range.

As illustrated in FIG. 1 and FIG. 5, the central region 112 of the elastic element 110 corresponding to the reinforcing member 120 may have not less than one hollow-out region. Each hollow-out region may be equivalent to a mass-spring-damping system and have an equivalent mass $Mm_i$, equivalent stiffnesses $Ka_i$ and $Ka_i'$, and equivalent damping $Ra_i$ and $Ra_i'$. The hollow-out region may be connected with an adjacent hollow-out region through the spring $Ka_i'$ and the damping $Ra_i'$. The hollow-out region may also be connected with, through the spring $Ka_i'$ and the damping $Ra_i'$, the suspension region 1121 disposed between the region supported by the reinforcing member 120 in the central region 112 and the folded ring region 114. Meanwhile, the suspension region 1121 may be connected with the front air load of the elastic element 110 through the spring $Ka_i$ and the damping $Ra_i$ to transmit the force and the displacement, thereby pushing the air to move.

Since the one or more hollow-out regions are separated by the one or more strip structures 124 of the reinforcing member 120, each hollow-out region may form a different resonance frequency, and separately push an air domain connected with the hollow-out region to move to generate a corresponding sound pressure. Furthermore, by designing the position and dimension of each strip structure 124, and a count of the strip structures 124 of the reinforcing member 120, various hollow-out regions with different resonance frequencies may be realized, so that the frequency response curve of the vibration component 100 may have not less than one high-frequency resonance peak (i.e., a fourth resonance peak). In some embodiments, a frequency of the not less than one high-frequency resonance peak (i.e., the fourth resonance peak) as described above may be within a range of 10000 Hz-18000 Hz.

Furthermore, in order to increase the sound pressure level output by the vibration component 100 at high frequency (10000 Hz-20000 Hz), the position, the dimension, and the count of the strip structure(s) 124 may be designed to make the resonance frequency of each hollow-out region equal or close. In some embodiments, a frequency difference between the resonance frequencies of the one or more hollow-out regions may be within a range of 4000 Hz, so that the frequency response curve of the vibration component 100 can have a high-frequency resonance peak with a relatively large output sound pressure level, which is defined as the fourth resonance peak (as illustrated in FIG. 5) of the vibration component 100 in the present disclosure. In some embodiments, as illustrated in FIG. 5, it can be known from the vibration of the vibration component 100 at a B-B cross-sectional position that near a frequency of the fourth resonance peak (also referred to as a fourth resonance frequency), the main deformation of the vibration component 100 may be deformations caused by the one or more hollow-out regions of the central region 112. In some embodiments, the frequency of the fourth resonance peak may be within a range of 8000 Hz-20000 Hz. In some embodiments, the frequency of the fourth resonance peak may be within a range of 10000 Hz-18000 Hz. In some embodiments, the frequency of the fourth resonance peak may be within a range of 12000 Hz-18000 Hz. In some embodiments, the frequency of the fourth resonance peak may be within a range of 15000 Hz-18000 Hz. In some embodiments, by designing areas of the one or more hollow-out regions and a thickness of the elastic element 110, the resonance frequencies of the one or more hollow-out regions may be adjusted, so that the fourth resonance peak of the vibration component 100 may be located within the above frequency range. In some embodiments, in order to make the frequency of the fourth resonance peak of the vibration component 100 fall within the above frequency range, a ratio of the total area of the one or more hollow-out regions to the thickness of the elastic element 110 may be within a range of 100 mm-1000 mm. In some embodiments, in order to make the frequency of the fourth resonance peak of the vibration component 100 fall within the above frequency range, the ratio of the total area of the one or more hollow-out regions to the thickness of the elastic element 110 may be within a range of 120mm-900 mm. In some embodiments, in order to make the frequency of the fourth resonance peak of the vibration component 100 fall within the above frequency range, the ratio of the total area of the one or more hollow-out regions to the thickness of the elastic element 110 may be within a range of 150 mm-800 mm. In some embodiments, in order to make the frequency of the fourth resonance peak of the vibration component 100 fall within the above frequency range, the ratio of the total area of the one or more hollow-out regions to the thickness of the elastic element 110 may be within a range of 150 mm-700 mm.

As illustrated in FIG. 6, FIG. 6 illustrates frequency response curves of vibration components 100 with different differences between a frequency of a third resonance peak and a frequency of a fourth resonance peak according to some embodiments of the present disclosure. An abscissa represents frequency (Hz), and an ordinate represents sound pressure level (SPL). By designing structures of the reinforcing member 120 and the elastic element 110, the vibration component 100 may generate a plurality of resonance peaks within an audible range. Furthermore, with a combination of the plurality of resonance peaks, etc., the vibration component 100 may have a relatively high sensitivity within the entire audible range. By designing the one or more strip structures 124 and the one or more ring structures 122 of the reinforcing member 120, the fourth resonance peak 240 of the vibration component 100 may be located within different frequency ranges. By designing a difference $\Delta f$ between the frequency of the fourth resonance peak 240 and the frequency of the third resonance peak 230, a relatively flat frequency response curve and a relatively high sound pressure level within a frequency range between the fourth resonance peak 240 and the third resonance peak 230 may be output, thereby avoiding a valley in the frequency response curve. As illustrated in FIG. 6, if the difference $\Delta f$ between the frequency of the fourth resonance peak 240 and the frequency of the third resonance peak 230 is excessively large (e.g., $\Delta f_2$ as illustrated in FIG. 6), the valley may occur within the frequency range between the fourth resonance peak 240 and the third resonance peak 230, and the output sound pressure level may decrease. If the difference $\Delta f$ between the frequency of the fourth resonance peak 240 and the frequency of the third resonance peak 230 is excessively small (e.g., $\Delta f_1$ as illustrated in FIG. 6), the frequency of the fourth resonance peak 240 may decrease, a sound pressure level within a high-frequency range (e.g.,12 kHz-20 kHz) may decrease, and a frequency band of the vibration component 100 may be narrowed. By adjusting the structures of the reinforcing member 120 and the elastic element 110, the third resonance peak 230 may be moved to the left and/or the fourth resonance peak 240 may be moved to the right, thereby increasing the difference $\Delta f$ between the frequency of the fourth resonance peak 240 and the frequency of the third resonance peak 230. In some embodiments, the difference $\Delta f$ between the frequency of the fourth resonance peak 240 and the frequency of the third resonance peak 230 may be within a range of 80 Hz-15000 Hz. In some embodiments, the difference $\Delta f$ between the frequency of the fourth resonance peak 240 and the frequency of the third resonance peak 230 may be within a range of 100 Hz-13000 Hz. In some embodiments, the difference $\Delta f$ between the frequency of the fourth resonance peak 240 and the frequency of the third resonance peak 230 may be within a range of 200 Hz-12000 Hz. In some embodiments, the difference $\Delta f$ between the frequency of the fourth resonance peak 240 and the frequency of the third resonance peak 230 may be within a range of 300 Hz to 11000 Hz. In some embodiments, the difference $\Delta f$ between the frequency of the fourth resonance peak 240 and the frequency of the third resonance peak 230 may be within a range of 400 Hz-10000 Hz. In some embodiments, the difference $\Delta f$ between the frequency of the fourth resonance peak 240 and the frequency of the third resonance peak 230 may be within a range of 500 Hz-9000 Hz. In some embodiments, the difference $\Delta f$ between the frequency of the fourth resonance peak 240 and the frequency of the third resonance peak 230 may be within a range of 200 Hz-11000 Hz. In some embodiments, the difference $\Delta f$ between the frequency of the fourth resonance peak 240 and the frequency of the third resonance peak 230 may be within a range of 200 Hz-10000 Hz. In some embodiments, the difference $\Delta f$ between the frequency of the fourth resonance peak 240 and the frequency of the third resonance peak 230 may be within a range of 2000 Hz-15000 Hz. In some embodiments, the difference $\Delta f$ between the frequency of the fourth resonance peak 240 and the frequency of the third resonance peak 230 may be within a range of 3000 Hz-14000 Hz. In some embodiments, the difference $\Delta f$ between the frequency of the fourth resonance peak 240 and the frequency of the third resonance peak 230 may be within a range of 4000 Hz-13000 Hz.

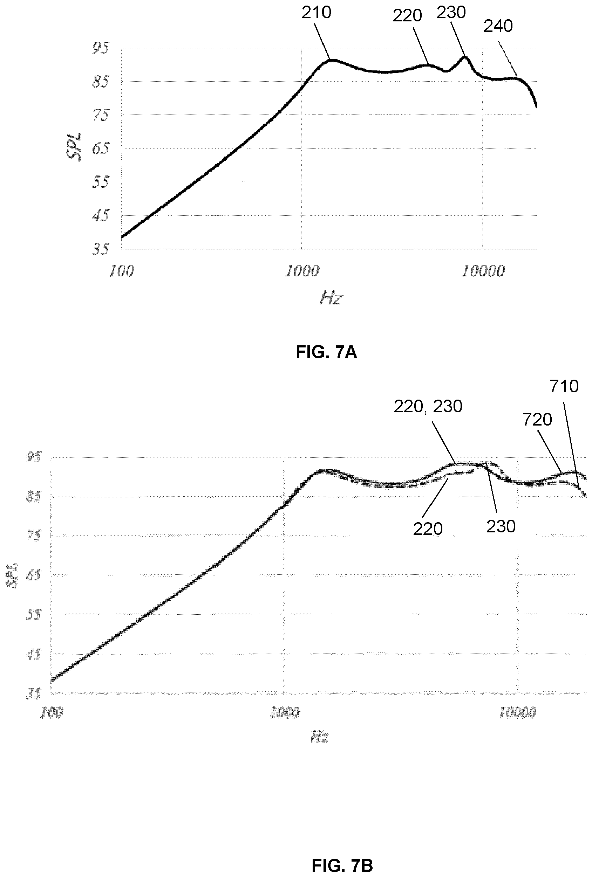

As illustrated in FIG. 7A, by designing the structures of the reinforcing member 120 and the elastic element 110, the vibration component 100 may present a required high-order mode within the audible range (20 Hz-20000 Hz) of the human ears, and the first resonance peak 210, the second resonance peak 220, the third resonance peak 230, and the fourth resonance peak 240 may appear on the frequency response curve of the vibration component 100, i.e., four resonance peaks may be generated on the frequency response curve of the vibration component 100 within the frequency range of 20 Hz-20000 Hz, which makes the vibration component 100 have a relatively high sensitivity within a relatively wide frequency range.

In some embodiments, by designing the structures of the reinforcing member 120 and the elastic element 110, the vibration component 100 may have only three resonance peaks within the audible range (20 Hz-20000 Hz). For example, when a difference between a frequency of the second resonance peak and a frequency of the third resonance peak of the vibration component 100 is less than 2000 Hz, the second resonance peak and the third resonance peak may present as one resonance peak on the frequency response curve of the vibration component 100. As another example, if the central region 112 corresponding to the reinforcing member 120 has not less than one suspension region, and when the resonance frequency of each hollow-out region is higher than the audible range, or the resonance frequencies of the various hollow-out regions are different, vibration phases of different suspension regions within different frequency ranges are different within a high-frequency range (10000 Hz-18000Hz), and an effect of sound superposition and cancellation is generated, a high-frequency roll-off effect may be obtained, and the fourth resonance peak may not be reflected on the frequency response curve of the vibration component 100.

As illustrated in FIG. 7B, FIG. 7B is a schematic diagram illustrating overlapping of a second resonance peak and a third resonance peak according to some embodiments of the present disclosure. In some embodiments, by designing the structure and dimension of the reinforcing member 120, including an overall dimension of the reinforcing member 120, a count and dimension of the one or more strip structures 124, arrangement positions of the one or more strip structures 124, an area of the suspension region 1121 disposed between the region of the central region 112 provided with the reinforcing member 120 and the folded ring region 114, a pattern design (e.g., a folded ring width, a folded ring arch height, and a folded ring arch) of the folded ring region 114, and an area of the connection region 115, the difference between the frequency of the second resonance peak 220 and the frequency of the third resonance peak 230 may be adjusted. In some embodiments, when the difference between the frequency of the second resonance peak 220 and the frequency of the third resonance peak 230 is within a range of 2000 Hz-3000 Hz, a valley may not occur between the second resonance peak 220 and the third resonance peak 230 on the frequency response curve (e.g., a frequency response curve 710) of the vibration component 100, and the second resonance peak 220 and the third resonance peak 230 (corresponding to dotted lines in the figure) may still be distinguished on the frequency response curve. In some embodiments, when the difference between the frequency of the second resonance peak 220 and the frequency of the third resonance peak 230 further decreases, for example, less than 2000 Hz, the second resonance peak 220 and the third resonance peak 230 may present as one resonance peak (corresponding to a solid line in the figure) on the frequency response sound pressure level curve (e.g., a frequency response curve 720) of the vibration component 100, making the vibration component have a relatively high sensitivity in a medium and high-frequency range (3000 Hz-10000 Hz).

By designing the one or more ring structures 122 and the one or more strip structures 124 of the reinforcing member 120, the central region 112 corresponding to the reinforcing member 120 may have not less than one hollow-out region. Each hollow-out region may be a mass-spring-damping system. By designing a position, a dimension, and a count of the strip structure(s) 124 of the reinforcing member 120, the resonance frequency of each hollow-out region may be equal or close to each other. In some embodiments, a difference between the resonance frequencies of the one or more hollow-out regions may be within a range of 4000 Hz, so that one or more high-frequency resonance peaks (i.e., the fourth resonance peak) with a large output sound pressure level may be generated on the frequency response curve of the vibration component 100.

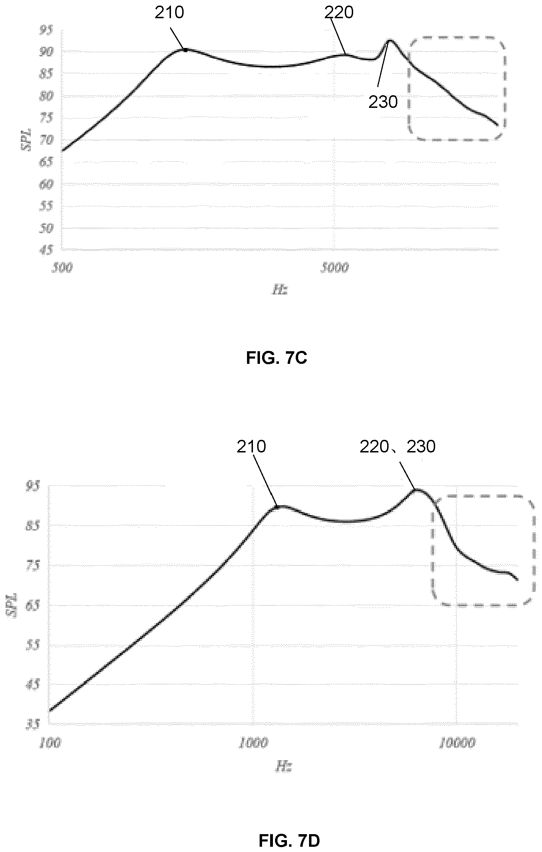

In some embodiments, as illustrated in FIG. 7C, by designing a position, a dimension, and a count of the strip structure(s) 124 of the reinforcing member 120, a resonance frequency of each of one or more hollow-out regions may be higher than an audible range, or the resonance frequency of each of the one or more hollow-out regions may be different, and vibration phases of different hollow-out regions within different frequency ranges of a high-frequency range (10000 Hz-18000 Hz) may be different, resulting in an effect of sound superposition and cancellation, so that a high-frequency roll-off effect may be obtained, and the fourth resonance peak may not be reflected on the sound pressure level frequency response curve of the vibration component 100.

As illustrated in FIG. 7D, FIG. 7D is a schematic diagram illustrating a frequency response curve of the vibration component 100 having two resonance peaks according to some embodiments of the present disclosure. In some embodiments, by designing a structure of the reinforcing member 120, when a difference between a frequency of the second resonance peak 220 and a frequency of the third resonance peak 230 is less than 2000 Hz, the second resonance peak 220 and the third resonance peak 230 may present as one resonance peak on the frequency response sound pressure level curve of the vibration component 100. In addition, by designing a position, a dimension, and a count of the strip structure(s) 124 of the reinforcing member 120, a resonance frequency of each of one or more hollow-out regions may be higher than an audible range, or the resonance frequency of each of the one or more hollow-out regions may be different, and vibration phases of different hollow-out regions within different frequency ranges of a high-frequency range (10000 Hz-18000 Hz) may be different, resulting in an effect of sound superposition and cancellation, so that a high-frequency roll-off effect may be obtained, and the fourth resonance may not be reflected on the sound pressure level frequency response curve of the vibration component 100. At this time, the vibration component 100 may have output characteristics that have a certain bandwidth and a relatively high sensitivity within a medium and high-frequency range (3000 Hz-10000 Hz).

In some embodiments, by designing an area and a thickness of the suspension region 1121 and the folded ring region 114 of the elastic element 110, the second resonance peak of the vibration component 100 may be maintained in the required frequency range. In some embodiments, the second resonance peak of the vibration component 100 may be within a range of 1000 Hz-10000 Hz. In some embodiments, the second resonance peak of the vibration component 100 may be within a range of 3000 Hz-7000 Hz. In some embodiments, when designing the difference between the frequency of the second resonance peak and the frequency of the third resonance peak of the vibration component 100, the difference between the frequency of the second resonance peak and the frequency of the third resonance peak may be less than 3000 Hz.

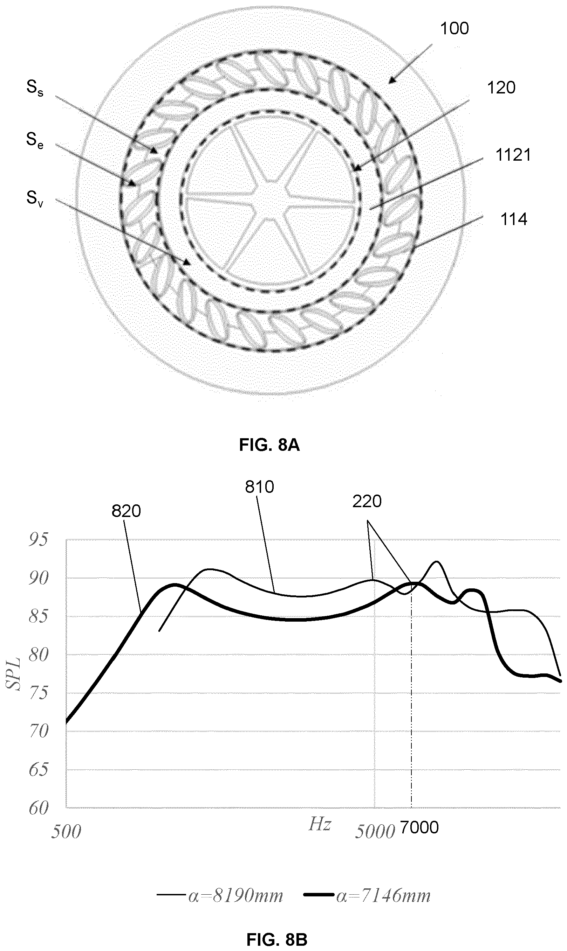

As illustrated in FIG. 8 A, FIG. 8A is a schematic structural diagram illustrating a vibration component including a reinforcing member with a single-ring structure according to some embodiments of the present disclosure. In some embodiments, a horizontal plane projection area (i.e., a projection area of the suspension region 1121 in a vibration direction of the elastic element 110) of the suspension region 1121 is defined as $S_v$, a horizontal plane projection area (i.e., a projection area of the folded ring region 114 in the vibration direction of the elastic element 110) of the folded ring region 114 is defined as $S_e$, and a sum of the horizontal plane projection area $S_v$ of the suspension region 1121 and the horizontal plane projection area $S_e$ of the folded ring region 114 is defined as $S_s$. A physical quantity $\alpha$ (unit in mm) is defined as a ratio of $S_s$ to a thickness Hi of the elastic element 110 (also referred to as a diaphragm):

$$\alpha = \frac{S_s}{H_i}. \quad \text{(Equation 1)}$$

In some embodiments, in order to make the frequency of the second resonance peak of the vibration component 100 to be within a range of 3000 Hz-7000 Hz, the ratio $\alpha$ of $S_s$ to the thickness Hi of the diaphragm may be within a range of 5000 mm-12000 mm. In some embodiments, in order to make the frequency of the second resonance peak of the vibration component 100 to be within a range of 3000 Hz-7000 Hz, the $\alpha$ may be within a range of 6000 mm-10000 mm. In some embodiments, in order to further adjust the frequency of the second resonance peak of the vibration component 100 to move to high frequency, the value range of $\alpha$ may be 6000 mm -9000 mm. In some embodiments, in order to further adjust the frequency range of the second resonance peak of the vibration component 100 to move to high frequency, the $\alpha$ may be within a range of 6000 mm-8000 mm. In some embodiments, in order to further adjust the frequency of the second resonance peak of the vibration component 100 to move to high frequency, the $\alpha$ may be within a range of 6000 mm-7000 mm.

In some embodiments, a relationship among an area of the suspension region 1121, an area of the folded ring region 114, and the thickness of the elastic element 110 may affect a local equivalent mass Mms and a local equivalent mass $Mm_2$, a local regional stiffness $Ka_2'$, and a local regional stiffness Kai', which in turn affects an equivalent mass Ms, an equivalent stiffness Ks, and equivalent damping Rs formed by the connection region 115, the folded ring region 114, and the suspension region 1121, thereby controlling the range the second resonance peak of the vibration component 100. In some embodiments, the second resonance peak of the vibration component 100 may also be controlled through the design of a folded ring arch height of the folded ring region 114.

FIG. 8B is a schematic diagram illustrating frequency response curves of vibration components according to some embodiments of the present disclosure. In some embodiments, as illustrated in FIG. 8B, frequency response curve 810 represents a frequency response curve of the vibration component when $\alpha$ = 8190 mm; frequency response curve 820 represents a frequency response curve of the vibration component when $\alpha$ = 7146 mm; and frequency response curve 830 represents a frequency response curve of the vibration component when $\alpha$ = 12360 mm. It can be known from the frequency response curve 820 that when $\alpha$ = 7146 mm, the frequency of the second resonance peak 220 of the vibration component 100 may be approximately 7000 Hz. It can be known from the frequency response curve 810 that when $\alpha$ = 8190 mm, the frequency of the second resonance peak 220 of the vibration component 100 may be approximately 5000 Hz. An amplitude of the second resonance peak 220 of the frequency response curve 810 may be close to an amplitude of the second resonance peak 220 of the frequency response curve 820. That is, as $\alpha$ increases, the resonance frequency of the second resonance peak 220 may decrease, and the amplitude may remain basically constant. It can be known from the frequency response curve 820 that when $\alpha$ = 12360 mm,

the vibration component 100 may have no obvious second resonance peak. In this case, the amplitude of the vibration component 100 within 3000 Hz-7000 Hz may decrease in comparison with those of the frequency response curve 810 and the frequency response curve 820, i.e., an output sound pressure level of the vibration component 100 is relatively low when $\alpha$ = 12360 mm. Therefore, when the $\alpha$ is within a range of 6000mm-10000mm, the frequency of the second resonance peak of the vibration component 100 may be better controlled to be within a range of 3000 Hz-7000 Hz, so that the vibration component 100 may have a relatively high output sound pressure level within the range of 3000 Hz-7000 Hz.

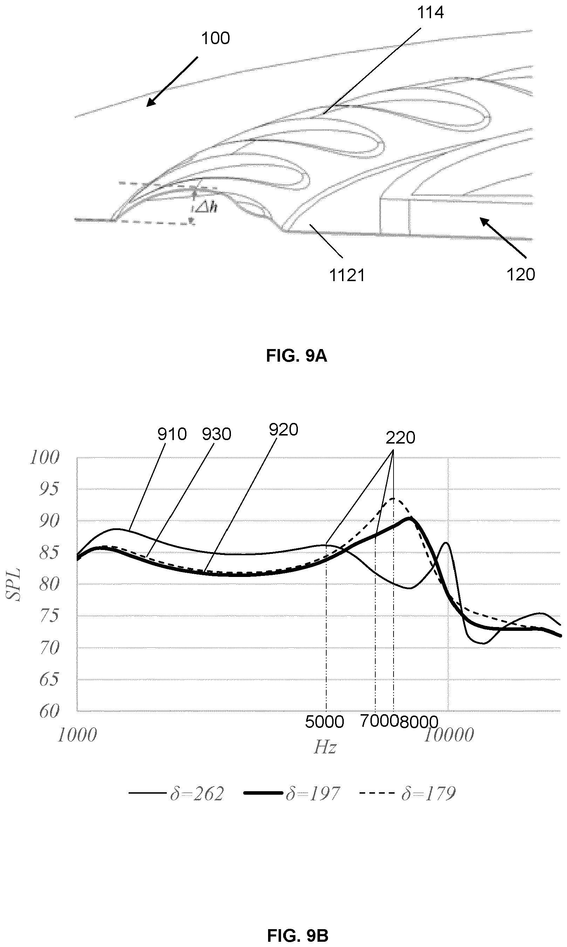

As illustrated in FIG. 9A, FIG. 9A is a partial structural diagram illustrating a vibration component according to some embodiments of the present disclosure. In the present disclosure, a folded ring arch height $\Delta$h of the folded ring region 114 is defined. A physical quantity $\delta$ (mm) is defined as a ratio of $S_s$ to the folded ring arch height $\Delta$h of the diaphragm:

$$\delta = \frac{S_s}{\Delta h}. \quad \text{(Equation 2)}$$

In some embodiments, $\delta$ may be within a range of 50 mm-600 mm. In some embodiments, $\delta$ may be within a range of 100 mm-500 mm. In some embodiments, in order to make the frequency of the second resonance peak of the vibration component 100 to be within a range of 3000 Hz-7000 Hz, $\delta$ may be within a range of 200 mm-400 mm. In some embodiments, in order to further move the frequency of the second resonance peak of the vibration component 100 to low frequency within the range of 3000 Hz-7000 Hz, $\delta$ may be within a range of 300 mm-400 mm. In some embodiments, in order to further move the frequency of the second resonance peak of the vibration component 100 to low frequency within the range of 3000 Hz-7000 Hz, $\delta$ may be within a range of 350 mm-400 mm. In some embodiments, in order to move the frequency of the second resonance peak of the vibration component 100 to high frequency within the range of 3000 Hz-7000 Hz, $\delta$ may be within a range of 200 mm-300 mm. In some embodiments, in order to further move the frequency of the second resonance peak of the vibration component 100 to high frequency within the range of 3000 Hz-7000 Hz, $\delta$ may be within a range of 200 mm-250 mm.

In some embodiments, by the design of the folded ring arch height, a three-dimensional dimension of the folded ring region 114 may be changed without changing horizontal projection areas of the folded ring region 114 and the suspension region 1121, so that the stiffness $Ka_1'$ of the folded ring region 114 may be changed, thereby controlling the second resonance peak of the loudspeaker. In some embodiments, the output sound pressure level of the loudspeaker may also be controlled by adjusting the dimension of the reinforcing member.

FIG. 9B is a schematic diagram illustrating frequency response curves of vibration components according to some embodiments of the present disclosure. In some embodiments, as illustrated in FIG. 9B, frequency response curve 910 represents a frequency response curve of the vibration component 100 when δ = 262 mm; and frequency response curve 920 represents a frequency response curve of the vibration component 100 when δ = 197 mm. It can be known from the frequency response curve 910 that when δ = 262 mm, a frequency of the second resonance peak 220 of the vibration component 100 may be approximately 5000 Hz. It can be known from the frequency response curve 920 that when δ = 197 mm, the frequency of the second resonance peak 220 of the vibration component 100 may be approximately 7000 Hz. Therefore, as δ increases, the resonance frequency of the second resonance peak 220 may decrease, and when the δ is within a range of 200 mm-400 mm, the frequency of the second resonance peak of the vibration component 100 may be better controlled to be within a range of 3000 Hz-7000 Hz.

In the present disclosure, a horizontal projection area of the central region 112 is defined as $S_c$, a horizontal projection area of a maximum contour of the reinforcing member 120 is defined as $S_{rm}$, and a horizontal projection area of the suspension region 1121 is defined as $S_v$, wherein: $S_{rm}=S_c-S_v$.

In the present disclosure, a physical quantity $\vartheta$ (unit is 1) is defined as a ratio of the horizontal projection area $S_v$ of the suspension region 1121 to the horizontal projection area $S_c$ of the central region 112:

$$\vartheta = \frac{S_v}{S_c}. \quad \text{(Equation 3)}$$

In some embodiments, $\vartheta$ may be within a range of 0.05-0.7. In some embodiments, $\vartheta$ may be within a range of 0.1-0.5. In some embodiments, in order to make the frequency of the second resonance peak of the vibration component 100 to be within a range of 3000 Hz-7000 Hz, $\vartheta$ may be within a range of 0.15-0.35. In some embodiments, in order to further move the second resonance peak of the vibration component 100 to high frequency within the range of 3000 Hz-7000 Hz, $\vartheta$ may be within a range of 0.15-0.25. In some embodiments, $\vartheta$ may be within a range of 0.15-0.2. In some embodiments, in order to further move the second resonance peak of the vibration component 100 to low frequency within the range of 3000 Hz-7000 Hz, $\vartheta$ may be within a range of 0.25-0.35. In some embodiments, in order to further move the second resonance peak of the vibration component 100 to low frequency within the range of 3000 Hz-7000 Hz, $\vartheta$ may be within a range of 0.3-0.35.

In some embodiments, when the vibration component deforms near the frequency corresponding to the second resonance peak, the suspension region 1121 and the folded ring region 114 may generate a local resonance. In this case, by designing the dimension (i.e., a dimension of the maximum contour of the reinforcing member 120) of the reinforcing member 120, the reinforcing member 120 may achieve a certain bending deformation within the frequency range, thereby realizing superposition increment of the sound pressure in different regions of the diaphragm, and realizing a maximum sound pressure level output of the vibration component or the loudspeaker at the second resonance peak.

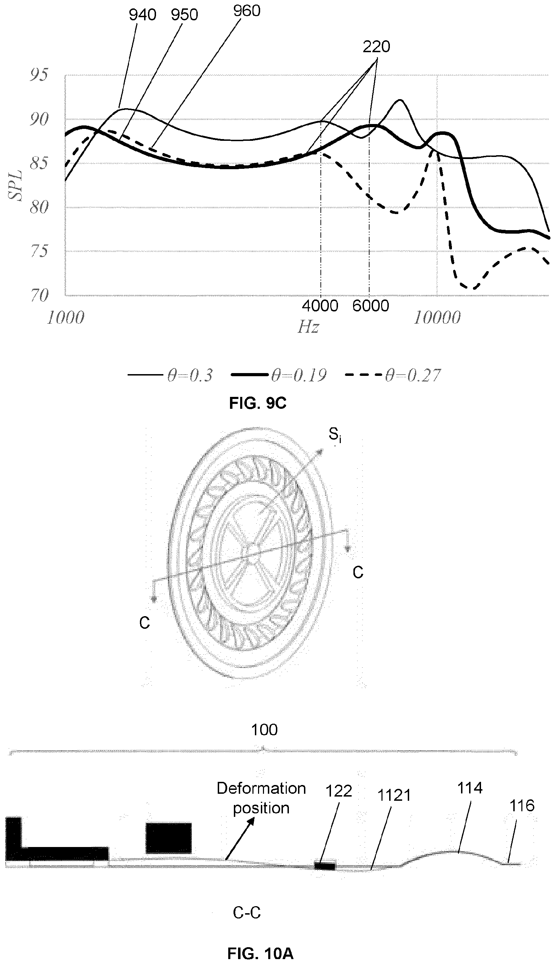

FIG. 9C is a schematic diagram illustrating frequency response curves of vibration components according to some embodiments of the present disclosure. In some embodiments, as illustrated in FIG. 9C, the frequency response curve 940 represents a frequency response curve of the vibration component 100 when $\vartheta$ = 0.3; and frequency response curve 950 represents a frequency response curve of the vibration component 100 when $\vartheta$ = 0.19. It can be known from the frequency response curve 940 that when $\vartheta$ = 0.3, the frequency of the second resonance peak 220 of the vibration component 100 may be 4000 Hz. It can be known from the frequency response curve 950 that when $\vartheta$ = 0.19, the frequency of the second resonance peak 220 of the vibration component 100 may be 6000 Hz. Accordingly, as $\vartheta$ decreases, the resonance frequency of the second resonance peak 220 may increase, and when $\vartheta$ is within a range of 0.15-0.35, the frequency of the second resonance peak of the vibration component 100 may be better controlled to be within a range of 3000 Hz-7000 Hz.

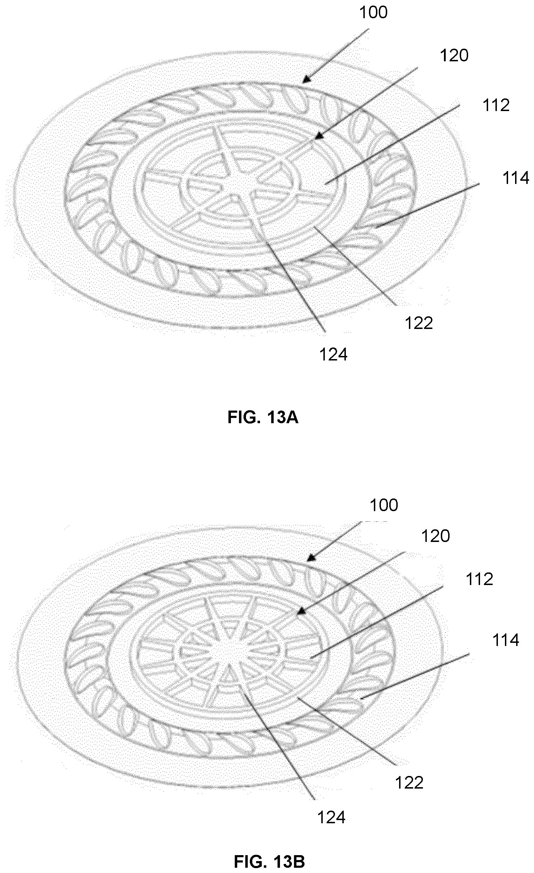

In some embodiments, the one or more strip structures 124 may have different widths, shapes, and counts, to change the one or more hollow-out regions (corresponding to the suspension region of the central region 112) of the reinforcing member 120, thereby adjusting the frequency response of the loudspeaker. More descriptions may be found in subsequent FIG. 13A-FIG.18C and related descriptions thereof.

In some embodiments, the resonance frequency of the vibration component 100 may be controlled by designing areas of the one or more hollow-out regions to improve the use performance of the vibration component 100. For example, the resonance frequency of the vibration component 100 may be controlled by designing a count and positions of the one or more strip structures 124 of the reinforcing member 120, a count and positions of the one or more ring structures 122, etc. In some embodiments, a fourth resonance peak of the vibration component 100 may be within a range of 8000 Hz-20000 Hz. In some embodiments, the fourth resonance peak of the vibration component 100 may be within a range of 10000 Hz-18000 Hz.

As illustrated in FIG. 6 and FIG. 10A, FIG. 10A is a schematic diagram illustrating a deformation of a C-C cross-section of a vibration component including a reinforcing member with a single-ring structure near a frequency of a fourth resonance peak according to some embodiments of the present disclosure. It can be seen from FIG. 6 that a difference Δf between a frequency of the fourth resonance peak 240 and a frequency of the third resonance peak 230 has a great influence on the flatness of the frequency response curve of the vibration component 100 in a high-frequency range. In some embodiments, as illustrated in FIG. 10A, it can be seen from the vibration of the vibration component 100 at a C-C cross-sectional position that near the frequency of the fourth resonance peak, main deformation of the vibration component 100 may be deformations of one or more hollow-out regions of the central region 112. In some embodiments, the fourth resonance peak 240 of the vibration component 100 may be controlled by controlling an equivalent mass $Mm_i$ and an equivalent stiffness $Ka_i$ corresponding to a mass-spring-damping system of each of the one or more hollow-out regions of the reinforcing member 120 corresponding to the central region. For example, an area of each of the one or more hollow-out regions of the central region 112 may be designed by designing the count and dimensions of the one or more strip structures 124 and the one or more ring structures 122. The area of each of the one or more hollow-out regions is defined as $S_i$. It should be noted that although FIG. 10A illustrates the deformation of the vibration component 100 including the reinforcing member 120 with a single-ring structure corresponding to the fourth resonance peak, for a vibration component including the reinforcing member 120 with multi-ring structures, the conclusion is still applicable (e.g., the vibration component 100 in FIG. 5).

In order to make the frequency of the fourth resonance peak to be within an appropriate range (10000 Hz-18000 Hz), a physical quantity is defined in the present disclosure: a ratio of the area $S_i$ of any one of the one or more hollow-out regions (i.e., a projection area of any one hollow-out portion in a vibration direction of the elastic element 110) to a thickness $H_i$ of a diaphragm (e.g., the elastic element 110) of each of the one or more hollow-out regions is an area-thickness ratio $\mu$ (mm):

$$\mu = \frac{S_i}{H_i}. \quad \text{(Equation 4)}$$

In some embodiments, when the Young's modulus and density of the diaphragm (e.g., the elastic element 110) are within a preset range, a frequency position of the fourth resonance peak of the vibration component may be adjusted by designing the value of $\mu$. In some embodiments, the Young's modulus of the diaphragm may be within a range of 5*10^8 Pa-1*10^10 Pa. In some embodiments, the Young's modulus of the diaphragm may be within a range of 1*10^9 Pa-5*10^9 Pa. In some embodiments, the density of the diaphragm may be within a range of 1*10^3 kg/m³-4*10^3 kg/m³. In some embodiments, the density of the diaphragm may be within a range of 1*10^3 kg/m³-2*10^3 kg/m³.

In some embodiments, the area-thickness ratio $\mu$ may be within a range of 1000 mm-10000 mm. In some embodiments, the area-thickness ratio $\mu$ may be within a range of 1500 mm-9000 mm. In some embodiments, the area-thickness ratio $\mu$ may be within a range of 2000 mm-8000 mm. In some embodiments, the area-thickness ratio $\mu$ may be within a range of 2500 mm-7500 mm. In some embodiments, the area-thickness ratio $\mu$ may be within a range of 3000 mm-7000 mm. In some embodiments, the area-thickness ratio $\mu$ may be within a range of 3500 mm-6500 mm. In some embodiments, the area-thickness ratio $\mu$ may be within a range of 4000 mm-6000 mm.

In some embodiments, by designing the area of each of the one or more hollow-out regions and the thickness of the diaphragm, the equivalent mass $Mm_i$ and the equivalent stiffness $Ka_i$ of each of the one or more hollow-out regions may be controlled, thereby controlling the fourth resonance peak of a loudspeaker.

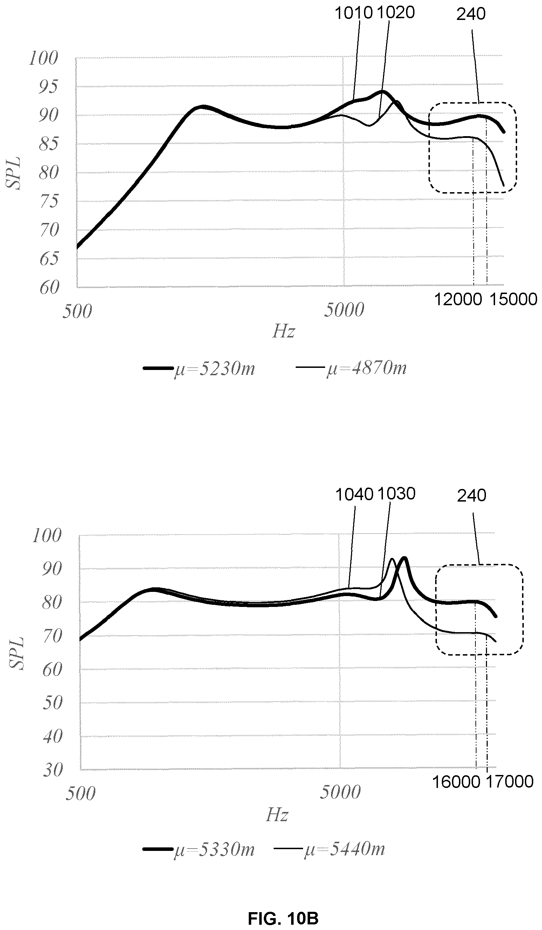

FIG. 10B is a schematic diagram illustrating frequency response curves of vibration components according to some embodiments of the present disclosure. In some embodiments, as illustrated in FIG. 10B, frequency response curve 1010 represents a frequency response curve of a vibration component when $\mu$ = 5230 mm; frequency response curve 1020 represents a frequency response curve of the vibration component when $\mu$ = 4870 mm; frequency response curve 1030 represents a frequency response curve of the vibration component when $\mu$ = 5330 mm; and frequency response curve 1040 represents a frequency response curve of the vibration component when $\mu$ = 5440 mm. As illustrated in FIG. 10B, a frequency of a fourth resonance peak of the frequency response curve 1010 corresponding to $\mu$ = 5230 mm may be approximately 15000 Hz. The frequency of the fourth resonance peak of the frequency response curve 1020 corresponding to $\mu$ = 4870 mm may be approximately 12000 Hz. The frequency of the fourth resonance peak of the frequency response curve 1030 corresponding to $\mu$ = 5330 mm may be approximately 16000 Hz. The frequency of the fourth resonance peak of the frequency response curve 1040 corresponding to $\mu$ = 5440 mm may be approximately 17000 Hz. Accordingly, when the value $\mu$ is within a range of 4000 mm- 6000 mm, the frequency of the fourth resonance peak of the vibration component 100 may be better controlled to be within a range of 10000 Hz-18000 Hz.

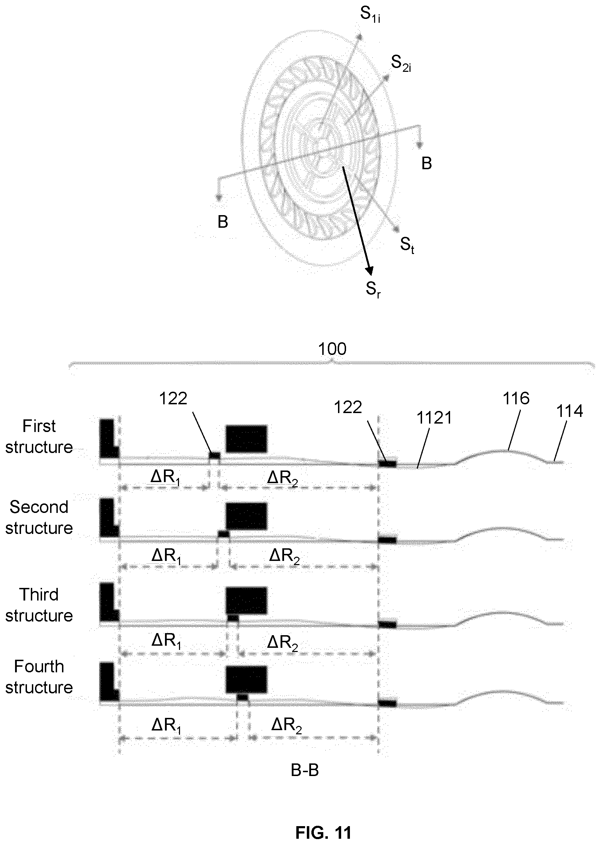

As illustrated in FIG. 11, in some embodiments, the reinforcing member 120 may have a multi-ring structure (e.g., a double-ring structure), i.e., the reinforcing member 120 may include a plurality of radially adjacent ring structures (e.g., a first ring structure, a second ring structure, etc.). Diameters of the plurality of ring structures may be different. A ring structure with a relatively small diameter may be arranged at inner sides of a ring structure with a relatively large diameter. According to the present disclosure, an area of a hollow-out region of the elastic element 110 in the first ring structure is defined as $S_{1i}$. When the first ring structure and the second ring structure are adjacent ring structures, an area of a hollow-out region of the elastic element 110 between the first ring structure and the second ring structure is defined as $S_{2i}$. In some embodiments, the reinforcing member 120 may also have more ring structures 122. An area of a hollow-out region of the elastic element 110 between an n-1th ring structure and an nth ring structure is sequentially defined as $S_{ni}$ from inside to outside. The one or more hollow-out regions located between the ring structures of different diameters may include a first hollow-out region and a second hollow-out region. A distance between a centroid of the first hollow-out region and a center of the central region and a distance between a centroid of the second hollow-out region and the center of the central region may be different. According to the present disclosure, a ratio $\gamma$ (unit: 1) of areas of the one or more hollow-out regions of the elastic element 110 is defined as a ratio of an area $S_{ki}$ of the first hollow-out region to an area $S_{ji}$ of the second hollow-out regions:

$$\gamma = \frac{S_{ki}}{S_{ji}}, \quad \text{(Equation 5)}$$

wherein k>j. By designing a value of $\gamma$, the frequency position of the fourth resonance peak of the vibration component and an output sound pressure level may be adjusted.

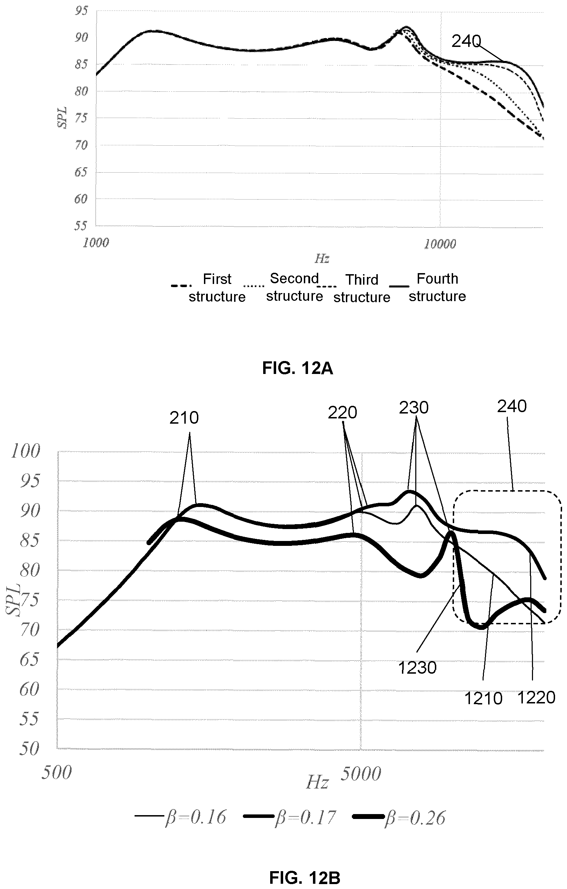

As illustrated in FIG. 11 and FIG. 12A, FIG. 12A illustrates frequency response curves of vibration components corresponding to FIG. 11. From the first structure to the fourth structure, an area ratio $\gamma$ of an area $S_{2i}$ (i.e., the first hollow-out region) of a hollow-out region between a first ring region and a second ring region to an area $S_{1i}$ (i.e., the second hollow-out region) of a hollow-out region in the first ring region may be 5.9, 4.7, 3.9, and 3.2 in sequence. It can be seen from FIG. 11 that at the position of the fourth resonance peak of the vibration component 100, from the first structure to the fourth structure, as $\gamma$ decreases, a radius $\Delta R_1$ of the first hollow-out region located within the ring structures 122 located at the inner side may gradually increase, and a radius $\Delta R_2$ of the second hollow-out region between the ring structure 122 located at the inner side and the ring structure 122 located at the outer side may gradually decrease. In some embodiments, further referring to FIG. 12A, from the first structure to the fourth structure, a sound pressure amplitude output at the fourth resonance peak of the frequency response curve of the vibration component gradually increases. Accordingly, the ratio of the areas of the one or more hollow-out regions of the central region 112 may affect the resonance frequency of each of the one or more hollow-out regions. Finally, an effect of sound pressure superposition in the high-frequency range may be obtained. That is, the high-frequency sensitivity of the vibration component 100 may be adjusted by setting the value of $\gamma$.

In some embodiments, the ratio of the areas of the one or more hollow-out regions in the central region 112 may be as small as possible. For example, the ratio $\gamma$ of the area $S_{ki}$ of the first hollow-out region to the area $S_{ji}$ of the second hollow-out region may be within a range of 0.1-10. In some embodiments, the ratio $\gamma$ of the area $S_{ki}$ of the first hollow-out region to the area $S_{ji}$ of the second hollow-out region may be within a range of 0.16-6. In some embodiments, the ratio $\gamma$ of the area $S_{ki}$ of the first hollow-out region to the area $S_{ji}$ of the second hollow-out region may be within a range of 0.2-5. In some embodiments, the ratio $\gamma$ of the area $S_{ki}$ of the first hollow-out region to the area $S_{ji}$ of the second hollow-out region may be within a range of 0.25-4. In some embodiments, the ratio $\gamma$ of the area $S_{ki}$ of the first hollow-out region to the area $S_{ji}$ of the second hollow-out region may be within a range of 0.25-1. In some embodiments, the ratio $\gamma$ of the area $S_{ki}$ of the first hollow-out region to the area $S_{ji}$ of the second hollow-out region may be within a range of 0.25-0.6. In some embodiments, the ratio $\gamma$ of the area $S_{ki}$ of the first hollow-out region to the area $S_{ji}$ of the second hollow-out region may be within a range of 0.1-4. In some embodiments, the ratio $\gamma$ of the area $S_{ki}$ of the first hollow-out region to the area $S_{ji}$ of the second hollow-out region may be within a range of 0.1-3. In some embodiments, the ratio $\gamma$ of the area $S_{ki}$ of the first hollow-out region to the area $S_{ji}$ of the second hollow-out region may be within a range of 0.1-2. In some embodiments, the ratio $\gamma$ of the area $S_{ki}$ of the first hollow-out region to the area $S_{ji}$ of the second hollow-out region may be within a range of 0.1-1.

In some embodiments, the ratio of the areas of the one or more hollow-out regions of the elastic elements 110 may affect a difference between resonance frequencies of the one or more hollow-out regions. The resonance frequencies of the one or more hollow-out regions may be equal or close to each other such that sound pressures of the one or more hollow-out regions can be superimposed, thereby increasing the output sound pressure level of a loudspeaker at the fourth resonance peak.

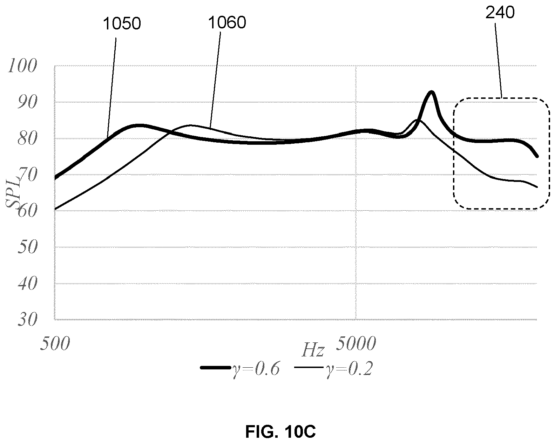

FIG. 10C is a schematic diagram illustrating frequency response curves of vibration components according to some embodiments of the present disclosure. In some embodiments, as illustrated in FIG. 10C, frequency response curve 1050 represents a frequency response curve of a vibration component when $\gamma=0.6$; and frequency response curve 1060 represents a frequency response curve of the vibration component when $\gamma = 0$. As illustrated in FIG. 10C, an output sound pressure level (amplitude) of the frequency response curve 1050 at a fourth resonance peak is relatively high, and an output sound pressure level (amplitude) of the frequency response curve 1060 at the fourth resonance peak is relatively low. Accordingly, when $\gamma$ is within a range of 0.25-4, the vibration component 100 may have a relatively high output sound pressure level within a high-frequency range (e.g., 10000 Hz-18000 Hz).

In some embodiments, the mass, centroid, and stiffness of the reinforcing member 120, and the mass and stiffness of the hollow-out region(s) of the central region 112 may be adjusted by designing a projection area of the reinforcing member 120 in a vibration direction and a projection area of a maximum contour of the reinforcing member 120 in the central region 112 in the vibration direction, thereby adjusting a first resonance peak, a third resonance peak, and the fourth resonance peak of the vibration component 100.

In the present disclosure, as illustrated in FIG. 11, a ratio β (unit: 1) of a horizontal area of the reinforcing portion of the reinforcing member 120 to a horizontal area of the reinforcing member 120 is defined as a ratio of a projection area $S_r$ of the reinforcing portion to a projection area St of a maximum contour of the reinforcing member 120 in the central region 112 in the projection of the reinforcing member 120 in the vibration direction:

$$\beta = \frac{S_r}{S_t}. \quad \text{(Equation 6)}$$

In some embodiments, the ratio β of the horizontal area of the reinforcing portion of the reinforcing member 120 to the horizontal area of the reinforcing member 120 may be within a range of 0.1-0.8. In some embodiments, the ratio β of the horizontal area of the reinforcing portion of the reinforcing member 120 to the horizontal area of the reinforcing member 120 may be within a range of 0.2-0.7. In some embodiments, the ratio β of the horizontal area of the reinforcing portion of the reinforcing member 120 to the horizontal area of the reinforcing member 120 may be within a range of 0.1-0.7. In some embodiments, the ratio β of the horizontal area of the reinforcing portion of the reinforcing member 120 to the horizontal area of the reinforcing member 120 may be within a range of 0.2-0.6. In some embodiments, the ratio β of the horizontal area of the reinforcing portion of the reinforcing member 120 to the horizontal area of the reinforcing member 120 may be within a range of 0.3-0.6. In some embodiments, the ratio β of the horizontal area of the reinforcing portion of the reinforcing member 120 to the horizontal area of the reinforcing member 120 may be within a range of 0.4-0.5. In some embodiments, the ratio β of the horizontal area of the reinforcing portion of the reinforcing member 120 to the horizontal area of the reinforcing member 120 may be within a range of 0.3-0.5. In some embodiments, the ratio β of the horizontal area of the reinforcing portion of the reinforcing member 120 to the horizontal area of the reinforcing member 120 may be within a range of 0.2-0.5. In some embodiments, the ratio β of the horizontal area of the reinforcing portion of the reinforcing member 120 to the horizontal area of the reinforcing member 120 may be within a range of 0.1-0.5.

In some embodiments, by designing the projection area of the reinforcing member 120 in the vibration direction and the projection area of the maximum contour of the reinforcing member 120 in the vibration direction, the mass, the centroid, and the stiffness of the reinforcing member 120 may be controlled, and the mass and the stiffness of the hollow-out region(s) of the central region 112 may be adjusted, thereby controlling a total equivalent mass Mt formed by the combination of the mass of the reinforcing member 120, the mass of the elastic element 110, the equivalent air mass, and the driving end equivalent mass, and then adjusting the first resonance peak, the third resonance peak, and the fourth resonance peak of the loudspeaker.

FIG. 12B is a schematic diagram illustrating frequency response curves of vibration components according to some embodiments of the present disclosure. In some embodiments, as illustrated in FIG. 12B, frequency response curve 1210 represents a frequency response curve of a vibration component when β= 0.16; frequency response curve 1220 represents a frequency response curve of the vibration component when β = 0.17; and frequency response curve 1230 represents a frequency response curve of the vibration component when β = 0.26. As illustrated in FIG. 12B, the frequency response curve 1210, the frequency response curve 1220, and the frequency response curve 1230 may have the first resonance peak 210, the second resonance peak 220, the third resonance peak 230, and the fourth resonance peak 240. When the value of β changes, frequencies of the first resonance peak 210, the third resonance peak 230, and the fourth resonance peak 240 may change greatly, while a frequency of the second resonance peak 220 may change little. When β=0.16, the frequency response curve 1210 may not reflect the fourth resonance peak 240. When β increases to 0.17, the first resonance peak 210 and the second resonance peak 220 of the vibration component may change little, the third resonance peak 230 may move to high frequency, and a high-frequency output sound pressure level may increase, which reflects the obvious fourth resonance peak 240. When β increases to 0.26, the first resonance peak 210 may move to low frequency, the third resonance peak 230 may move to high frequency, the fourth resonance peak 240 may move to high frequency, and an overall output sound pressure level of the vibration component may decrease. Accordingly, when the value of β changes, the first resonance peak, the third resonance peak, and the fourth resonance peak of the vibration component 100 may be adjusted. In order to make the first resonance peak, the third resonance peak and the fourth resonance peak of the vibration component 100 to be within an appropriate range (e.g., a range illustrated in the embodiments of the present disclosure) and enable the vibration component to have a relatively high output sound pressure level, the value of β may be within a range of 0.1-0.5.

As illustrated in FIG. 13A and FIG. 13B, FIG. 13A and FIG. 13B are schematic structural diagrams illustrating vibration components including different counts of strip structures according to some embodiments of the present disclosure. In some embodiments, an total mass of the vibration component 100 may be adjusted by adjusting the count of the one or more strip structures 124, so that a total equivalent mass Mt formed by the combination of a mass of the reinforcing member 120, a mass of the elastic element 110, an equivalent air mass, and a driving end equivalent mass may change, and a resonance frequency of a mass Mt-spring Kt-damping Rt system may change, which in turn causes a first-order resonance frequency of the vibration component 100 to change, resulting in a change of a sensitivity within a low-frequency range before the first resonance frequency of the vibration component 100 and a medium frequency range after the first resonance frequency of the vibration component 100. In some embodiments, a larger number of strip structures 124 may be designed, so that the total equivalent mass Mt may be increased, and the first resonance frequency of the vibration component 100 may be advanced, thereby increasing a sensitivity within a low-frequency range before the first resonance frequency of the vibration component 100, such as a frequency range before 3000 Hz, a frequency range before 2000 Hz, a frequency range before 1000 Hz, a frequency range before 500 Hz, or a frequency range before 300 Hz. In some embodiments, a small number of strip structures 124 may be designed, so that the total equivalent mass Mt may be decreased, and the first resonance frequency of the vibration component 100 may be moved backward, thereby increasing the sensitivity within the medium frequency range after the first resonance frequency of the vibration component 100. As another example, a sensitivity within a frequency range after 3000 Hz may be increased. As another example, a sensitivity within a frequency range after 2000 Hz may be increased. As another example, a sensitivity within a frequency range after 1000 Hz may be increased. As another example, a sensitivity within a frequency range after 500 Hz may be increased. As another example, a sensitivity within a frequency range after 300 Hz may be increased.

In some embodiments, the stiffness of the reinforcing member 120 may also be adjusted by adjusting the count of strip structures 124, so that the stiffness $Kt_1$ provided to the system by the reinforcing member 120 and the elastic element 110 may change, and for a mass $Mt_1$-spring Kti-damping $Rt_1$ system formed by a total equivalent mass $Mt_1$ and a total equivalent damping $Rt_1$, in which the total equivalent mass $Mt_1$ is formed by the combination of the reinforcing member 120, the connection region 115, the folded ring region 114, the suspension region disposed between a portion of the central region 112 covered by the reinforcing member 120 and the folded ring region 114, an equivalent air mass, and a driving end equivalent mass, and the total equivalent damping $Rt_1$ is formed by equivalent damping of each part, the mass Mti-spring $Kt_1$-damping $Rt_1$ system may take a ring region in a diameter direction of the reinforcing member 120 as an equivalent fixed fulcrum, and a resonance frequency of a flipping motion of the ring may change, thereby causing a third resonance position of the vibration component 100 to change.

In some embodiments, an area of no less than one suspension region of the central region 112 corresponding to the reinforcing member 120 may also be adjusted by adjusting the count of the one or more strip structures 124, so that an equivalent mass $Mm_i$, equivalent stiffnesses Kai and Kai', equivalent damping $Ra_i$ and $Ra_i$' of each of the one or more hollow-out regions may change, thereby causing the fourth resonance peak of the vibration component to change. In some embodiments, by adjusting the count of the one or more strip structures 124, the area-thickness ratio $\mu$ of the vibration component and the ratio $\beta$ of the horizontal area of the reinforcing portion of the reinforcing member 120 to the horizontal area of the reinforcing member 120 may also be adjusted, thereby adjusting the position of the fourth resonance peak of the vibration component.

In some embodiments, the count of the one or more strip structures 124 of the reinforcing member 120 is adjustable, and the positions of the first resonance peak, the third resonance peak, and the fourth resonance peak of the vibration component 100 may be adjusted based on actual application requirements so that the frequency response of the vibration component 100 is controllably adjustable.

In some embodiments, since the shape of a projection of the strip structure 124 in the vibration direction of the elastic element 110 includes at least one of a rectangle, a trapezoid, a curve, an hourglass shape, and a petal shape, the areas of the one or more hollow-out regions (corresponding to the suspension region of the central region 112 within the projection range of the reinforcing member 120) of the reinforcing member 120 may be changed by adjusting the shapes of the one or more strip structures 124, such that a relationship (the area-thickness ratio $\mu$) between the area of the hollow-out region and the thickness of the elastic element 110 may be adjusted, thereby adjusting the fourth resonance peak. In addition, a relationship (the ratio $\gamma$ of the areas of the one or more hollow-out regions) among the areas of the one or more hollow-out regions between different ring structures 122 of the reinforcing member 120 may be changed to adjust the fourth resonance peak. Furthermore, a relationship (the ratio $\beta$ of the horizontal area of the reinforcing portion of the reinforcing member 120 to the horizontal area of the reinforcing member 120) between the horizontal area of the reinforcing portion of the reinforcing member 120 and the horizontal area of the reinforcing member 120 may be changed to adjust the first resonance peak, the third resonance peak, and the fourth resonance peak.

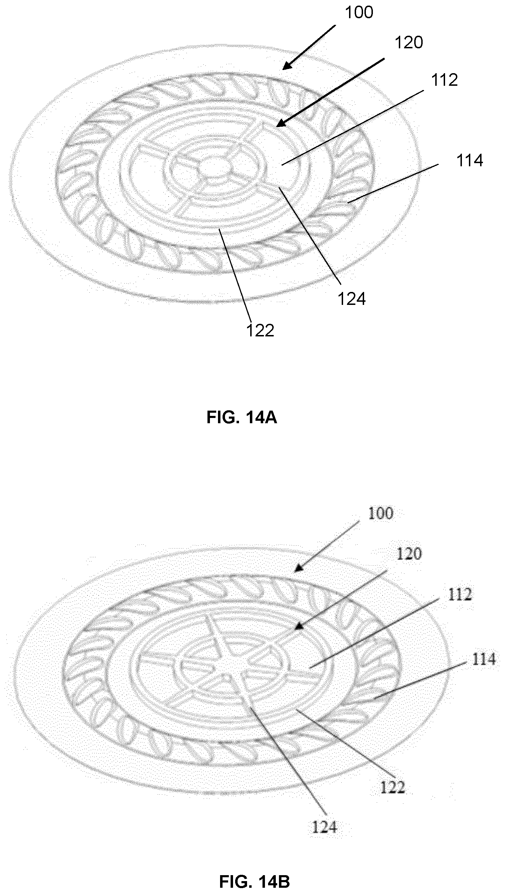

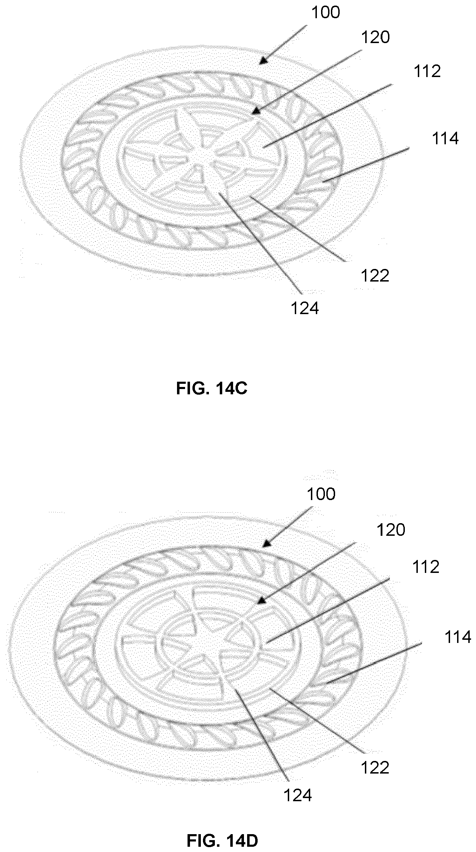

As illustrated in FIG. 14A- FIG.14D, FIG. 14A- FIG. 14D are schematic structural diagrams illustrating vibration components including strip structures of different widths according to some embodiments of the present disclosure. The strip structure in FIG. 14A may be an inverted trapezoid (i.e., a short side of the trapezoid is close to the center of the reinforcing member 120). The strip structure 124 in FIG. 14 B may be a trapezoid (i.e., the short side of the trapezoid is far away from the center of the reinforcing member 120). The strip structure 124 in FIG. 14C may be an outer arc shape. The strip structure 124 in FIG. 14 D may be an inner arc shape. In some embodiments, by designing the strip structure 124 with different horizontal widths, the position of a centroid of the reinforcing member 120 may be effectively adjusted. In some embodiments, the stiffness of the reinforcing member 120 may also be changed without changing the mass of the reinforcing member 120, so that the stiffness $Kt_1$ provided by the reinforcing member 120 and the elastic element 110 (especially the portion of the central region 112 covered by the reinforcing member 120) to the system may change, further causing the resonance frequency of the flipping motion of the mass Mti-spring Kti-damping $Rt_1$ system to change, thereby causing the third resonance frequency of the vibration component 100 to change.

In some embodiments, by changing the width design of the strip structure 124, the strip structure 124 may have different local stiffness at different positions extending from the center to the periphery. When a driving end frequency is close to the resonance frequency of the mass Mti-spring Kti-damping $Rt_1$ system, the connection region 115 between the fixed region 116 and the folded ring region 114, the folded ring region 114, and the suspension region disposed between the portion of the central region 112 covered by the reinforcing member 120 and the folded ring region 114 may be driven by the reinforcing member 120 to vibrate and generate a resonance peak with an adjustable 3dB bandwidth.

As illustrated in FIG. 14A- FIG. 14D, in some embodiments, by designing the inverted trapezoidal strip structure 124 and the outer arc-shaped (an outer arc shape is defined as a shape that protrudes outwardly and an inner arc shape is defined as a shape that is concave inwardly, the outer arc shape including an arc, an ellipse, a high-order function arc, or any other arc) strip structure 124, the third resonance peak of the vibration component 100 with a relatively large 3dB bandwidth may be obtained, which is applicable to scenarios requiring a low Q value and a wide bandwidth. In some embodiments, by designing the trapezoidal, rectangular, or an inner arc-shaped (an outer arc shape is defined as a shape that protrudes outwardly and an inner arc shape is defined as a shape that is concave inwardly, the inner arc shape including an arc, an ellipse, a high-order function arc, or any other arc) strip structures 124, the third resonance peak of the vibration component 100 with high sensitivity and a small 3dB bandwidth may be obtained, which is applicable to scenarios requiring a high Q value and a local high sensitivity.

By designing the one or more strip structures 124 with different horizontal widths, the area of no less than one suspension region of the central region 112 corresponding to the reinforcing member 120 may also be adjusted, so that each equivalent mass $Mm_i$, equivalent stiffness $Ka_i$ and $Ka_i'$, and equivalent damping $Ra_i$ and $Ra_i'$ may change. Furthermore, the position of the fourth resonance peak of the vibration component 100 may change.

Therefore, by designing the one or more strip structures 124 with different horizontal widths, the position of the third resonance peak frequency of the vibration component 100, the 3dB bandwidth at the resonance peak, the sensitivity of the vibration component 100 at the resonance peak, and the position of the fourth resonance peak of the vibration component 100 may be adjusted.

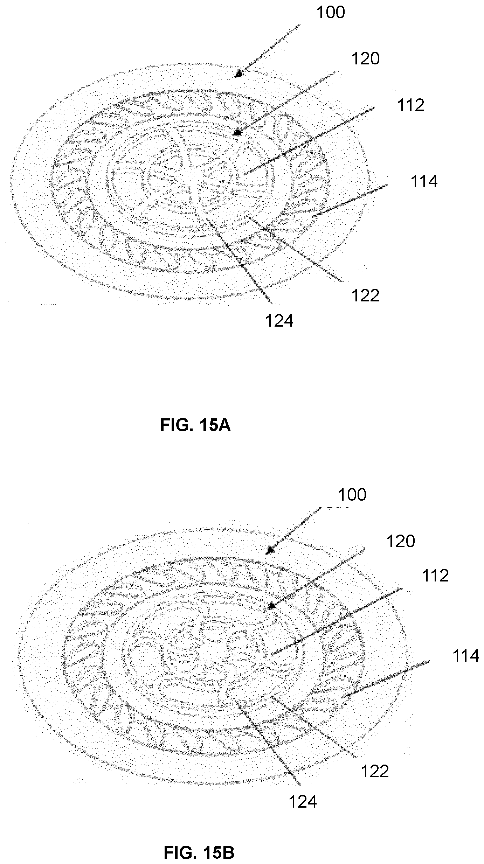

As illustrated in FIG. 15A and FIG. 15B, FIG. 15A and FIG. 15B are schematic structural diagrams illustrating vibration components including strip structures of different shapes according to some embodiments of the present disclosure. The one or more strip structures 124 in FIG. 15A may be spiral. The one or more strip structures 124 in FIG. 15B may be S-shaped. In some embodiments, by designing the one or more strip structures 124 with different horizontal shapes, the stiffness of the reinforcing member 120 may be adjusted, so that a stiffness $Kt_1$ provided by the reinforcing member 120 and the elastic element 110 (especially a portion of the central region 112 covered by the reinforcing member 120) to the system may change, which in turn causes a resonance frequency of a flipping motion of a mass Mti-spring $Kt_1$ - damping $Rt_1$ system to change, thereby causing a position of the third resonance peak of the vibration component 100 to change. In some embodiments, an area of no less than one suspension region of the central region 112 corresponding to the reinforcing member may also be adjusted, so that each equivalent mass $Mm_i$, equivalent stiffnesses $Ka_i$ and $Ka_i'$, and equivalent damping $Ra_i$ and $Ra_i'$ may change, and the position of the fourth resonance peak of the vibration component 100 may change. In some embodiments, by designing the one or more strip structures 124 with different horizontal shapes, a stress distribution inside the reinforcing member 120 may also be adjusted, and a processing deformation of the reinforcing member 120 may be controlled.

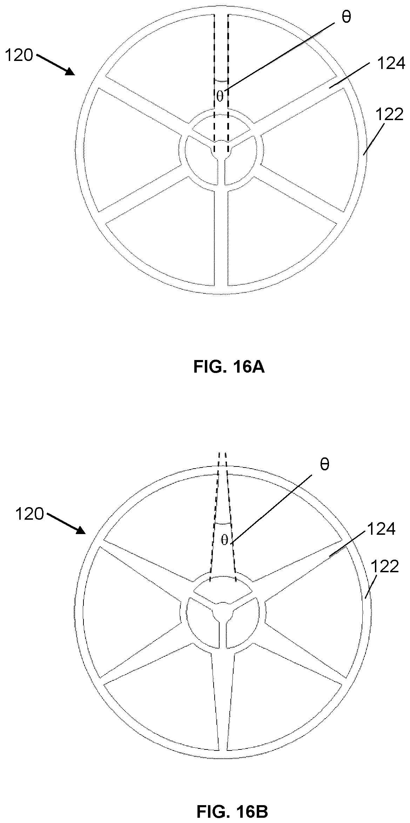

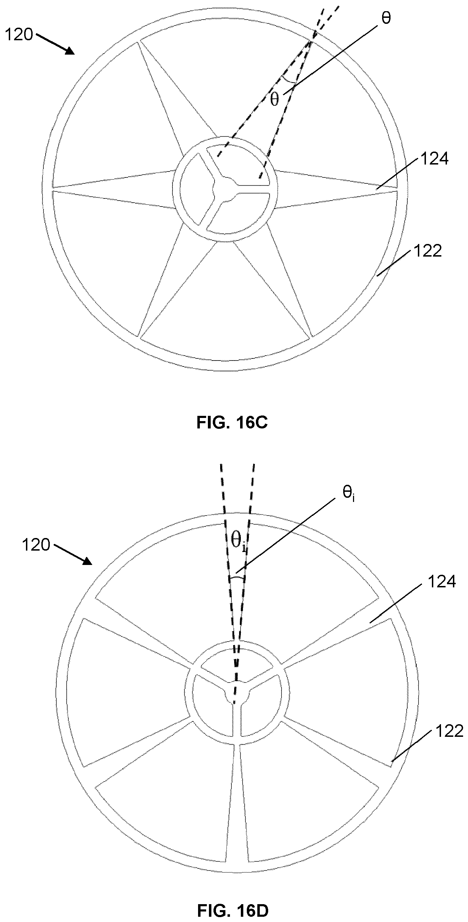

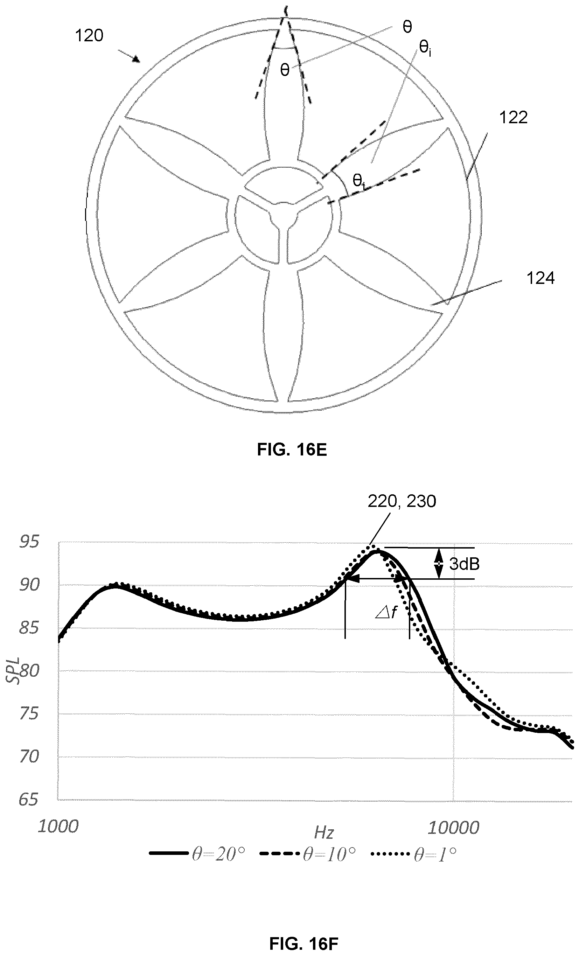

As illustrated in FIG. 16A- FIG. 16E, FIG. 16A- FIG. 16E are schematic structural diagrams illustrating reinforcing members including strip structures of different shapes according to some embodiments of the present disclosure. In some embodiments, in order to accurately adjust the influence of the one or more strip structures of different shapes on resonance peaks (e.g., a first resonance peak, a third resonance peak, and a fourth resonance peak) of the vibration component, for the one or more strip structures 124 with widths gradually decreases from the center to the periphery, an angle θ is defined as an angle between two sides of a shape of a projection of a strip structure on a projection plane perpendicular to a vibration direction. The resonance peak may be adjusted by setting a value of θ. In some embodiments, for the strip structure 124 (as illustrated in FIG. 16A- FIG. 16C) with straight sides, the angle θ is an angle between the two sides of the strip structure. In some embodiments, for the strip structure 124 (as illustrated in FIG. 16E) with curved sides, the angle θ is an angle between tangent lines of the two sides of the strip structure 124. In some embodiments, in order to accurately adjust the influence of the one or more strip structures of different shapes on the resonance peaks (e.g., the first resonance peak, the third resonance peak, and the fourth resonance peak) of the vibration component, as illustrated in FIG. 16D, for a strip structure of which a width gradually increases from the center to the periphery, an angle is defined as $\theta_i$. The resonance peak of the vibration component may be adjusted by setting a value of $\theta_i$. In some embodiments, for the strip structure 124 with straight sides, the angle $\theta_i$ is an angle between the two sides of the strip structure. In some embodiments, for the strip structure 124 with curved sides, the angle $\theta_i$ is an angle between tangent lines of the two sides of the strip structure.

In some embodiments, by designing the angle θ (or $\theta_i$) of the strip structure 124, the stiffness of the reinforcing member 120 may be changed without changing or changing the mass of the reinforcing member 120, so that the stiffness $Kt_1$ provided to the system by the reinforcing member 120 and the elastic element 110 may change, which further causes a resonance frequency of a flipping motion of the mass Mti-spring Kti-damping $Rt_1$ system to change, thereby causing a position of the third resonance peak of the vibration component 100 to change. Meanwhile, a 3dB bandwidth of the third resonance peak of the vibration component 100 may also be controlled. In some embodiments, the 3dB bandwidth of the third resonance peak of the vibration component 100 may be effectively increased by increasing the angle θ (or $\theta_i$) of the one or more strip structures 124.

For a frequency response of the vibration component 100 requiring a low Q value and a wide bandwidth, a relatively large angle θ (or $\theta_i$) of the strip structure 124 may be designed. In some embodiments, the angle θ of the strip structure 124 may be within a range of 0-150°. In some embodiments, the angle θ of the strip structure 124 may be within a range of 0-120°. In some embodiments, the angle θ of the strip structure 124 may be within a range of 0-90°. In some embodiments, the angle θ of the strip structure 124 may be within a range of 0-80°. In some embodiments, the angle θ of the strip structure 124 may be within a range of 0-60°. In some embodiments, the angle $\theta_i$ of the strip structure 124 may be within a range of 0-90°. In some embodiments, the angle $\theta_i$ of the strip structure 124 may be within a range of 0-80°. In some embodiments, the angle $\theta_i$ of the strip structure 124 may be within a range of 0-70°. In some embodiments, the angle $\theta_i$ of the strip structure 124 may be within a range of 0-60°. In some embodiments, the angle $\theta_i$ of the strip structure 124 may be within a range of 0-45°.

For a frequency response of the vibration component 100 requiring a high Q value and a narrow bandwidth, a relatively small angle θ (or $\theta_i$) of the strip structure 124 may be designed. In some embodiments, the angle θ of the strip structure 124 may be within a range of 0-90°. In some embodiments, the angle θ of the strip structure 124 may be within a range of 0-80°. In some embodiments, the angle θ of the strip structure 124 may be within a range of 0-70°. In some embodiments, the angle θ of the strip structure 124 may be within a range of 0-60°. In some embodiments, the angle θ of the strip structure 124 may be within a range of 0-45°. In some embodiments, the angle $\theta_i$ of the strip structure 124 may be within a range of 0-60°. In some embodiments, the angle $\theta_i$ of the strip structure 124 may be within a range of 0-80°. In some embodiments, the angle $\theta_i$ of the strip structure 124 may be within a range of 0-90°. In some embodiments, the angle $\theta_i$ of the strip structure 124 may be within a range of 0-120°. In some embodiments, the angle $\theta_i$ of the strip structure 124 may be within a range of 0-150°.

In some embodiments, a relationship between θ and $\theta_i$ is defined as:

$$\theta = -\theta_i. \quad \text{(Equation 7)}$$

For a frequency response of a loudspeaker requiring a low Q value and a wide bandwidth, a relatively large angle θ of the strip structure 124 may be designed. In some embodiments, the angle θ of the strip structure 124 may be within a range of -90°-150°. In some embodiments, the angle θ of the strip structure 124 may be within a range of -45°-90°. In some embodiments, the angle θ of the strip structure 124 may be within a range of 0°-60°.

For a frequency response of a loudspeaker requiring a high Q value and a narrow bandwidth, a relatively small angle θ of the strip structure 124 may be designed. In some embodiments, the angle θ of the strip structure 124 may be within a range of - 150°-90°. In some embodiments, the angle θ of the strip structure 124 may be within a range of -90°-45°. In some embodiments, the angle θ of the strip structure 124 may be within a range of -60°-0°.

In some embodiments, for some irregularly shaped strip structures 124, it is impossible to design the angle of the strip structures 124. In this case, an area of the strip structure 124 may be adjusted. A stiffness of the reinforcing member may be changed without changing or by changing a mass of the reinforcing member, so that the stiffness $Kt_1$ provided to the system by the reinforcing member 120 and the elastic element 110 may change, further causing a resonance frequency of a flipping motion of the mass Mti-spring Kti-damping $Rt_1$ system to change, thereby causing the position of the third resonance peak of the vibration component 100 to change. Furthermore, a 3dB bandwidth of the third resonance peak of the vibration component 100 may also be controlled.

FIG. 16F is a schematic diagram illustrating frequency response curves of vibration components according to some embodiments of the present disclosure. By structural design of the vibration component, the second resonance peak 220 and the third resonance peak 230 of the vibration component may be merged, so that the frequency response curve of the vibration component may only reflect two resonance peaks. FIG. 16F illustrates the frequency response curves of the vibration components when the angle θ of the strip structure 124 is 20°, 10°, and 1°, respectively. As illustrated in FIG. 16F, as the angle θ increases, a 3dB bandwidth of a medium and high-frequency resonance peak (e.g., a resonance peak obtained after the second resonance peak 220 and the third resonance peak 230 are merged) of the vibration component gradually increases. Accordingly, by adjusting the value of the angle θ of the strip structure 124, the 3dB bandwidth of medium and high-frequency resonance peaks of the vibration component may be adjusted. In some embodiments, by setting the angle θ of the strip structure 124 to be within a range of -60°- 60°, the 3dB bandwidth of at least one medium and high-frequency resonance peak of the vibration component may not be less than 1000 Hz.

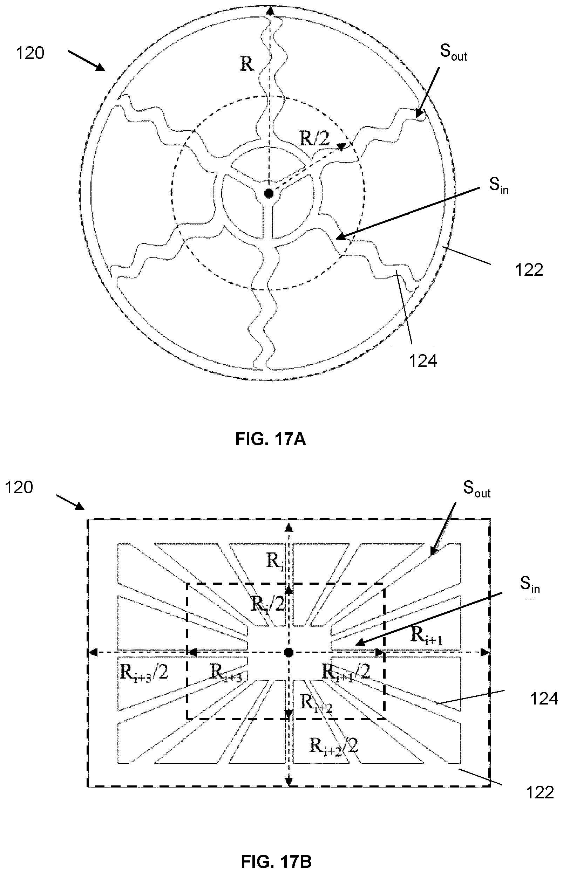

As illustrated in FIG. 17A- FIG. 17B, FIG. 17A- FIG. 17B are schematic structural diagrams illustrating reinforcing members including irregular strip structures according to some embodiments of the present disclosure. In some embodiments, in order to accurately design the irregular strip structures to adjust a resonance peak of the vibration component, as illustrated in FIG. 17A, a maximum contour of the reinforcing member 120 is defined as a circle with a radius R, and 1/2 of the radius R of the circle defined by the maximum contour is defined as a radius R/2. An area of a horizontal projection of the reinforcing member 120 within a range of radius R/2 is defined as $S_{in}$, and an area of a horizontal projection (i.e. a projection in a vibration direction of the vibration component) of the reinforcing member 120 within a range between the circle with the radius R/2 and the circle with the radius R is defined as $S_{out}$. A physical quantity τ is defined as a ratio of the area $S_{out}$ of the horizontal projection of the reinforcing member 120 to the area $S_{in}$ of the horizontal projection of the reinforcing member 120:

$$\tau = \frac{S_{out}}{S_{in}}.$$

In some embodiments, a mass distribution of the reinforcing member 120 may be controlled by adjusting the ratio τ of the area $S_{out}$ of the horizontal projection of the reinforcing member 120 to the area $S_{in}$ of the horizontal projection of the reinforcing member 120, thereby controlling the bandwidth of the third resonance peak of the vibration component 100. For other types of regular reinforcing members 120, as illustrated in FIG. 17B, such as an ellipse, a rectangle, a square, and other polygonal structures, the maximum contour of reinforcing member 120 may be enveloped with a graphic similar to the reinforcing member 120, and the central region of the graphic is defined as a reference point. A distance from the reference point to each point on a contour envelope line is R (e.g., $R_i$, ..., $R_{i+3}$). In the region formed by all points corresponding to R/2 (e.g., $R_i/2$, ..., $R_{i+3}/2$), the area of the horizontal projection of the reinforcing member 120 is $S_{in}$, and in a region formed between the distance R/2 and the distance R, the area of the horizontal projection of the reinforcing member 120 is $S_{out}$. For other irregular reinforcing members 120, the reinforcing member may be enveloped with a regular graphic of a structure similar to the maximum contour of the reinforcing member, and $S_{in}$, $S_{out}$, and the ratio τ may be defined similarly as above.

For frequency responses of some vibration components 100 requiring a low Q value and a wide bandwidth, a relatively large mass may be designed to be concentrated in the central region of the reinforcing member 120. In some embodiments, the ratio τ of the horizontal projection area $S_{out}$ to the horizontal projection area $S_{in}$ may be within a range of 0.3-2. In some embodiments, the ratio τ of the horizontal projection area $S_{out}$ to the horizontal projection area $S_{in}$ may be within a range of 0.5-1.5. In some embodiments, the ratio τ of the horizontal projection area $S_{out}$ to the horizontal projection area $S_{in}$ may be within a range of 0.5-1.2. In some embodiments, the ratio τ of the horizontal projection area $S_{out}$ to the horizontal projection area $S_{in}$ may be within a range of 0.5-1.3. In some embodiments, the ratio τ of the horizontal projection area $S_{out}$ to the horizontal projection area $S_{in}$ may be within a range of 0.5-1.4. In some embodiments, the ratio τ of the horizontal projection area $S_{out}$ to the horizontal projection area $S_{in}$ may be within a range of 0.3-1.2. In some embodiments, the ratio τ of the horizontal projection area $S_{out}$ to the horizontal projection area $S_{in}$ may be within a range of 0.3-1.6. In some embodiments, the ratio τ of the horizontal projection area $S_{out}$ to the horizontal projection area $S_{in}$ may be within a range of 0.5-2. In some embodiments, the ratio τ of the horizontal projection area $S_{out}$ to the horizontal projection area $S_{in}$ may be within a range of 0.5-2.2. In some embodiments, the ratio τ of the horizontal projection area $S_{out}$ to the horizontal projection area $S_{in}$ may be within a range of 0.3-2.2. In some embodiments, the ratio τ of the horizontal projection area $S_{out}$ to the horizontal projection area $S_{in}$ may be within a range of 0.3-2.

For frequency responses of some vibration components 100 requiring a high Q value and a narrow bandwidth, a relatively large mass may be designed to be concentrated in a peripheral region of the reinforcing member 120. In some embodiments, the ratio τ of the horizontal projection area $S_{out}$ to the horizontal projection area $S_{in}$ may be within a range of 1-3. In some embodiments, the ratio τ of the horizontal projection area $S_{out}$ to the horizontal projection area $S_{in}$ may be within a range of 1.2-2.8. In some embodiments, the ratio τ of the horizontal projection area $S_{out}$ to the horizontal projection area $S_{in}$ may be within a range of 1.4 -2.6. In some embodiments, the ratio τ of the horizontal projection area $S_{out}$ to the horizontal projection area $S_{in}$ may be within a range of 1.6-2.4. In some embodiments, the ratio $\tau$ of the horizontal projection area $S_{out}$ to the horizontal projection area $S_{in}$ may be within a range of 1.8-2.2. In some embodiments, the ratio $\tau$ of the horizontal projection area $S_{out}$ to the horizontal projection area $S_{in}$ may be within a range of 1.2-2. In some embodiments, the ratio $\tau$ of the horizontal projection area $S_{out}$ to the horizontal projection area $S_{in}$ may be within a range of 1-2. In some embodiments, the ratio $\tau$ of the horizontal projection area $S_{out}$ to the horizontal projection area $S_{in}$ may be within a range of 2-2.8. In some embodiments, the ratio $\tau$ of the horizontal projection area $S_{out}$ to the horizontal projection area $S_{in}$ may be within a range of 2-2.5.

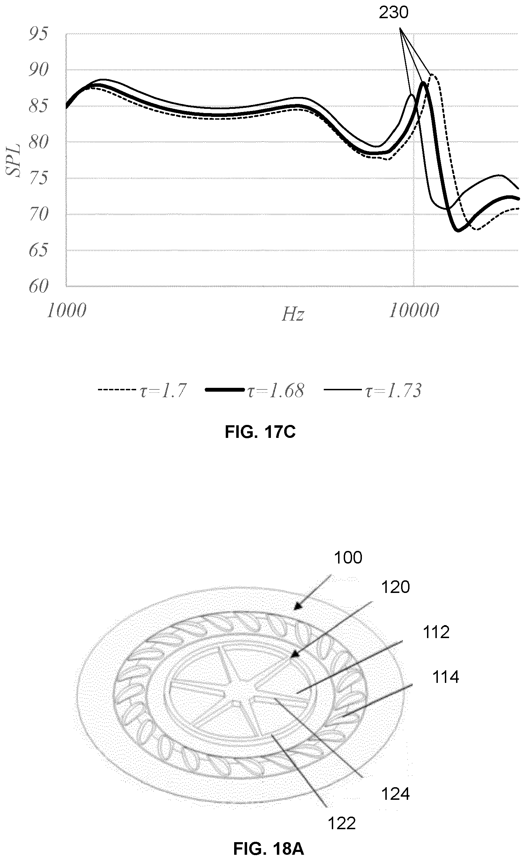

In some embodiments, by adjusting the ratio $\tau$ of the horizontal projection area $S_{out}$ to the horizontal projection area $S_{in}$, a resonance frequency of a flipping motion of the vibration component during vibration may also be changed, thereby causing a position of the third resonance peak to change. FIG. 17C is a schematic diagram illustrating frequency response curves of vibration components according to some embodiments of the present disclosure. As illustrated in FIG. 17C, FIG. 17C illustrates frequency response curves of the vibration components when values of $\tau$ are 1.68 and 1.73, respectively. The 3dB bandwidths of the two frequency response curves at the third resonance peak 230 are narrow. Furthermore, when the value of $\tau$ increases from 1.68 to 1.73, the third resonance peak 230 moves to low frequency. Accordingly, as the value of $\tau$ increases, a frequency corresponding to the third resonance peak 230 may decrease. By adjusting the value of $\tau$ of the vibration component, the bandwidth and the position of the third resonance peak may be effectively adjusted.

In some embodiments, areas of the hollow-out regions (corresponding to a suspension region of the central region 112 within a projection range of the reinforcing member 120) of the reinforcing member 120 may be changed by adjusting a count (e.g., within a range of 1-10) of the one or more ring structures 122, such that a relationship (the area-thickness ratio $\mu$) between the area of each of the one or more hollow-out regions and a thickness of the elastic element 110 may be adjusted, so as to adjust the fourth resonance peak. A relationship (the ratio $\gamma$ of the areas of the one or more hollowed regions) between the areas of the hollow-out regions of different ring structures 122 of the reinforcing member 120 may be changed to adjust the fourth resonance peak. A relationship (the ratio $\beta$ of the horizontal area of the reinforcing portion of the reinforcing member 120 to the horizontal area of the reinforcing member) between a horizontal area of a reinforcing portion of the reinforcing member 120 and a horizontal area of the reinforcing member 120 may also be changed to adjust the first resonance peak, the third resonance peak, and the fourth resonance peak.

In some embodiments, the one or more ring structures 122 may include a first ring structure and a second ring structure of which centroids coincide with each other, in which case a radial dimension of the first ring structure may be less than a radial dimension of the second ring structure. In some embodiments, the one or more strip structures 124 may also include at least one first strip structure and at least one second strip structure. The at least one first strip structure may be disposed at an inner side the first ring structure and connected with the first ring structure. The at least one second strip structure may be disposed between the first ring structure and the second ring structure and connected with the first ring structure and the second ring structure, respectively, so that the reinforcing member 120 may form a plurality of different hollow-out regions.

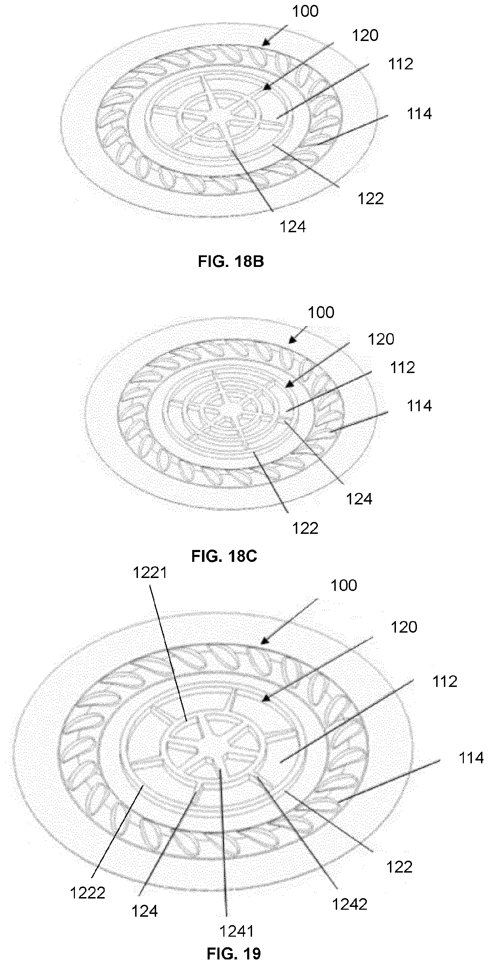

As illustrated in FIG. 18A- FIG. 18C, FIG. 18A-FIG. 18C are schematic structural diagrams illustrating vibration components including different counts of ring structures according to some embodiments of the present disclosure. The ring structure 122 in FIG. 18A may be a single-ring structure. The ring structure 122 in FIG. 18B may be a double-ring structure. The ring structure 122 in FIG. 18C may be a three-ring structure. By designing the count of the one or more ring structures 122, the mass and stiffness of the reinforcing member 120 may be adjusted, and areas of one or more hollow-out regions of the central region 112 may be adjusted. In some embodiments, the count of the one or more ring structures 122 may be within a range of 1-10. In some embodiments, the count of the one or more ring structures 122 may be within a range of 1-5. In some embodiments, the count of the one or more ring structures 122 may be within a range of 1-3.

In some embodiments, by adjusting the count of the one or more ring structures 122, the mass of the reinforcing member 120 may be adjusted, so that a total equivalent mass Mt formed by the combination of the mass of the reinforcing member 120, a mass of the elastic element 110, an equivalent air mass, and a driving end equivalent mass may change, and a resonance frequency of a mass Mt-spring Kt-damping Rt system may change, thereby causing a first-order resonance frequency of the vibration component 100 to change.

In some embodiments, by adjusting the count of the one or more ring structures 122, the stiffness of the reinforcing member 120 may also be adjusted, so that the stiffness $Kt_1$ provided to the system by the reinforcing member 120 and the elastic element 110 (especially a portion of the central region 112 covered by the reinforcing member 120) may change, which further causes a resonance frequency of a flipping motion of the mass $Mt_1$-spring $Kt_1$-damping $Rt_1$ system to change, thereby causing a position of the third resonance peak of the vibration component 100 to change. In some embodiments, by adjusting the count of the one or more ring structures 122, a stiffness distribution of the one or more strip structures 124 extending to different positions from the center to the periphery may be different. When a driving end frequency is close to the resonance frequency of the mass $Mt_1$-spring $Kt_1$-damping $Rt_1$ system, the connection region 115, the folded ring region 114, and a local suspension region disposed between the portion of the central region 112 covered by the reinforcing member 120 and the folded ring region may be driven by the reinforcing member 120 to vibrate, thereby obtaining a resonance peak with an adjustable 3dB bandwidth.

In some embodiments, by adjusting the count of the one or more ring structures 122, the areas of the one or more hollow-out regions of the central region 112 may also be adjusted, so that an equivalent mass $Mm_i$, equivalent stiffnesses $Ka_i$ and $Ka_i'$, and equivalent damping $Ra_i$ and $Ra_i'$ of each of the one or more hollow-out regions may change, so that the position of the fourth resonance peak of the vibration component 100 may change.

In some embodiments, by adjusting the count of the one or more ring structures 122, a dimension of an outermost ring structure 122 may also be adjusted, and an area of a local hollow-out region between a portion of the central region 112 covered by the reinforcing member 120 and the folded ring region 114 may be adjusted. The local hollow-out region, the connection region 115, and the folded ring region 114 may form an equivalent mass Ms, an equivalent stiffness Ks, and equivalent damping Rs. By adjusting an area of a local suspension region between the portion of the central region 112 covered by the reinforcing member 120 and the folded ring region 114, a resonance frequency of the mass Ms-spring Ks-damping Rs system may be changed, thereby adjusting the position of the second resonance peak of the vibration component 100.

In some embodiments, by adjusting the count of the one or more ring structures 122, the fourth resonance peak of the vibration component 100 may be located within a range of 10 kHz-18 kHz. An area-thickness ratio $\mu$ of an area $S_i$ of each of the one or more hollow-out regions to a thickness $H_i$ of a diaphragm of each of the one or more hollow-out regions may be within a range of 150 mm-700 mm. A ratio $\gamma$ of an area $S_{ki}$ to an area $S_{ji}$ of any two hollow-out regions of the elastic element 110 may be within a range of 0.25-4. A ratio $\beta$ of a horizontal area of the reinforcing portion of the reinforcing member 120 to a horizontal area of the reinforcing member 120 may be within a range of 0.2- 0.7. In some embodiments, by adjusting the count of the one or more ring structures 122, the fourth resonance peak of the vibration component 100 may be located within the range of 10 kHz-18 kHz. The area-thickness ratio $\mu$ of the area $S_i$ of each of the one or more hollow-out regions to the thickness $H_i$ of the diaphragm of each of the one or more hollow-out regions may be within a range of 100 mm-1000 mm. The ratio $\gamma$ of the area $S_{ki}$ to the area $S_{ji}$ of any two hollow-out regions of the elastic element 110 may be within a range of 0.1-10. The ratio $\beta$ of the horizontal area of the reinforcing portion of the reinforcing member 120 to the horizontal area of the reinforcing member 120 may be within a range of 0.1-0.8.

As illustrated in FIG. 19, FIG. 19 is a schematic structural diagram illustrating a vibration component including discontinuous strip structures corresponding to an inner ring structure and an outer ring structure according to some embodiments of the present disclosure. In some embodiments, when the vibration component 100 includes at least two ring structures, at least two ring structures 122 may divide one or more strip structures into a plurality of regions along a direction extending from the center to the periphery. The strip structures 124 in each region may be arranged continuously or discontinuously. In some embodiments, the one or more ring structures 122 of the vibration component 100 may include at least a first ring structure 1221. For example, the one or more ring structures 122 may include the first ring structure 1221 and a second ring structure 1222 of which centroids coincide with each other, and a radial dimension of the first ring structure 1221 may be less than a radial dimension of the second ring structure 1222. In some embodiments, the one or more strip structures 124 may include at least one first strip structure 1241 and at least one second strip structure 1242. Any one of the at least one first strip structure 1241 may be disposed at a first position of an inner side of the first ring structure 1221 and connected with the first ring structure 1221. Any one of the at least one second strip structure 1242 may be connected with an outer side of the first ring structure 1221 at a second position. A plurality of first strip structures 1241 may be connected to a plurality of first positions, and a plurality of second strip structures 1242 may be connected to a plurality of second positions. In some embodiments, a connection line between at least one of the plurality of first positions and a center of the first ring structure 1221 may not pass through any one of the plurality of second positions. In some embodiments, a connection line between at least one of the plurality of second positions and the center of the first ring structure 1221 may not pass through any one of the plurality of first positions. In some embodiments, the plurality of first positions and the plurality of second positions may be different, i.e., the plurality of first positions, the plurality of second positions, and the center of the first ring structure 1221 may not be collinear, and the plurality of first strip structures 1241 and the plurality of second strip structures 1242 may be connected with the first ring structure 1221 at different positions. In some embodiments, a count of the plurality of first strip structures 1241 and a count of the plurality of second strip structures 1242 may be the same or different.

Through the discontinuous arrangement of the one or more strip structures 124 in the inner and outer regions of the one or more ring structures 122, the counts of the one or more strip structures 124 in the inner and outer regions of the one or more ring structures 122 may be different, horizontal widths of the one or more strip structures 124 in the inner and outer regions of the one or more ring structures 122 may be different, and horizontal shapes of the one or more strip structures 124 in the inner and outer regions of the one or more ring structures 122 may be different, so that the mass, the stiffness, and the centroid distribution of the reinforcing member 120, the count and the areas of the one or more hollow-out regions of the central region 112 may be adjusted within a relatively large range.

In some embodiments, by adjusting the mass of the reinforcing member 120, the total equivalent mass Mt may be controlled to change, so that a resonance frequency of a mass Mt-spring Kt-damping Rt system may change, thereby causing a first-order resonance frequency of the vibration component 100 to change. By adjusting the stiffness of the reinforcing member 120, a resonance frequency of a flipping motion of a $Mt_1$-spring $Kt_1$-damping $Rt_1$ system may be adjusted, thereby causing the position of the third resonance peak of the vibration component 100 to change, making a stiffness distribution of the one or more strip structures 124 extending to different positions from the center to the periphery different, and realizing an adjustable resonance peak with a 3dB bandwidth of the vibration component 100. By adjusting the count and the areas of the one or more hollow-out regions of the central region 112, the position and sensitivity of the fourth resonance peak of the vibration component 100 may be changed.

In some embodiments, the one or more strip structures 124 in the inner and outer regions of the one or more ring structures 122 may be arranged discontinuously, so that the fourth resonance peak of the vibration component 100 may be located within a range of 10 kHz-18 kHz, an area-thickness ratio $\mu$ of an area Si of each of the one or more hollow-out regions to a thickness $H_i$ of the elastic element 110 of each of the one or more hollow-out regions may be within a range of 150 mm-700 mm, a ratio $\gamma$ of an area $S_{ki}$ to an area $S_{ji}$ of any two hollow-out regions of the elastic element 110 may be within a range of 0.25-4, and a ratio $\beta$ of a horizontal area of the reinforcing portion of the reinforcing member 120 to a horizontal area of the reinforcing member 120 may be within a range of 0.2- 0.7. In some embodiments, the one or more strip structures 124 in the inner and outer regions of the one or more ring structures 122 may be arranged discontinuously, so that the fourth resonance peak of the vibration component 100 may be located within the range of 10 kHz-18 kHz, the area-thickness ratio $\mu$ of the area Si of each of the one or more hollow-out regions to the thickness $H_i$ of the diaphragm of each of the one or more hollow-out regions may be within a range of 100 mm-1000 mm, the ratio $\gamma$ of the area $S_{ki}$ to the area $S_{ji}$ of any two hollow-out regions of the elastic element 110 may be within a range of 0.1-10, and the ratio $\beta$ of the horizontal area of the reinforcing portion of the reinforcing member 120 to the horizontal area of the reinforcing member 120 may be within a range of 0.1- 0.8.

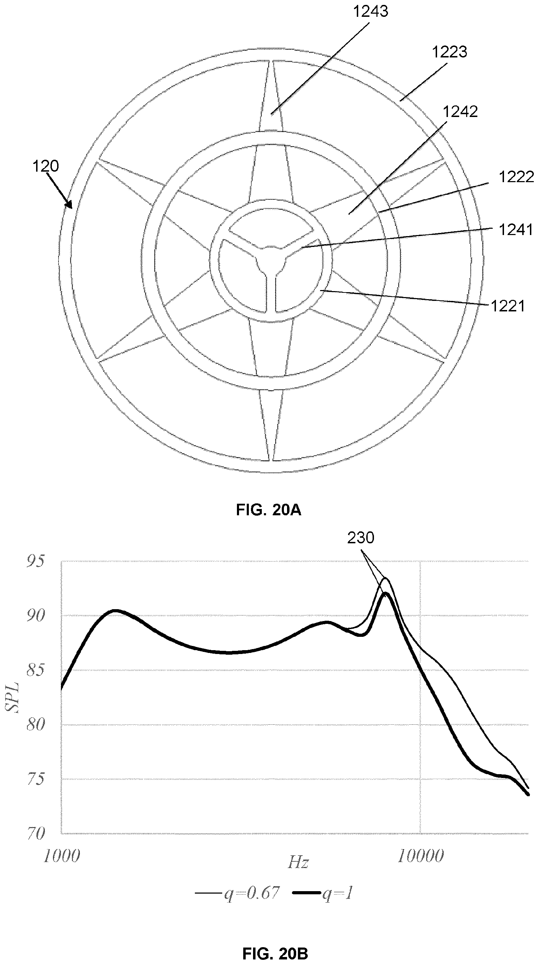

As illustrated in FIG. 20A, FIG. 20 A is a schematic structural diagram illustrating a vibration component including one or more ring structures according to some embodiments of the present disclosure. In some embodiments, spacing regions of the one or more ring structures 122 may be designed by designing the one or more ring structures 122. A mass distribution of the reinforcing member 120 may be adjusted by designing a count of the one or more strip structures 124 in different spacing regions. It should be noted that the count, shapes, and positions of the one or more strip structures 124 designed in the spacing regions of the one or more ring structure 122 may be different.

In some embodiments, the one or more ring structures 122 from the center outward may be defined as the first ring structure 1221, the second ring structure 1222, a third ring structure 1223, ..., an nth ring structure. A strip structure 124 in a spacing region between the nth ring structure and an n-1 th ring structure may be an nth strip structure (e.g., the first strip structure 1241, the second strip structure 1242, and a third strip structure 1243). A count of the nth strip structures (i.e., the strip structures connected to an inner side of the nth ring structure) is defined as $Q_n$, wherein n is a natural number. A physical quantity q is defined as a ratio of a count $Q_i$ of ith strip structures to a count $Q_j$ of jth strip structures:

$$q = \frac{Q_i}{Q_j}. \quad \text{(Equation 8)}$$

In some embodiments, the ratio q of the count $Q_i$ of the ith strip structures to the count $Q_j$ of the jth strip structures may be within a range of 0.05-20. In some embodiments, the ratio q of the count $Q_i$ of the ith strip structures to the count $Q_j$ of the jth strip structures may be within a range of 0.1-10. In some embodiments, the ratio q of the count $Q_i$ of the ith strip structures to the count $Q_j$ of the jth strip structures may be within a range of 0.1-8. In some embodiments, the ratio q of the count $Q_i$ of the ith strip structures to the count $Q_j$ of the jth strip structures may be within a range of 0.1-6. In some embodiments, the ratio q of the count $Q_i$ of the ith strip structures to the count $Q_j$ of the jth strip structures may be within a range of 0.2-5. In some embodiments, the ratio q of the count $Q_i$ of the ith strip structures to the count $Q_j$ of the jth strip structures may be within a range of 0.3-4. In some embodiments, the ratio q of the count $Q_i$ of the ith strip structures to the count $Q_j$ of the jth strip structures may be within a range of 0.5-6. In some embodiments, the ratio q of the count $Q_i$ of the ith strip structures to the count $Q_j$ of the jth strip structures may be within a range of 1-4. In some embodiments, the ratio q of the count $Q_i$ of the ith strip structures to the count $Q_j$ of the jth strip structures may be within a range of 1-2. In some embodiments, the ratio q of the count $Q_i$ of the ith strip structures to the count $Q_j$ of the jth strip structures may be within a range of 0.5-2.

In some embodiments, the spacing regions of the one or more ring structures 122 may be designed by designing the one or more ring structures 122, and the mass distribution of the reinforcing member 120 may be achieved by designing the count of the one or more strip structures 124 in different spacing regions, so that under the condition that the mass of the reinforcing member 120 is constant or changes, the equivalent stiffness $Kt_1$ of the reinforcing member 120 and the diaphragm may be changed by changing the stiffness of the reinforcing member 120, further the resonance frequency of the flipping motion of the mass $Mt_1$-spring $Kt_1$-$Rt_1$ system may change, thereby causing the position of the third resonance peak of the loudspeaker to change.

FIG. 20B is a schematic diagram illustrating frequency response curves of vibration components according to some embodiments of the present disclosure. Two frequency response curves illustrated in FIG. 20B are frequency response curves of the vibration components when q= 0.67 and q= 0.1, respectively. The frequencies of the third resonance peak 230 of the two frequency response curves are close to each other. However, the amplitude of the third resonance peak 230 of the frequency response curve corresponding to q= 0.67 is higher than the amplitude of the third resonance peak of the frequency response curve corresponding to q= 0.1. Accordingly, it can be seen from FIG. 20B that by adjusting the value of q, the amplitude of the third resonance peak may be controlled to change, thereby adjusting the sensitivity of the vibration component. In some embodiments, when the value of q is within a range of 0.2-5, the vibration component may have a relatively high sensitivity.

In some embodiments, the shapes of the one or more ring structures 122 may include at least one of a circular ring, an elliptical ring, a polygonal ring, and a curved ring. By designing the one or more ring structures 122 of different shapes and/or different dimensions, the quality and stiffness of the reinforcing member 120 may be adjusted, and areas of one or more hollow-out regions of the central region 112 may be adjusted.

In some embodiments, the dimension and shape of the suspension region 1121 may be adjusted by adjusting the dimension and shape of a portion of the central region 112 covered by the reinforcing member 120 and the dimension and shape of the reinforcing member 120. In some embodiments, a total area of the horizontal projections (i.e., a projection in a vibration direction of the vibration component) of the suspension region 1121 and the folded ring region 114 may be adjusted by adjusting an area and a shape of the folded ring region 114. The second resonance peak of the vibration component 100 may be accurately controlled to be located within a required frequency range by controlling the total area of the horizontal projections of the suspension region 1121 and the folded ring region 114, a thickness of the elastic element 110, a folded ring arch height and other data. In some embodiments, the second resonance peak of the vibration component 100 may be located within a range of 3000 Hz-7000 Hz. In some embodiments, a vibration displacement of a local region of the vibration component 100 in a second resonance peak frequency range may be adjusted by controlling a ratio of an area of the suspension region 1121 to an area of the folded ring region 114, thereby maximizing an output sensitivity of the vibration component 100 at the position of the second resonance peak.

In some embodiments, by adjusting a relationship among dimensions of the folded ring region 114 and the suspension region 1121 of the vibration component 100 and a thickness of the elastic element 110, a local equivalent mass Mms and a local equivalent mass $Mm_2$, a local regional stiffness $Ka_2$' and a local area stiffness $Ka_1$' may be controlled to ensure that the second resonance peak of the vibration component 100 is within the required frequency range. In some embodiments, by changing shapes of the one or more ring structures 122 and making a ratio $\alpha$ of $S_s$ to a thickness $H_i$ of a diaphragm be within a range of 5000 mm-12000 mm, the second resonance peak of the vibration component 100 may be located within a range of 3000 Hz-7000 Hz. In some embodiments, by changing the shapes of the one or more ring structures 122 and making the ratio $\alpha$ of $S_s$ to the thickness $H_i$ of the diaphragm be within a range of 6000 mm-10000 mm, the second resonance peak of the vibration component 100 may be located within the range of 3000 Hz-7000 Hz.

In some embodiments, based on a relationship among dimensions of the folded ring region 114 and the suspension region 1121 and a dimension of the folded ring arch height of the folded ring region 114, the folded ring arch height may be adjusted such that a three-dimensional dimension of the folded ring region 114 of the elastic element 110 may be changed without changing areas of horizontal projections of the folded ring region 114 and the suspension region 1121, thereby changing the stiffness $Ka_1$' of the folded ring region 114, and controlling the second resonance peak of the vibration component 100. In some embodiments, a ratio $\delta$ of $S_s$ to a folded ring arch height $\Delta h$ may be within a range of 50 mm-600 mm. In some embodiments, the ratio $\delta$ of $S_s$ to the folded ring arch height $\Delta h$ may be within a range of 100 mm to 500 mm. In some embodiments, the ratio $\delta$ of $S_s$ to the folded ring arch height $\Delta h$ may be within a range of 200 mm-400 mm.

In some embodiments, based on a relationship between the dimension of the suspension region 1121 and the area of the central region 112, the reinforcing member 120 may achieve a certain bending deformation in a specific frequency range, and sound pressures in different regions of the elastic element 110 may be increased by superposition to achieve a maximum sound pressure level output. In some embodiments, a ratio $\vartheta$ of an area $S_v$ of a horizontal projection of the suspension region 1121 to an area $S_c$ of a horizontal projection of a diaphragm center of the vibration component 100 may be within a range of 0.05-0.7. In some embodiments, the ratio $\vartheta$ of the area $S_v$ of the horizontal projection of the suspension region 1121 to the area $S_c$ of the horizontal projection of the diaphragm center of the vibration component 100 may be within a range of 0.1-0.5. In some embodiments, the ratio $\vartheta$ of the area $S_v$ of the horizontal

projection of the suspension region 1121 to the area $S_c$ of the horizontal projection of the diaphragm center of the vibration component 100 may be within a range of 0.15-0.35.

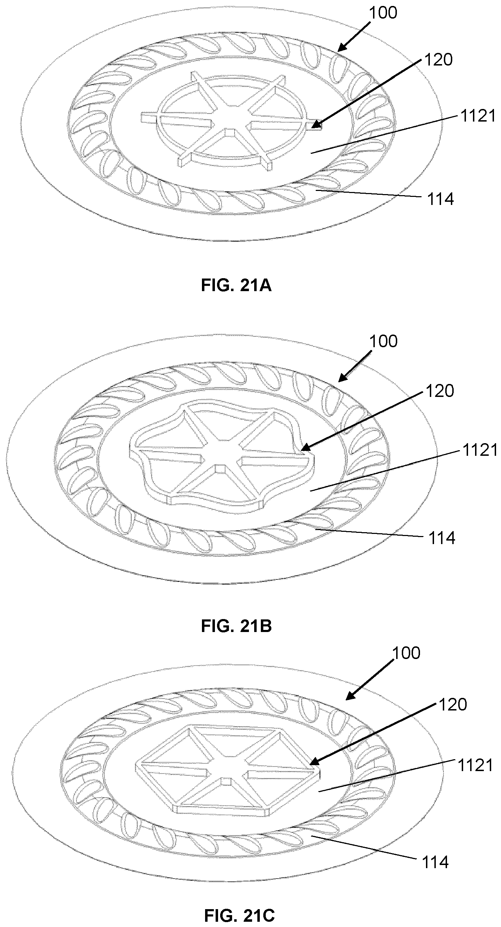

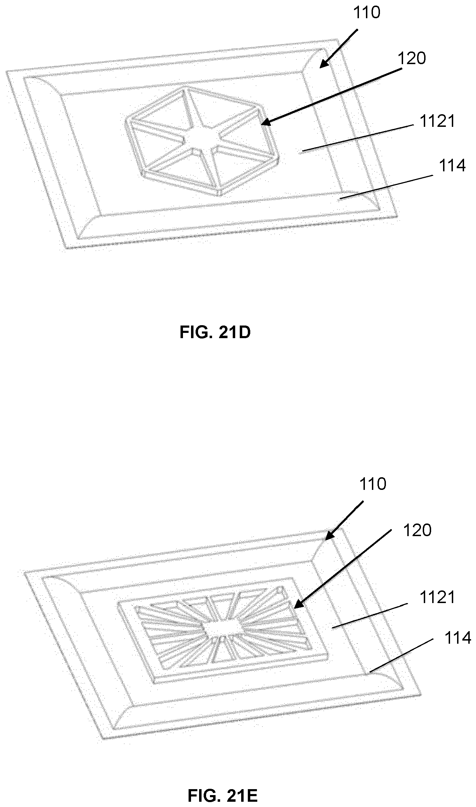

As illustrated in FIG. 21A- FIG. 21E, FIG. 21A-FIG. 21E are schematic structural diagrams illustrating vibration components with different structures according to some embodiments of the present disclosure. In some embodiments, an outer contour of the reinforcing member 120 may be a structure (as illustrated in FIG. 21A) including outwardly extending spokes, or may be a circular ring structure, an elliptical ring structure, or a curved ring structure (as illustrated in FIG. 21B), a polygon, other irregular ring structures, etc. The polygon may include a triangle, a quadrilateral, a pentagon, a hexagon (as illustrated in FIG. 21C- FIG. 21D), a heptagon, an octagon, a nonagon, a decagon, or the like. In some embodiments, the elastic element 110 may also be a polygon, such as a triangle, a quadrilateral (as illustrated in FIG. 21D and FIG. 21E), a pentagon, a hexagon, a heptagon, an octagon, a nonagon, a decagon, or the like, or other irregular shapes. The reinforcing member 120 may correspondingly be designed to have a similar or dissimilar structure, thereby controlling the shape of the suspension region 1121 through the reinforcing member 120, the central region 112, and a shape of a folded ring of the folded ring region 114, and then adjusting the performance of the vibration component 100.

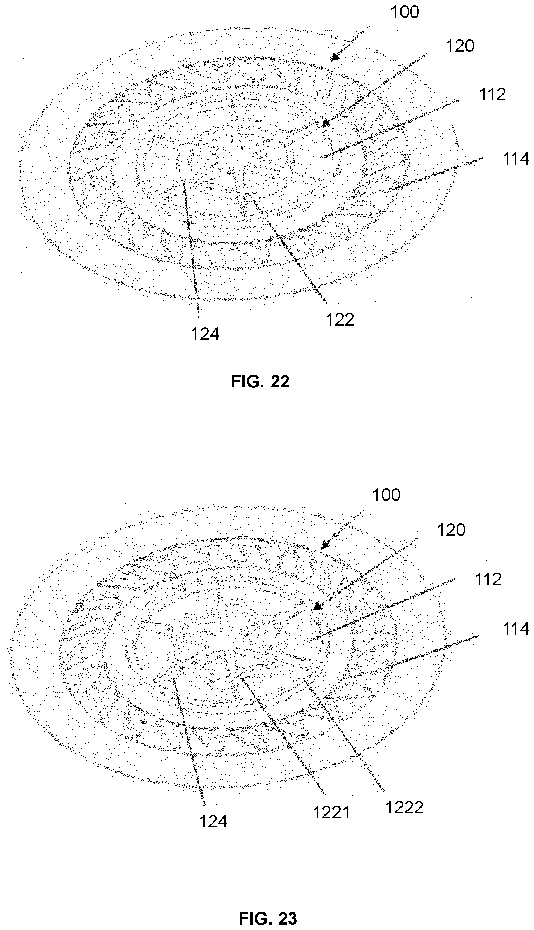

As illustrated in FIG. 22, FIG. 22 is a schematic structural diagram illustrating a vibration component including ring structures with variable width according to some embodiments of the present disclosure. In some embodiments, by designing local structures with unequal widths at different positions of any one of the one or more ring structures 122, a mass of the reinforcing members 120 may be effectively adjusted, and the total equivalent mass Mt may be adjusted, and thus a resonance frequency of the mass Mt-spring Kt-damping Rt system may change, thereby causing a first-order resonance frequency of the vibration component 100 to change. Meanwhile, by designing local structures with unequal widths at different positions (e.g., adjacent positions) of any one of the one or more ring structure 122, the stiffness and centroid distribution of the reinforcing member 120 may be adjusted, thereby adjusting a resonance frequency of a flipping motion of the Mt1-spring Kt1-damping Rt1 system, causing a third resonance peak of the vibration component 100 to change. The design of the one or more ring structures 122 with unequal widths may also make the stiffness distribution of the one or more strip structures 124 extending to different positions from the center to the periphery different, thereby obtaining the third resonance peak with an adjustable 3dB bandwidth of the vibration component 100. Furthermore, the design of the one or more ring structures 122 with unequal widths may also adjust the count and area of the suspension region of the central region 112, so that a position and a sensitivity of the fourth resonance peak of the vibration component 100 may be changed. For example, two sides of at least one of the one or more ring structures 122 at a connection position with any one of the one or more strip structures 124 may have different radial widths, as illustrated in FIG. 22. As another example, at least one of the one or more ring structures 122 may have different circumferential widths between connection positions of the at least one ring structure 122 with any two of the one or more strip structures 124.

In some embodiments, local structures with unequal widths may be designed at any position (e.g., adjacent positions) of any one of the one or more ring structures 122, so that the fourth resonance peak of the vibration component 100 may be located within a range of 15 kHz-18 kHz, an area-thickness ratio $\mu$ of an area $S_i$ of each of the one or more hollow-out regions to a thickness $H_i$ of a diaphragm of each of the one or more hollow-out regions may be within a range of 150 mm-700 mm, a ratio $\gamma$ of an area $S_{ki}$ to an area $S_{ji}$ of any two hollow-out regions of the elastic element 110 may be within a range of 0.25-4, and a ratio $\beta$ of a horizontal area of the reinforcing portion of the reinforcing member 120 to a horizontal area of the reinforcing member 120 may be within a range of 0.2- 0.7. In some embodiments, the local structures with unequal widths may be designed at any position of any one of the one or more ring structures 122, so that the fourth resonance peak of the vibration component 100 may be located within a range of 15 kHz-18 kHz, the area-thickness ratio $\mu$ of the area $S_i$ of each of the one or more hollow-out regions to the thickness $H_i$ of the diaphragm of each of the one or more hollow-out regions may be within a range of 100 mm-1000 mm, the ratio $\gamma$ of the area $S_{ki}$ to the area $S_{ji}$ of any two hollow-out regions of the elastic element 110 may be within a range of 0.1-10, and the ratio $\beta$ of the horizontal area of the reinforcing portion of the reinforcing member 120 to the horizontal area of the reinforcing member 120 may be within a range of 0.1- 0.8.

As illustrated in FIG. 23, FIG. 23 is a schematic structural diagram illustrating a vibration component including irregular ring structures according to some embodiments of the present disclosure. In some embodiments, by designing local structures at different positions of different ring structures 122, such as a circle, a rectangle, a square, a triangle, a hexagon, an octagon, another polygon, an ellipse, and other irregular ring structures 122, dimensions, positions, and shapes of local regions of the one or more ring structures 122 may be more flexibly controlled, a mass of the reinforcing member 120 may be effectively adjusted, and a total equivalent mass Mt may be controlled to change, so that a resonance frequency of a mass Mt-spring Kt-damping Rt system may change, thereby causing a first resonance frequency of the vibration component 100 to change. By adjusting the stiffness of the reinforcing member 120 and the centroid distribution of the reinforcing member 120, a resonance frequency of a flipping motion of a $Mt_1$-spring $Kt_1$-damping $Rt_1$ system may be adjusted, thereby changing a position of a third resonance peak of the vibration component 100, making a stiffness distribution of the one or more strip structures 124 extending to different positions from the center to the periphery different, and thus obtaining the third resonance peak with an adjustable 3dB bandwidth of the vibration component 100. Meanwhile, a count and an area of a suspension region of the central region 112 may be effectively adjusted, so that a position and sensitivity of a fourth resonance peak of the vibration component 100 may change. In addition, by designing the irregular structures, stress concentration may be effectively avoided, resulting in a smaller deformation of the reinforcing member 120.

In some embodiments, as illustrated in FIG. 23, the reinforcing member 120 may include a double-ring structure, which includes a first ring structure 1221 located at an inner side and a second ring structure 1222 located at an outer side. In some embodiments, the shape of the first ring structure 1221 and the shape of the second ring structure 1222 may be different. In some embodiments, the shape of the first ring structure 1221 may be a curved ring shape, and the shape of the second ring structure 1222 may be a circular ring shape. In some embodiments, by designing the irregular ring structures 122, the fourth resonance peak of the vibration component 100 may be located within the range of 10 kHz-18 kHz, the area-thickness ratio $\mu$ of the area $S_i$ of each of the one or more hollow-out regions to the thickness $H_i$ of the diaphragm of each of the one or more hollow-out regions may be within the range of 150 mm-700 mm, the ratio $\gamma$ of the area $S_{ki}$ to the area $S_{ji}$ of any two hollow-out regions of the elastic element 110 may be within a range of 0.25-4, and the ratio $\beta$ of the horizontal area of the reinforcing portion of the reinforcing member 120 to the horizontal area of the reinforcing member 120 may be within a range of 0.2- 0.7. In some embodiments, by designing the irregular ring structures 122, the fourth resonance peak of the vibration component 100 may be located within the range of 15 kHz-18 kHz, the area-thickness ratio $\mu$ of the area $S_i$ of each of the one or more hollow-out regions to the thickness $H_i$ of the diaphragm of each of the one or more hollow-out regions may be within a range of 100 mm-1000 mm, the ratio $\gamma$ of the area $S_{ki}$ to the area $S_{ji}$ of any two hollow-out regions of the elastic element 110 may be within a range of 0.1-10, and the ratio $\beta$ of the horizontal area of the reinforcing portion of the reinforcing member 120 to the horizontal area of the reinforcing member 120 may be within a range of 0.1- 0.8.

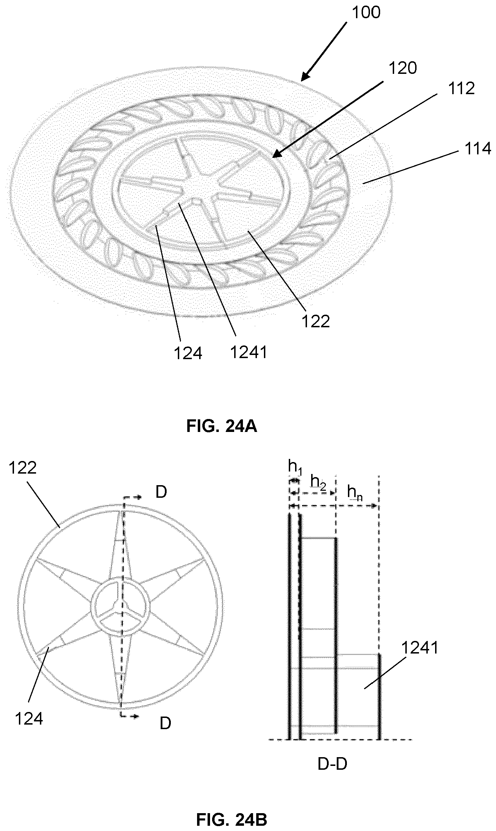

As illustrated in FIG. 24A- FIG. 24B, FIG. 24A is a schematic structural diagram illustrating a vibration component including a strip structure with a step structure according to some embodiments of the present disclosure. FIG. 24B is a schematic structural diagram illustrating a vibration component including a strip structure with a step structure according to some embodiments of the present disclosure. In some embodiments, as illustrated in FIG. 24A, by designing the reinforcing member 120 including the strip structure 124 with the step structure, stiffness, mass, and a centroid distribution of the reinforcing member 120 may be changed without changing one or more hollow-out regions (affecting a fourth resonance peak of the vibration component 100) and the suspension region 1121 (affecting a second resonance peak of the vibration component 100 ) of the central region 112, thereby effectively adjusting a position of a first resonance peak, a position of a third resonance peak, and a bandwidth of the vibration component without changing the second resonance peak and the fourth resonance peak of the vibration component 100. Different frequency response curves may be adjusted based on actual application requirements.

In some embodiments, by designing thicknesses of different regions of the reinforcing member 120 from a thickness direction (i.e., in a vibration direction of the vibration component 100), the stiffness of the reinforcing member 120 may be changed without changing or changing a mass of the reinforcing member 120 based on an actual required mass distribution, so that the stiffness $Kt_1$ provided to the system by the reinforcing member 120 and the elastic element 110 may change, further causing a resonance frequency of a flipping motion of a mass $Mt_1$-spring $Kt_1$-damping $Rt_1$ system to change, thereby causing the position of the third resonance peak of the vibration component 100 to change. Furthermore, a 3dB bandwidth of the third resonance peak of the vibration component 100 may also be controlled.

In some embodiments, the one or more strip structures 124 may have a plurality of steps with different thicknesses in the vibration direction of the elastic element 110, i.e., the one or more strip structures 124 may have a stepped shape. In some embodiments, at least one of the one or more strip structures may have the stepped shape. In some embodiments, all of the one or more strip structures may have the stepped shape. FIG. 24B illustrates a structure including a reinforcing member 120 with a step-shaped strip structure 124, and a cross-sectional structure of a D-D cross section thereof. The thickness of an outmost edge step (i.e., a first step located at a radially outermost side of the strip structure 124) of the reinforcing member 120 is defined as $h_1$, a thickness of a secondary outmost edge step of the reinforcing member 120 is defined as $h_2$,..., a thickness of a center step (i.e., a second step located at a radially innermost side of the strip structure 124) is defined as $h_n$, and a physical quantity $\varepsilon$ is defined as a ratio of a thickness $h_j$ to a thickness $h_k$ (k>j) of any two steps:

$$\epsilon = \frac{h_j}{h_k}. \quad \text{(Equation 9)}$$

A physical quantity $\varphi$ is defined as a ratio of the thickness $h_1$ of the outmost edge step (i.e., the first step located at the radially outermost side of the strip structure 124) of the reinforcing member 120 to the thickness $h_n$

of the center step (i.e., the second step located at the radially innermost side of the strip structure 124):

$$\varphi = \frac{h_1}{h_n}. \quad \text{(Equation 10)}$$

In some embodiments, the ratio $\varepsilon$ of the thickness $h_j$ to the thickness $h_k$ of any two steps may be within a range of 0.1-10. In some embodiments, the ratio $\varepsilon$ of the thickness $h_j$ to the thickness $h_k$ of any two steps may be within a range of 0.1-8. In some embodiments, the ratio $\varepsilon$ of the thickness $h_j$ to the thickness $h_k$ of any two steps may be within a range of 0.2-8. In some embodiments, the ratio $\varepsilon$ of the thickness $h_j$ to the thickness $h_k$ of any two steps may be within a range of 0.1-7. In some embodiments, the ratio $\varepsilon$ of the thickness $h_j$ to the thickness $h_k$ of any two steps may be within a range of 0.1-6. In some embodiments, the ratio $\varepsilon$ of the thickness $h_j$ to the thickness $h_k$ of any two steps may be within a range of 0.2-6. In some embodiments, the ratio $\varepsilon$ of the thickness $h_j$ to the thickness $h_k$ of any two steps may be within a range of 0.2-5. In some embodiments, the ratio $\varepsilon$ of the thickness $h_j$ to the thickness $h_k$ of any two steps may be within a range of 0.25-4.

In some embodiments, by designing the thicknesses of different regions of the reinforcing member 120, mass distribution of the reinforcing member 120 may be adjusted, thereby changing stiffness of the reinforcing member 120 without changing or changing a mass of the reinforcing member 120, so that a stiffness $Kt_1$ provided to the system by the reinforcing member 120 and the elastic element 110 may change, thus adjusting a position of a third resonance peak of the vibration component 100, and controlling a 3dB bandwidth of the third resonance peak of the vibration component 100.

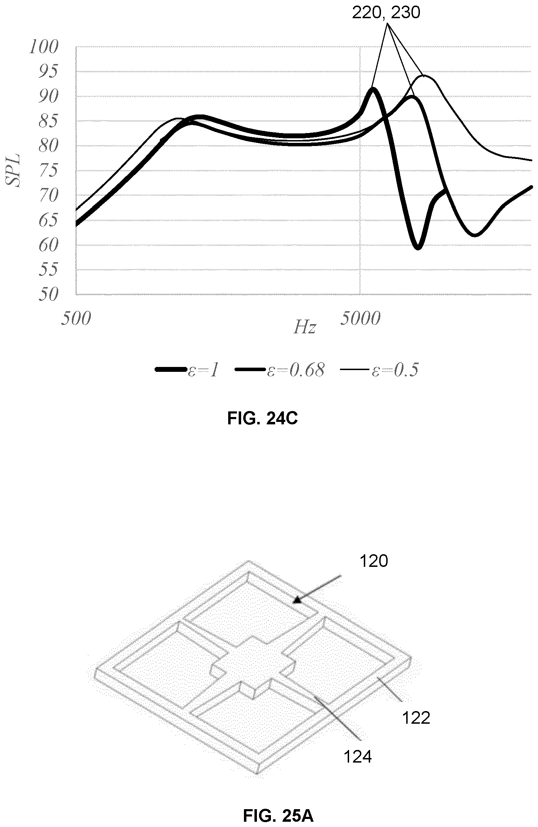

FIG. 24C is a schematic diagram illustrating frequency response curves of vibration components according to some embodiments of the present disclosure. By the structural design of the vibration component, the second resonance peak 220 and the third resonance peak 230 of the vibration component may be merged. The frequency response curve of the vibration component may only reflect two resonance peaks. FIG. 24C illustrates frequency response curves of the vibration components corresponding to $\varepsilon = 1$, $\varepsilon = 0.68$, and $\varepsilon = 0.5$, respectively. As illustrated in FIG. 24C, positions of medium and high frequency resonance peaks (e.g., the resonance peak obtained after the second resonance peak 220 and the third resonance peak 230 are merged) of the frequency response curves corresponding to $\varepsilon = 1$, $\varepsilon = 0.68$, and $\varepsilon = 0.5$ are different, and 3dB bandwidth at the resonance peaks are also different. In addition, as a value of $\varepsilon$ decreases, resonance frequencies of the medium and high frequency resonance peaks (e.g., the resonance peak obtained after the second resonance peak 220 and the third resonance peak 230 are merged) gradually increase, and the 3dB bandwidth gradually increases. Accordingly, by adjusting the value of $\varepsilon$, the frequency positions and the 3dB bandwidth of the medium and high frequency resonance peaks may be adjusted. In some embodiments, the ratio $\varepsilon$ of the thickness $h_j$ to the thickness $h_k$ of any two steps may be within a range of 0.25-4, which makes the medium and high frequency resonance peaks of the vibration component to be located within a range of 3000 Hz-12000 Hz, and the resonance peaks may have a relatively large 3dB bandwidth.

For frequency responses of some vibration components 100 requiring a low Q value and a wide bandwidth, a relatively large mass may be designed to be concentrated near the center of the reinforcing member 120. In some embodiments, the ratio $\varphi$ of the thickness $h_1$ of the outmost edge step of the reinforcing member 120 to the thickness $h_n$ of the center step may be within a range of 0.1-1. In some embodiments, the ratio $\varphi$ of the thickness $h_1$ of the outmost edge step of the reinforcing member 120 to the thickness $h_n$ of the center step may be within a range of 0.2-0.8. In some embodiments, the ratio $\varphi$ of the thickness $h_1$ of the outmost edge step of the reinforcing member 120 to the thickness $h_n$ of the center step may be within a range of 0.2-0.6. In some embodiments, the ratio $\varphi$ of the thickness $h_1$ of the outmost edge step of the reinforcing member 120 to the thickness $h_n$ of the center step may be within a range of 0.2-0.4.

For frequency responses of some vibration components 100 requiring a high Q value and a narrow bandwidth, a relatively large mass may be designed to be concentrated in an edge region of the reinforcing member 120. In some embodiments, the ratio $\varphi$ of the thickness $h_1$ of the outmost edge step of the reinforcing member 120 to the thickness $h_n$ of the center step may be within a range of 1-10. In some embodiments, the ratio $\varphi$ of the thickness $h_1$ of the outmost edge step of the reinforcing member 120 to the thickness $h_n$ of the center step may be within a range of 1.2-6. In some embodiments, the ratio $\varphi$ of the thickness $h_1$ of the outmost edge step of the reinforcing member 120 to the thickness $h_n$ of the center step may be within a range of 2-6. In some embodiments, the ratio $\varphi$ of the thickness $h_1$ of the outmost edge step of the reinforcing member 120 to the thickness $h_n$ of the center step may be within a range of 3-6. In some embodiments, the ratio $\varphi$ of the thickness $h_1$ of the outmost edge step of the reinforcing member 120 to the thickness $h_n$ of the center step may be within a range of 4-6. In some embodiments, the ratio $\varphi$ of the thickness $h_1$ of the outmost edge step of the reinforcing member 120 to the thickness $h_n$ of the center step may be within a range of 5-6.

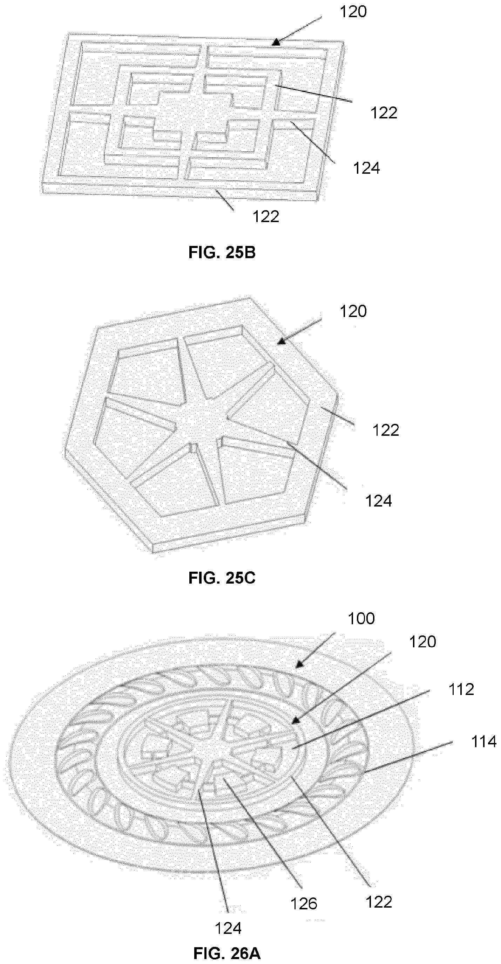

As illustrated in FIG. 25A- FIG. 25C, FIG. 25A-FIG. 25C are schematic structural diagrams illustrating vibration components including different shapes of reinforcing members according to some embodiments of the present disclosure. In FIG. 25A, the shape of the reinforcing member 120 may be a rectangle, the ring structure 122 may be a single-ring rectangular structure, and the strip structure 124 may be a trapezoidal structure. In FIG. 25B, the shape of the reinforcing member 120 may be a rectangle, the ring structure 122 may be a double-ring rectangular structure, and the strip structure 124 may be a trapezoidal structure. In FIG. 25C, the shape of the reinforcing member 120 may be a hexagon, the ring structure 122 may be a single-ring hexagonal structure, and the strip structure 124 may be a trapezoidal structure. In some embodiments, the shape of the reinforcing member 120 of the vibration component 100 may match the shape of the elastic element 110. The elastic element 110 may also have various structures, such as a circle, a square, a polygon, etc. The shape of the reinforcing member 120 may also be designed into different shapes, including but not limited to a circle, a square (e.g., a rectangle and square), a triangle, a hexagon, an octagon, another polygon, an ellipse, and other irregular shapes.

Different shapes of reinforcing member 120 and different shapes of elastic element 110 may be flexibly designed to change the mass and stiffness of the reinforcing member 120, the mass and stiffness of the vibration component 100, etc., thereby changing the resonance frequency of the vibration component 100.

In some embodiments, the shape of the reinforcing member 120 and the shape of the elastic element 110 may include various shapes. In this case, different widths and different shapes may be defined for a horizontal direction of the one or more strip structures 124 extending from the central region 112 to the periphery. Different shapes, counts, and dimensions of the one or more ring structures may also be designed. The one or more ring structures 122 may be designed as entire rings or local ring structures 122. Different ring structures 122 may divide the one or more strip structures 124 into different regions, in which the one or more strips structures 124 from the center to the periphery may be continuous or staggered, and a count of the one or more strip structures 124 may be equal or unequal. In some embodiments, the one or more ring structures 122 may also be designed as a circle, a square (e.g., a rectangle and a square), a triangle, a hexagon, an octagon, another polygon, an ellipse, and other irregular structures.

In some embodiments, by designing the vibration component 100 including different shapes of reinforcing members 120, a fourth resonance peak of the vibration component 100 may be located within a range of 10 kHz-18 kHz, an area-thickness ratio $\mu$ of an area $S_i$ of each of one or more hollow-out regions to a thickness $H_i$ of the elastic element 110 of each of the one or more hollow-out regions may be within a range of 150 mm-700 mm, a ratio $\gamma$ of an area $S_{ki}$ to an area $S_{ji}$ of any two hollow-out regions of the elastic element 110 may be within a range of 0.25-4, and a ratio $\beta$ of a horizontal area of a reinforcing portion of the reinforcing member 120 to a horizontal area of the reinforcing member 120 may be within a range of 0.2- 0.7. In some embodiments, by designing the vibration component 100 including different shapes of reinforcing members 120, a fourth resonance peak of the vibration component 100 may be located within the range of 10 kHz-18 kHz, the area-thickness ratio $\mu$ of the area $S_i$ of each of the one or more hollow-out regions to the thickness $H_i$ of the elastic element 110 of each of the one or more hollow-out regions may be within a range of 100 mm-1000 mm, the ratio $\gamma$ of the area $S_{ki}$ to the area $S_{ji}$ of any two hollow-out regions of the elastic element 110 may be within a range of 0.1-10, and the ratio $\beta$ of the horizontal area of the reinforcing portion of the reinforcing member 120 to the horizontal area of the reinforcing member 120 may be within a range of 0.1-0.8.

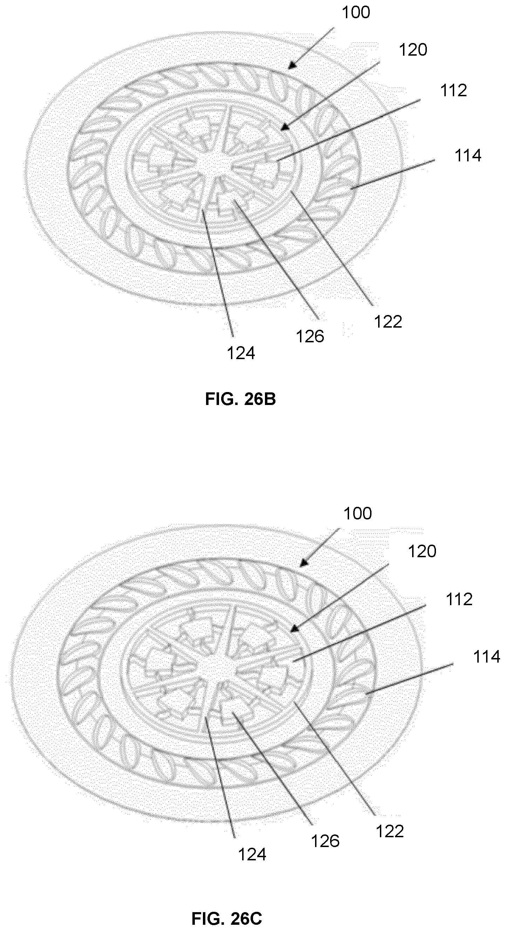

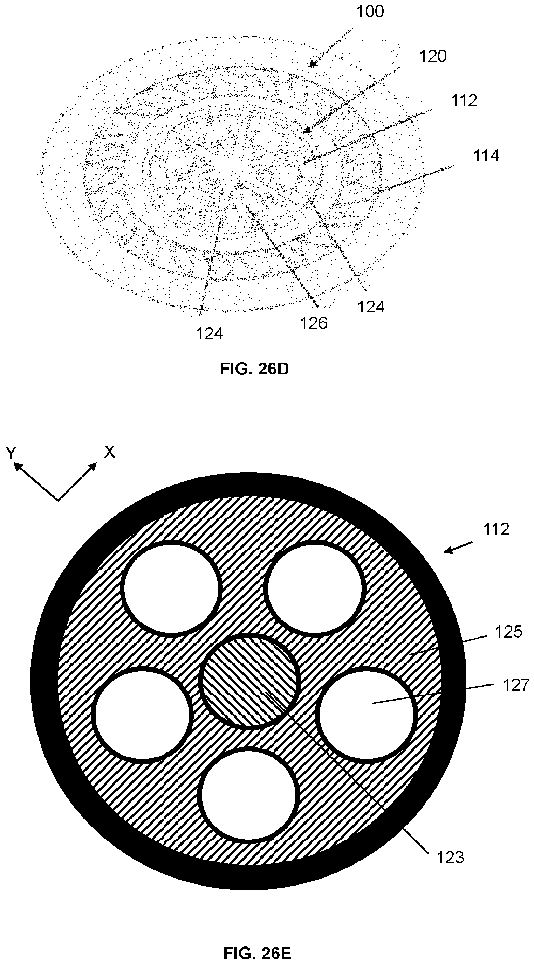

As illustrated in FIG. 26A- FIG. 26D, FIG. 26A- FIG. 26D are schematic structural diagrams illustrating vibration components 100 including local mass structures according to some embodiments of the present disclosure. FIG. 26A illustrates a local mass structure 126 of a double-elastic connection. FIG. 26B illustrates the local mass structure 126 of a four-elastic connection. FIG. 26C illustrates the local mass structure of an S-shaped four-elastic connection. FIG. 26D illustrates an irregular local mass structure 126 of the S-shaped four-elastic connection. In some embodiments, the local mass structure 126 may be designed in a suspension region of the central region 112 to flexibly adjust an equivalent mass $Mm_i$, equivalent stiffness $Ka_i$ and $Ka_i'$, and equivalent damping $Ra_i$ and $Ra_i'$ of each of the one or more hollow-out regions, so that a fourth resonance peak of the vibration component 100 may be effectively adjusted. Meanwhile, by designing the local mass structure 126, a mass and a stiffness of the reinforcing member 120 may also be adjusted within a wide range, thereby adjusting a first resonance peak and a third resonance peak of the vibration component 100.

In some embodiments, the local mass structure 126 may be circumferentially connected to adjacent strip structures 124 through two elastic structures (as illustrated in FIG. 26A), or may be circumferentially connected to adjacent ring structures 122 through the two elastic structures. In some embodiments, each local mass structure 126 may not be connected to the one or more strip structures 124 or the one or more ring structures 122, but only connected to the elastic element 110. In some embodiments, a part of the local mass structures 126 may be connected to the elastic element 110, and the other part of the local mass structures 126 may be connected to the one or more ring structures 122 and/or the one or more strip structures 124.

In some embodiments, the local mass structure 126 may also be connected to the adjacent strip structures 124 and the adjacent ring structures 122 simultaneously through four elastic structures (as illustrated in FIG. 26B).

In some embodiments, a planar shape of the elastic structure may be a regular shape (as illustrated in FIG. 26A and FIG. 26B) or an irregular shape (as illustrated in FIG. 26C).

In some embodiments, the local mass structure 126 may be a regular shape (as illustrated in FIG. 26A- FIG. 26C) or in any irregular shape (as illustrated in FIG. 26D).

In some embodiments, by designing the dimension, position, count, and shape of the local mass structure 126 and the dimension, position, count, and shape of the elastic structure, a fourth resonance peak of the vibration component 100 may be located within a range of 10 kHz-18 kHz, an area-thickness ratio $\mu$ of an area $S_i$ of each of one or more hollow-out regions to a thickness $H_i$ of the elastic element 110 of each of the one or more hollow-out regions may be within a range of 150 mm-700 mm, a ratio $\gamma$ of an area $S_{ki}$ to an area $S_{ji}$ of any two hollow-out regions of the elastic element 110 may be within a range of 0.25-4, and a ratio $\beta$ of the horizontal area of the reinforcing portion of the reinforcing member 120 to the horizontal area of the reinforcing member 120 may be within a range of 0.2- 0.7. In some embodiments, by designing the dimension, the position, the count, and the shape of the local mass structure 126 and the dimension, the position, the count, and the shape of the elastic structure, the fourth resonance peak of the vibration component 100 may be located within a range of 10 kHz-18 kHz, the area-thickness ratio $\mu$ of the area $S_i$ of each of the one or more hollow-out regions to the thickness $H_i$ of the elastic element 110 of each of the one or more hollow-out regions may be within a range of 100 mm-1000 mm, the ratio $\gamma$ of the area $S_{ki}$ to the area $S_{ji}$ of any two hollow-out regions of the elastic element 110 may be within a range of 0.1-10, and the ratio $\beta$ of the horizontal area of the reinforcing portion of the reinforcing member 120 to the horizontal area of the reinforcing member 120 may be within a range of 0.1-0.8.

FIG. 26E is a schematic structural diagram illustrating a cross-section of a reinforcing member according to some embodiments of the present disclosure. As illustrated in FIG. 26E, the reinforcing member 120 may include a central connection part 123, a reinforcing portion 125, and a plurality of hollow-out portions 127. In some embodiments, the plurality of hollow-out portions 127 may be obtained by carving out part of the material from the reinforcing member 120. A part of the reinforcing member 120 that is not carved out may form the reinforcing portion 125. In some embodiments, the plurality of hollow-out portions 127 may be configured as circular shapes. In some embodiments, the plurality of hollow-out portions 127 may be configured as other shapes. In some embodiments, the central connection part 123 and the reinforcing portion 125 may have different thicknesses in the vibration direction of the elastic element 110. In some embodiments, the thickness of the central connection part 123 in the vibration direction of the elastic element 110 may be greater than the thickness of the reinforcing portion 125 in the vibration direction of the elastic element 110.

The embodiments of the present disclosure further provide a loudspeaker. The loudspeaker may include the vibration component provided by the embodiments of the present disclosure. By reasonably arranging structures and parameters of the vibration component (e.g., an elastic element and a reinforcing member), the loudspeaker may generate a plurality of resonance peaks within an audible range (e.g., 20 kHz-20 kHz) of the human ears, thereby improving a frequency band and sensitivity of the loudspeaker, and improving a sound pressure level output by the loudspeaker.

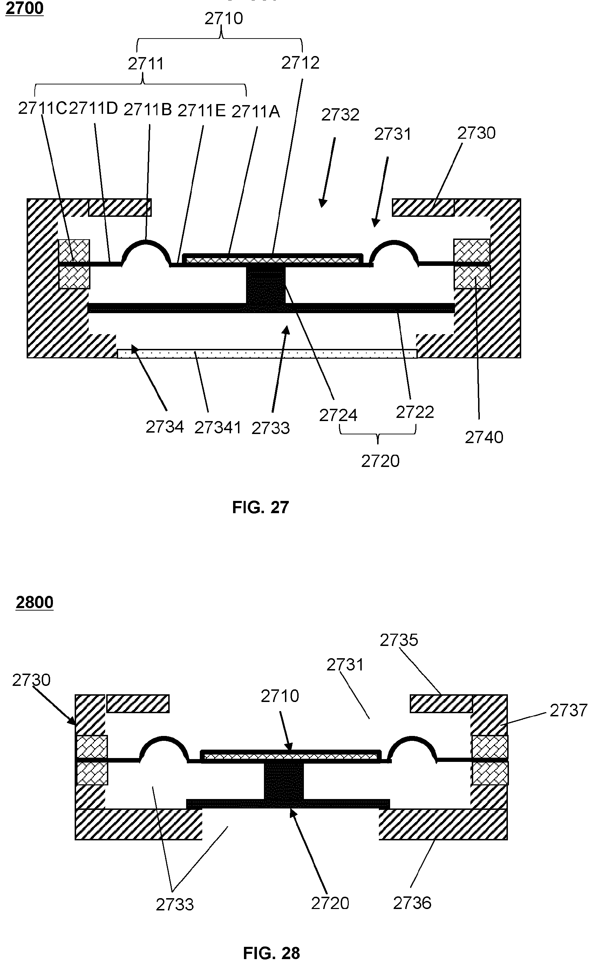

FIG. 27 is a structural diagram illustrating an exemplary loudspeaker according to some embodiments of the present disclosure. In some embodiments, as illustrated in FIG. 27, a loudspeaker 2700 may include a housing 2730, a driving component 2720, and a vibration component 2710. The driving component 2720 may be configured to generate a vibration based on an electrical signal. The vibration component 2710 may be configured to receive the vibration of the driving component 2720 to vibrate. The housing 2730 may form a cavity. The driving component 2720 and the vibration component 2710 may be disposed in the cavity. A structure of the vibration component 2710 may be the same as any vibration component described in the embodiments of the present disclosure.

In some embodiments, the vibration component 2710 may mainly include an elastic element 2711 and a reinforcing member 2712. The elastic element 2711 may mainly include a central region 2711A, a folded ring region 2711B disposed at a periphery of the central region 2711A, and a fixed region 2711C disposed at a periphery of the folded ring region 2711B. The elastic element 2711 may be configured to vibrate in a direction perpendicular to the central region 2711A. The reinforcing member 2712 may be connected with the central region 2711A. The reinforcing member 2712 may include a reinforcing portion and a plurality of hollow-out portions. Vibrations of the reinforcing member 2712 and the elastic element 2711 may generate at least two resonance peaks within an audible range (20 Hz-20 kHz) of human ears.

The driving component 2720 may be an acoustic device with an energy conversion function. In some embodiments, the driving component 2720 may be electrically connected with other components (e.g., a signal processor) of the loudspeaker 2700 to receive the electrical signal and convert the electrical signal into a mechanical vibration signal. The mechanical vibration signal may be transmitted to the vibration component 2710 to cause the vibration component 2710 to vibrate, thereby pushing the air in the cavity to vibrate and produce sound.

In some embodiments, the driving component 2720 may include a driving unit 2722 and a vibration transmission unit 2724. The driving unit 2722 may be electrically connected with other components (e.g., the signal processor) of the loudspeaker 2700 to receive the electrical signal and convert the electrical signal into the mechanical vibration signal. The vibration transmission unit 2724 may be connected between the driving unit 2722 and the vibration component 2710 and configured to transmit the vibration signal generated by the driving unit 2722 to the vibration component 2710.

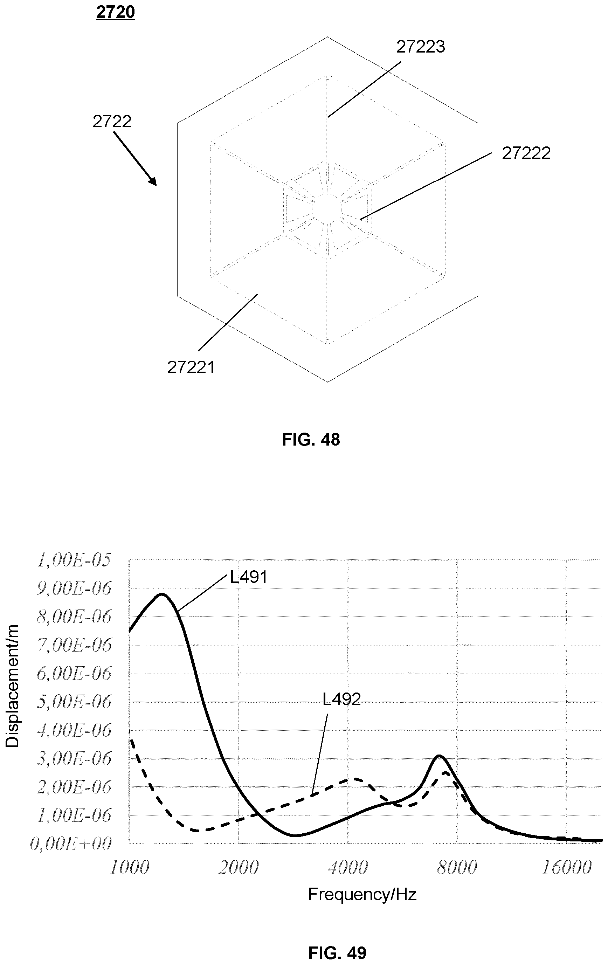

In some embodiments, the driving unit 2722 may include, but is not limited to, a moving coil acoustic driver, a moving iron acoustic driver, an electrostatic acoustic driver, or a piezoelectric acoustic driver. In some embodiments, the moving coil acoustic driver may include a magnetic component configured to generate a magnetic field and a coil disposed in the magnetic field. When the coil is energized, a vibration may be generated in the magnetic field to convert an electrical energy into a mechanical energy. In some embodiments, the moving iron acoustic driver may include a coil configured to generate an alternating magnetic field and a ferromagnetic component disposed in the alternating magnetic field. The ferromagnetic component may vibrate under the action of the alternating magnetic field to convert the electrical energy into the mechanical energy. In some embodiments, the electrostatic acoustic driver may drive a diaphragm to vibrate through an electrostatic field disposed in the electrostatic acoustic driver, thereby converting the electrical energy into the mechanical energy. In some embodiments, the piezoelectric acoustic driver may convert the electrical energy into the mechanical energy under the action of an electrostriction effect through a piezoelectric material disposed in the piezoelectric acoustic driver. In some embodiments, the driving unit 2722 may be the piezoelectric acoustic driver as in FIG. 48. The piezoelectric acoustic driver may be composed of a plurality of piezoelectric beams 27221. The plurality of piezoelectric beams 27221 may be connected with each other through elastic connectors 27222. In some embodiments, in order to maximize the use of space and increase the driving force output from the driving unit 2722, the plurality of piezoelectric beams 27221 and/or the elastic connectors may be laid as much as possible over a plane enclosed by the fixed end, i.e., widths of gaps 27223 between the plurality of piezoelectric beams and the elastic connectors may be as small as possible. For example, the widths of the gaps 27223 between the plurality of piezoelectric beams and the elastic connectors may not be greater than 25 μm.

In some embodiments, the driving unit 2722 and the vibration transmission unit 2724 may be located on a same side of a vibration direction of the vibration component. In some embodiments, one end of the vibration transmission unit 2724 along a vibration direction of the central region 2711A may be connected with the driving unit 2722, and the other end of the vibration transmission unit 2724 away from the driving unit 2722 may be connected with the central region 2711A of the vibration component 2710. In some embodiments, the reinforcing member 2712 may include a central connection part 27121 covering a center of the central region 2711A. In some embodiments, the other end of the vibration transmission unit 2724 away from the driving unit 2722 may be directly connected with the central connection part 27121, i.e., the vibration transmission unit 2724 may be connected with the central region 2711A through the central connection part 27121. In some embodiments, the other end of the vibration transmission unit 2724 away from the driving unit 2722 may be indirectly connected with the central connection part 27121, i.e., the vibration transmission unit 2724 may be directly connected with the central region 2711A and connected with the central connection part 27121 through the central region 2711A. In some embodiments, a dimension of the vibration transmission unit 2724 may be the same or substantially the same as a dimension of the central connection part 27121 (e.g., a dimension difference may be within 10%).

In some embodiments, a center of one end of the vibration transmission unit 2724 connected with the central region 2711A may coincide or substantially coincide with a projection of a center of the central region 2711A in the vibration direction of the elastic element 2711. With the arrangement, the uniformity and stability of the vibration of the elastic element 2711 may be improved, and a third resonance peak output by the loudspeaker 2700 may be controlled to be within a frequency range (e.g., 5000 Hz-12000 Hz) described in the embodiments of the present disclosure. In the embodiments of the present disclosure, substantially coinciding means that a distance between the center of one end of the vibration transmission unit 2724 connected with the central region 2711A and the center of the central region 2711A may not exceed 5% of the diameter of the central region 2711A. In some embodiments, when the vibration transmission unit 2724 is connected with the central region 2711A through the central connection part of the reinforcing member 2712, since the dimension of the vibration transmission unit 2724 matches (e.g., the dimension is the same) the dimension of the central connection part, the center of one end of the vibration transmission unit 2724 connected with the central connection part may coincide or substantially coincide with the center of the central connection part 27121. In this case, the center of the central connection part may also coincide or substantially coincide with the projection of the center of the central region 2711A in the vibration direction of the elastic element 2711. More descriptions regarding the central connection part of the reinforcing member 2712 may be found in the relevant descriptions of the central connection part 123 of the reinforcing members 120.

In some embodiments, the vibration component 2710 may receive a force and displacement transmitted by the vibration transmission unit 2724 to push the air to move and product sound. In some embodiments, a structure of the vibration component 2710 may be the same as a structure of the vibration component 100.

In some embodiments, the folded ring region 2711B may be designed with a pattern of a specific shape, thereby destroying a vibration mode of the folded ring region 2711B of the elastic element 2711 within a corresponding frequency range, avoiding sound cancellation caused by a local segmented vibration of the elastic element 2711, and causing the vibration component 2710 to have a relatively flat sound pressure level curve. Meanwhile, a local stiffness of the elastic element 2711 may be increased through the pattern design.

In some embodiments, a modal vibration mode of the vibration component 2710 may be adjusted by adjusting the structure of the reinforcing member 2712.

In some embodiments, the reinforcing member 2712 may include one or more ring structures and one or more strip structures. Each of the one or more strip structures may be connected with at least one of the one or more ring structures. At least one of the one or more strip structures may extend toward the center of the central region 2711A. A region where the one or more ring structures are located and a region where the one or more strip structures are located may form a reinforcing portion. In a projection range of a maximum contour of the reinforcing member 2712 in the vibration direction of the elastic element 2711, regions not covered by the one or more ring structures and the one or more strip structures may form a plurality of hollow-out portions. The descriptions regarding the one or more ring structures and the one or more strip structures of the reinforcing member 2712 may be found in the relevant descriptions of the one or more ring structures and the one or more strip structures elsewhere in the present disclosure.

In some embodiments, by reasonably arranging the reinforcing member 2712 and arranging a plurality of hollow-out regions in the central region 2711A, a local stiffness of the central region 2711A of the elastic element 2711 may be controlled and adjusted, thereby realizing controllable adjustment of the resonance peaks output by the vibration component 2710 using a segmented vibration mode of each of the plurality of hollow-out regions of the central region 2711A of the vibration component 2711, so that the vibration component 2710 may have a relatively flat sound pressure level curve. In some embodiments, the one or more ring structures and the one or more strip structures may cooperate with each other, so that the reinforcing member 2712 may have an appropriate proportion of the reinforcing portion and hollow-out portions (i.e., the plurality of hollow-out portions), thereby reducing a mass of the reinforcing member 2712 and improving an overall sensitivity of the vibration component 2710. In some embodiments, by designing shapes, dimensions, and counts of the one or more ring structures and the one or more strip structures, positions and bandwidths of a plurality of resonance peaks (e.g., a third resonance peak, a fourth resonance peak, etc.) of the vibration component 2710 may be adjusted, thereby controlling a vibration output of the vibration component 2710.

In some embodiments, a mass of the reinforcing member 2712, a mass of the elastic element 2711, an equivalent air mass, and a driving end equivalent mass may be combined to form a total equivalent mass Mt, and equivalent damping of various parts may form the total equivalent damping Rt. The elastic element 2711 may provide a stiffness Kt to the system, forming a mass Mt-spring Kt-damping Rt system. When an excitation frequency of the driving component 2720 is close to a resonance frequency of the system, a resonance peak may appear in a frequency response curve of the vibration component 2710, i.e., a first resonance peak of the vibration component 2710. In some embodiments, the frequency of the first resonance peak may be within a range of 180 Hz-3000 Hz. In some embodiments, the frequency of the first resonance peak may be within a range of 200 Hz-3000 Hz. In some embodiments, the frequency of the first resonance peak may be within a range of 200 Hz-2500 Hz. In some embodiments, the frequency of the first resonance peak may be within a range of 200 Hz-2000 Hz. In some embodiments, the frequency of the first resonance peak may be within a range of 200 Hz-1000 Hz.

In some embodiments, the folded ring region 2711B, a connection region 2711D, and a suspension region 2711E disposed between a region of the central region 2711A provided with the reinforcing member 2712 and the folded ring region 2711B may form an equivalent mass Ms, an equivalent stiffness Ks, and equivalent damping Rs, thereby forming a mass Ms-spring Ks-damping Rs system. When the excitation frequency of the driving component 2720 is close to the resonance frequency of the system, a resonance peak may appear in the frequency response curve of the vibration component 2710, i.e., a second resonance peak of the vibration component 2710. In some embodiments, the frequency of the second resonance peak of the vibration component 2710 may be within a range of 3000 Hz-7000 Hz. In some embodiments, the frequency of the second resonance peak of the vibration component 2710 may be within a range of 3000 Hz- 6000 Hz. In some embodiments, the frequency of the second resonance peak of the vibration component 2710 may be within a range of 4000 Hz -6000 Hz. In some embodiments, by setting parameters (e.g., parameters of the folded ring region 2711B and the suspension region 2711E) of the elastic element 2711, the second resonance peak of the vibration component 2710 may be located within the above frequency range.

In some embodiments, the reinforcing member 2712, the connection region 2711D, the folded ring region 2711B, the suspension region 2711E disposed between the region of the central region 2711A provided with the reinforcing member 2712 and the folded ring region 2711B, the equivalent air mass, an equivalent mass of the driving component 2720 may be combined to form a total equivalent mass $Mt_1$, and equivalent damping of various parts may form the total equivalent damping $Rt_1$. The reinforcing member 2712 and the elastic element 2711 may provide a stiffness $Kt_1$ to the system, forming a mass $Mt_1$-spring $Kt_1$-damping $Rt_1$ system. When the excitation frequency of the driving component 2720 is close to a speed resonance frequency of the system, a resonance peak may appear in the frequency response curve of the vibration component 2710, which is a third resonance peak of the vibration component 2710. In some embodiments, the frequency of the third resonance peak may be within a range of 5000 Hz-12000 Hz. In some embodiments, the frequency of the third resonance peak may be within a range of 6000 Hz-12000 Hz. In some embodiments, the frequency of the third resonance peak may be within a range of 6000 Hz-10000 Hz.

In some embodiments, the central region 2711A corresponding to the reinforcing member 2712 may have not less than one hollow-out region. Each hollow-out region with a different resonance frequency may vibrate, so that no less than one high frequency resonance peak may be generated on the frequency response curve of the vibration component 2710. In some embodiments, by designing the structure of the reinforcing member 2712, the resonance frequency of each hollow-out region may be equal or close to each other (e.g., a difference may be less than 4000 Hz), so that a high frequency resonance peak with a relatively large sound pressure level may be generated on the frequency response curve of the vibration component 2710, i.e., a fourth resonance peak of the vibration component 2710. In some embodiments, a frequency of the fourth resonance peak may be within a range of 8000 Hz-20000 Hz. In some embodiments, the frequency of the fourth resonance peak may be within a range of 10000 Hz-18000 Hz. In some embodiments, the frequency of the fourth resonance peak may be within a range of 12000 Hz-18000 Hz. In some embodiments, the frequency of the fourth resonance peak may be within a range of 15000 Hz-18000 Hz. In some embodiments, the frequency of the fourth resonance peak may be greater than 20000 Hz. In some embodiments, the resonance frequency of each hollow-out region may be different, and vibration phases of different hollow-out regions within different frequency ranges may be different in a high frequency range (e.g., 8000 Hz-20000 Hz), forming an effect of sound superposition and cancellation, which makes the vibration component 2710 not output the fourth resonance peak.

In some embodiments, by designing the structure of the vibration component 2710, the loudspeaker 2700 may generate two, three, or four resonance peaks within the audible range (e.g., 20 Hz-20 kHz) of the human ears.

In some embodiments, by designing a structure and a dimension of the vibration component 2710, including an overall dimension of the reinforcing member 2712, a count and dimensions of the one or more strip structures, arrangement positions of the one or more strip structures, an area of the suspension region 2711E, a structure (e.g., a folded ring width, a folded ring arch height, a folded ring arch shape, a pattern, etc.) of the folded ring region 2711B, and an area of the connection region 2711D, a difference between the frequency of the second resonance peak and the frequency of the third resonance peak of the vibration component 2710 may be designed. In some embodiments, when the difference between the frequency of the second resonance peak and the frequency of the third resonance peak of the vibration component 2710 is less than 2000 Hz, the second resonance peak and the third resonance peak tend to merge, i.e., the second resonance peak and the third resonance peak may present as one resonance peak, making a medium and high frequency range (3000 Hz-10000 Hz) to have a relatively high sensitivity, and greatly increasing bandwidth of the merged resonance peak. In some embodiments, the frequency of the fourth resonance peak may be greater than 20000 Hz, i.e., the fourth resonance peak is not presented within the audible range of the human ears. In some embodiments, when the difference between the frequency of the second resonance peak and the frequency of the third resonance peak is less than 2000 Hz and the fourth resonance peak is not presented within the audible range of the human ears, only two resonance peaks may be generated within the audible range of the human ear during vibration of the vibration component, and a 3dB bandwidth of at least one of the only two resonance peaks may not be less than 1000 Hz. The 3dB bandwidth refers to the width of a frequency band (e.g., the abscissa in FIG. 7D) when a sound pressure level amplitude (e.g., the ordinate in FIG. 7D) corresponding to a resonance peak is reduced by 3dB. In some embodiments, during vibration of the vibration component 2710, the 3dB bandwidth of at least one resonance peak within the audible range of the human ears may not be less than 1500 Hz. In some embodiments, during vibration of the vibration component 2710, the 3dB bandwidth of the at least one resonance peak within the audible range of the human ears may not be less than 1000 Hz. In some embodiments, during vibration of the vibration component 2710, the 3dB bandwidth of the at least one resonance peak within the audible range of the human ears may not be less than 500 Hz.

In some embodiments, by the design of the reinforcing member 2712 and the elastic element 2711, the vibration component 2710 may appear a required high-order mode within the audible range (20 Hz-20000 Hz). The first resonance peak, the second resonance peak, the third resonance peak, and the fourth resonance peak may be generated on the frequency response curve of the vibration component 2710, i.e., four resonance peaks may be generated on the frequency response curve of the vibration component 2710 within the frequency range of 20 Hz-20000 Hz.

In some embodiments, by designing the structure of the reinforcing member 2712 and the elastic element 2711, the vibration component 2710 may also generate only three resonance peaks within the audible range (20 Hz-20000 Hz) of the human ears. For example, when the difference between the frequency of the second resonance peak and the frequency of the third resonance peak of the vibration component 2710 is less than 2000 Hz, the second resonance peak and the third resonance peak may present as one resonance peak on the frequency response curve of the vibration component 2710, which forms three resonance peaks of the vibration component 2710 within the audible range (20 Hz-20000 Hz) of the human ears with the first resonance peak and the fourth resonance peak. As another example, the central region 2711A corresponding to the reinforcing member 2712 may have no less than one suspension region. When the resonance frequency of each hollow-out region is higher than the audible range, or the resonance frequencies of hollow-out regions are different and the vibration phases of different suspension regions within different frequency ranges are different in the high frequency range (10000 Hz-18000 Hz) and the effect of sound superposition and cancellation is formed, a high-frequency roll-off effect may be obtained. The fourth resonance peak may not be presented on the frequency response curve of the vibration component 2710. In this case, the first resonance peak, the second resonance peak, and the third resonance peak may form the three resonance peaks of the vibration component 2710 within the audible range (20 Hz-20000 Hz) of the human ears.

In some embodiments, by designing the structure of the reinforcing member 2712 or the elastic element 2711, the frequencies of the plurality of resonance peaks may be adjusted, and the 3dB bandwidth of the plurality of resonance peaks (e.g., the third resonance peak) and a Q value of the loudspeaker may also be adjusted.

In some embodiments, by designing an angle θ between two sides of a projection shape of the strip structure in the vibration direction, the 3dB bandwidth of the third resonance peak output by the loudspeaker 2700 and the Q value of the loudspeaker 2700 may be adjusted. In some embodiments, when the loudspeaker 2700 is required to present frequency response characteristics of a low Q value and a wide bandwidth, the angle θ of the strip structure may have a relatively large value. In some embodiments, the angle θ of the strip structure may be within a range of -90°-150°, so that the loudspeaker 2700 may have a relatively low Q value, and the 3dB bandwidth of the third resonance peak output by the loudspeaker 2700 may not be less than 1000 Hz. In some embodiments, the angle θ of the strip structure may be within a range of -0°-60°, so that the loudspeaker 2700 may have a relatively low Q value and the 3dB bandwidth of the third resonance peak output by the loudspeaker 2700 may not be less than 1000 Hz.

In some embodiments, when the loudspeaker 2700 is required to present frequency response characteristics of a high Q value and a narrow bandwidth, a relatively small angle θ of the strip structure may be designed. In some embodiments, the angle θ of the strip structure may be within a range of -150°-90°, so that the loudspeaker 2700 may have a relatively high Q value and the 3dB bandwidth of the third resonance peak output by the loudspeaker 2700 may not be greater than 1000 Hz. In some embodiments, the angle θ of the strip structure may be within a range of -60°-0°, so that the loudspeaker 2700 may have a relatively high Q value and the 3dB bandwidth of the third resonance peak output by the loudspeaker 2700 may not be greater than 1000 Hz.

In some embodiments, by designing a ratio τ of an area of an inner side to an area of an outer side of a half contour of a projection shape of the reinforcing member 2712 in the vibration direction of the elastic element 2711, the 3dB bandwidth of the third resonance peak output by the loudspeaker 2700 and the Q value of the loudspeaker 2700 may be adjusted. When the loudspeaker 2700 is required to present the frequency response characteristics with a low Q value and a wide bandwidth, a relatively large mass may be designed to be concentrated in the central region of the reinforcing member 2712. In some embodiments, the ratio τ of the area of the inner side to the area of the outer side of the half contour of the projection shape of the reinforcing member 2712 in the vibration direction of the elastic element 2711 may be within a range of 0.3-2, so that the loudspeaker 2700 may have a relatively low Q value, and the 3dB bandwidth of the third resonance peak output by loudspeaker 2700 may not be less than 1000 Hz. In some embodiments, the ratio τ of the area of the inner side to the area of the outer side of the half contour of the projection shape of the reinforcing member 2712 in the vibration direction of the elastic element 2711 may be within a range of 0.5-1.2, so that the loudspeaker 2700 may have a relatively low Q value, and the 3dB bandwidth of the third resonance peak output by loudspeaker 2700 may not be less than 1000 Hz. When the loudspeaker 2700 is required to present the frequency response characteristics of a high Q value and a narrow bandwidth, a relatively large mass may be designed to be concentrated in an edge region of the reinforcing member 2712. In some embodiments, the ratio τ of the area of the inner side to the area of the outer side of the half contour of the projection shape of the reinforcing member 2712 in the vibration direction of the elastic element 2711 may be within a range of 1-3, so that the loudspeaker 2700 may have a relatively high Q value, and the 3dB bandwidth of the third resonance peak output by the loudspeaker 2700 may not be greater than 1000 Hz. In some embodiments, the ratio τ of the area of the inner side to the area of the outer side of the half contour of the projection shape of the reinforcing member 2712 in the vibration direction of the elastic element 2711 may be within a range of 1.2-2.8, so that the loudspeaker 2700 may have a relatively high Q value, and the 3dB bandwidth of the third resonance peak output by the loudspeaker 2700 may not be greater than 1000 Hz.

In some embodiments, at least one of the one or more strip structures may have a plurality of steps with different thicknesses in the vibration direction of the elastic element 2711. The plurality of steps may include a first step located at the radially outermost side of the strip structure and a second step located at the radially innermost side of the strip structure. In some embodiments, by designing a ratio φ of the thickness of the first step to the thickness of the second step, the 3dB bandwidth of the third resonance peak output by the loudspeaker 2700 and the Q value of the loudspeaker 2700 may be adjusted. When the loudspeaker 2700 is required to present the frequency response characteristics of a low Q value and a wide bandwidth, a relatively large mass may be designed to be concentrated near the center of the reinforcing member 2712. In some embodiments, the ratio φ of the thickness of the first step to the thickness of the second step may be within a range of 0.1-1, so that the loudspeaker 2700 may have a relatively low Q value, and the 3dB bandwidth of the third resonance peak output by the loudspeaker 2700 may not be less than 1000 Hz. In some embodiments, the ratio φ of the thickness of the first step to the thickness of the second step may be within a range of 0.2-0.8, so that the loudspeaker 2700 may have a relatively low Q value, and the 3dB bandwidth of the third resonance peak output by the loudspeaker 2700 may not be less than 1000 Hz. When the loudspeaker 2700 is required to present the frequency response characteristics of a high Q value and a narrow bandwidth, a relatively large mass may be designed to be concentrated in the edge region of the reinforcing member 2712. In some embodiments, the ratio φ of the thickness of the first step to the thickness of the second step may be within a range of 0.1-10, so that the loudspeaker 2700 may have a relatively high Q value, and the 3dB bandwidth of the third resonance peak output by the loudspeaker 2700 may not be greater than 1000 Hz. In some embodiments, the ratio φ of the thickness of the first step to the thickness of the second step may be within a range of 1.2-6, so that the loudspeaker 2700 may have a relatively high Q value, and the 3dB bandwidth of the third resonance peak output by the loudspeaker 2700 may not be greater than 1000 Hz.

In some embodiments, the housing 2730 may be a regular or irregular three-dimensional structure with a hollow interior (i.e., provided with a cavity). For example, the housing 2730 may be a hollow frame structure, including but is not limited to regular shapes such as a rectangular frame, a circular frame, a regular polygon frame, and any irregular shapes. In some embodiments, the housing 2730 may be made of metal (e.g., stainless steel, copper, etc.), plastic (e.g., polyethylene (PE), polypropylene (PP), polyvinyl chloride (PVC), polystyrene (PS), and acrylonitrile-butadiene-styrene copolymer (ABS), etc.), a composite material (e.g., a metal matrix composite material or a non-metal matrix composite material), etc. In some embodiments, the driving component 2720 may be located in an acoustic cavity formed by the housing 2730 or at least partially suspended in the acoustic cavity of the housing 2730.

In some embodiments, a peripheral side of the elastic element 2711 may be connected within an inner wall of the housing 2730, thereby dividing the cavity formed by the housing 2730 into a plurality of cavities. Specifically, the cavity of the housing 2730 may be divided into a front cavity 2731 and one or more rear cavities 2733 respectively located on two sides of the elastic element 2711 in the vibration direction of the elastic element 2711 with the elastic element 2711 as a boundary. In some embodiments, the front cavity 2731 may be located at a side of the elastic element 2711 away from the driving unit 2722.

In some embodiments, the one or more rear cavities 2733 may be located at a side of the elastic element 2711 close to the driving unit 2722, i.e., the driving component 2720 may be disposed in the one or more rear cavities 2733.

In some embodiments, one or more holes may be disposed on side walls of the housing 2730 corresponding to the front cavity 2731 and the rear cavity 2733. Merely by way of example, a first hole portion 2732 may be provided on the housing 2730 on a side of the front cavity 2731 away from the elastic element 2711. The front cavity 2731 may communicate with the outside of the loudspeaker 2700 through the first hole portion 2732. A second hole 2734 may be provided on the housing 2730 of the one or more rear cavities 2733 away from the elastic element 2711. The one or more rear cavities 2733 may communicate with the outside of the loudspeaker 2700 through the second hole 2734. The sound produced by the vibration component 2710 may be radiated to the front cavity 2731 and/or the one or more rear cavities 2733 and transmitted to the outside of the loudspeaker 2700 through the first hole portion 2732 and/or the second hole 2734 on the housing 2730.

In some embodiments, a damping net or a dust-proof cloth (e.g., a damping grid) may be disposed at one or more holes (e.g., the second hole 2734). In some embodiments, the damping net may adjust (e.g., reduce) the amplitude of sound waves leaking from the one or more holes, thereby improving the performance of the loudspeaker 2700.

In some embodiments, the loudspeaker 2700 may also include a support element 2740 which is connected with the housing 2730 and the fixed region 2711C, respectively. In some embodiments, as illustrated in FIG. 27, the fixed region 2711C of the elastic element 2711 of the vibration component 2710 may be located at the periphery of the connection region 2711D and connected around a circumference of the connection region 2711D. The support element 2740 may be located on any surface of the fixed region 2711C in the vibration direction of the central region 2711A and connected with the connection region 2711D through the fixed region 2711C.

In some embodiments, the support element 2740 may be embedded in the inner wall of the housing 2730 and connected with the housing 2730 to support the elastic element 2711. When the support element 2740 is embedded in the inner wall of the housing 2730, the inner wall of the housing 2730 may be provided with a hole that matches the support element 2740, so that the support element 2740 can be placed in the hole to realize embedding of the support element 2740.

In some embodiments, as illustrated in FIG. 27, the support element 2740 may also be disposed in the cavity formed by the housing 2730. A lower surface (a surface close to the driving unit 2722) or a peripheral surface of the support element 2740 in the vibration direction of the vibration component 2710 may be connected with the housing 2730 to support the elastic element 2711. In some embodiments, when the support element 2740 is disposed in the cavity formed by the housing 2730, the inner wall of the housing 2730 may be configured to have a protruding structure that matches the support element 2740, so that the support element 2740 may be disposed on a surface of the protruding structure along the vibration direction to realize the connection between the support element 2740 and the housing 2730. In this arrangement, by disposing the support element 2740 in the cavity formed by the housing 2730, the support element 2740 may be prevented from being scratched and damaged during use of the loudspeaker 2700, thereby preventing the loudspeaker 2700 (especially the vibration component 2710) from being damaged.

In some embodiments, the support element 2740 may be a rigid structure that is not easily deformed, which only provides support for the elastic element 2711 during a vibration process of the vibration component 2710. In some embodiments, in order to further reduce a system stiffness of the vibration component 2710 during vibration and improve compliance of the loudspeaker 2700, the support element 2740 may be configured as an easily deformable flexible structure to provide additional displacement for the vibration component 2710 during vibration.

In some embodiments, the support element 2740 may deform in response to a vibration signal of the elastic element 2711 to provide the elastic element 2711 with a displacement in the vibration direction of the elastic element 2711, thereby increasing a total displacement generated by the elastic element 2711 in the vibration direction of the elastic element 2711, and further improving a low-frequency sensitivity of the vibration component 2710. In some embodiments, a material of the support element 2740 may include one or more of a rigid material, a semiconductor material, an organic polymer material, an adhesive material, or the like. In some embodiments, the rigid material may include, but is not limited to, a metallic material, an alloy material, or the like. The semiconductor material may include, but is not limited to, one or more of silicon, silicon dioxide, silicon nitride, silicon carbide, or the like. The organic polymer material may include, but is not limited to, one or more of polyimide (PI), parylene, polydimethylsiloxane (PDMS), hydrogel, or the like. The adhesive material may include, but is not limited to, one or more of the gel, silicone, acrylic, polyurethane, rubber, epoxy, hot melt, light curing, or the like. In some embodiments, in order to enhance a connection force between the support element 2740 and the elastic element 2711 and improve the reliability between the support element 2740 and the elastic element 2711, the material of the support element 2740 may be silicone adhesive glue, organic silicone sealing glue, etc. In some embodiments, a cross-sectional shape of the support element 2740 on a cross-section parallel to a vibration direction of an enhancement region may be a rectangle, a circle, an ellipse, a pentagon, or other regular and/or irregular geometric shapes. Meanwhile, by arranging the support element 2740 with a flexible structure, the vibration characteristics of the vibration component 2710 may be changed, the elastic element 2711 may be prevented from directly contacting the housing 2730, reducing a stress concentration (the housing is generally a rigid body) at a connection end of the elastic element 2711 with the housing 2730, thereby further protecting the elastic element 2711.

FIG. 28 is a schematic structural diagram illustrating a loudspeaker according to some embodiments of the present disclosure. It should be noted that since a loudspeaker 2800 in FIG. 28 has a structure similar to that of the loudspeaker 2700 in FIG. 27, the speaker 2800 may be viewed as a modification made on the basis of the loudspeaker 2700. Therefore, in the present disclosure, components that are structurally or functionally identical in the loudspeaker 2800 and the loudspeaker 2700 may use the same numbering, and components that are not labeled in FIG. 28 may be found in FIG. 27.

As illustrated in FIG. 28, the housing 2730 may include a front cavity plate 2735, a rear cavity plate 2736, and a side plate 2737. The front cavity plate 2735, the rear cavity plate 2736, and the side plate 2737 may enclose the cavity of the housing 2730. In some embodiments, the cavity of the housing 2730 may include the front cavity 2731 disposed on one side of the vibration component 2710 and the one or more rear cavities 2733 disposed on another side of the vibration component 2710. At least one of the one or more rear cavities 2733 may be enclosed by the driving component 2720, the vibration component 2710, and the rear cavity plate 2736. In some embodiments, one rear cavity 2733 may be provided. For example, the one or more rear cavities 2733 may include only a second rear cavity 27332. In some embodiments, two rear cavities 2733 may be provided. For example, the two rear cavities 2733 may include a first rear cavity 27331 and the second rear cavity 27332. In some embodiments, three rear cavities 2733, four rear cavities 2733, five rear cavities 2733, etc., may be provided. Merely by way of example, the driving component 2720, the vibration component 2710, the rear cavity plate 2736, and the side plate 2737 may enclose to form the second rear cavity 27332. Specifically, the vibration component 2710 may separate the cavity of the housing 2730 into the front cavity 2731 corresponding to the front cavity plate 2735 and the one or more rear cavities 2733 corresponding to the rear cavity plate 2736. The driving component 2720 may be disposed in the rear cavity 2733. For example, the driving component 2720 may be fixedly connected to the rear cavity plate 2736. In some embodiments, the rear cavity plate 2736 may be a PCB, a plastic plate, a metal plate, or the like. In some embodiments, the housing 2730 may be an integrated design, i.e., the front cavity plate 2735, the rear cavity plate 2736, and the side plate 2737 may be an integrated design. In some embodiments, the front cavity plate 2735, the rear cavity plate 2736, and the side plate 2737 may be connected to form the housing 2730 by gluing, welding, snap-fitting, or the like. More descriptions regarding the vibration component 2710, driving component 2720 and the housing 2730 may be found elsewhere in the present disclosure (e.g., FIG. 27), which are not repeated here.

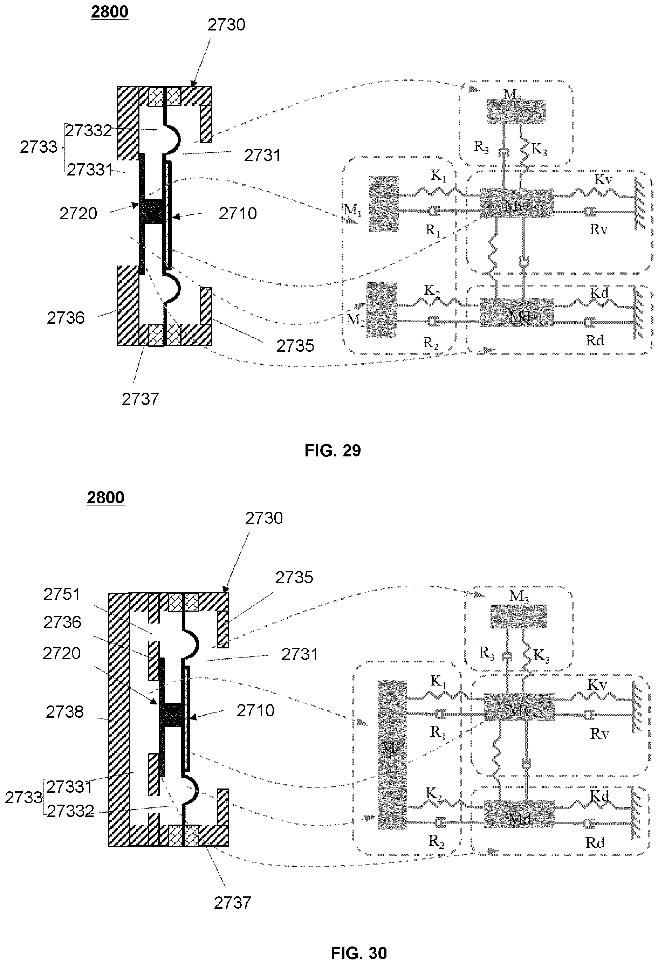

FIG. 29 is a schematic diagram illustrating a loudspeaker and an equivalent model thereof according to some embodiments of the present disclosure.

As illustrated in FIG. 29, each part of the loudspeaker 2800 may be equivalent to a mass-spring-damping system. In some embodiments, a vibration surface of the driving component 2720 may form at least a portion of a sidewall of the at least one of the one or more rear cavities 2733. Specifically, the driving component 2720 may divide the one or more rear cavities 2733 into the first rear cavity 27331 and the second rear cavity 27332. A vibration surface of the driving component 2720 toward the first rear cavity 27331 and a vibration surface of the driving component 2720 toward the second rear cavity 27332 may form the sidewalls of the first rear cavity 27331 and the second rear cavity 27332, respectively. Air in the first rear cavity 27331 may be equivalent to a mass-spring-damping system and have an equivalent mass $M_2$, an equivalent stiffness $K_2$, and an equivalent damping $R_2$. Air in the second rear cavity 27332 may be equivalent to a mass-spring-damping system and have an equivalent mass $M_1$, an equivalent stiffness $K_1$, and equivalent damping $R_1$. Air in the front cavity 2731 may be equivalent to a mass-spring-damping system and have an equivalent mass Ms, an equivalent stiffness $K_3$, and an equivalent damping $R_3$. The vibration component 2710 may be equivalent to a mass-spring-damping system and have an equivalent mass Mv, an equivalent stiffness Kv, and an equivalent damping Rv. The driving component 2720 may be equivalent to a mass-spring-damping system and have an equivalent mass Md, an equivalent stiffness Kd, and equivalent damping Rd. In some embodiments, the driving unit 2722 in the driving component 2720 may include a piezoelectric actuator as shown in FIG. 48. According to the descriptions elsewhere in the present disclosure, widths of gaps between a plurality of piezoelectric beams and elastic connectors of the piezoelectric actuator may be so small that, during a vibration process, the air in the second rear cavity 27332 is unable to flow quickly to the first rear cavity 27331 through the gaps to balance an air pressure at two sides of the driving component 2720. Therefore, the first rear cavity 27331 and the second rear cavity 27332 may not communicate with each other, and the second rear cavity 27332 may be essentially a sealed chamber. In some embodiments, as illustrated in FIG. 48, the driving component 2720 may include a plurality of vibration units. The vibration unit may include a piezoelectric beam 27221. The piezoelectric beam 27221 of the vibration unit may be connected through the elastic connector 27222. In some embodiments, the gaps formed between the plurality of vibration units may be smaller to increase a driving force output by the driving component 2720 and utilize space to a greater extent. In some embodiments, the gaps formed between the plurality of vibration units may not be greater than 25 $\mu$m. In some embodiments, the gaps formed between the plurality of vibration units may not be greater than 20 $\mu$m. In some embodiments, the gaps formed between the plurality of vibration units may not be greater than 15 $\mu$m. In some embodiments, the gaps formed between the plurality of vibration units may not be greater than 10 $\mu$m. In some embodiments, the gaps formed between the plurality of vibration units refer to the gaps formed between the plurality of piezoelectric beams of the plurality of vibration units. In some embodiments, the gaps formed between the plurality of vibration units may be the gaps formed between the plurality of piezoelectric beams and the plurality of elastic connectors 27222 of the plurality of vibration units.

In some embodiments, in order to increase the driving force output by the driving component 2720 and utilize the space to a greater extent, the vibration surface of the driving component 2720 may have a relatively large area of continuous surface region. In some embodiments, no less than 90% of the surface region on the vibration surface of the driving component 2720 may be continuous. In some embodiments, no less than 95% of the surface region on the vibration surface of the driving component 2720 may be continuous. In some embodiments, no less than 98% of the surface region on the vibration surface of the driving component 2720 may be continuous. In some embodiments, the entire surface region on the vibration surface of the driving component 2720 may be continuous.

In some embodiments, the driving component 2720 may include a piezoelectric membrane. In some embodiments, the piezoelectric membrane may have no gap. In this case, the second rear cavity 27332 may be completely sealed.

The mass-spring-damping systems to which the air in the first rear cavity 27331 and the second rear cavity 27332 is equivalent are capable of acting on the driving component 2720 and the vibration component 2710, respectively. Due to relatively small volumes of the first rear cavity 27331 and the second rear cavity 27332, the mass and damping of the air in the first rear cavity 27331 and the second rear cavity 27332 may be omitted, which makes the mass-spring-damping systems to which the air in the first rear cavity 27331 and the second rear cavity 27332 is equivalent may be equivalent to air spring systems. Therefore, the mass-spring-damping systems to which the air in the first rear cavity 27331 and the second rear cavity 27332 is equivalent may primarily contribute to the stiffnesses of air springs acting on the vibration component 2710 and the driving component 2720. Furthermore, the mass-spring-damping systems to which the air in the first rear cavity 27331 and the second rear cavity 27332 is equivalent may act on the driving component 2720 and the vibration component 2710 in the form of additional stiffnesses. Specifically, due to relatively small volumes of the first rear cavity 27331 and the second rear cavity 27332, the air in the first rear cavity 27331 and the second rear cavity 27332 may also be less compressible, then the additional stiffnesses of the air in the first rear cavity 27331 and the second rear cavity 27332 acting on the vibration component 2710 and the driving component 2720 may be relatively large, vibration displacements of the vibration component 2710 and the driving component 2720 may be relatively small, thereby reducing outputs of the driving component 2720 and the vibration component 2710, such as reducing the output of the driving component 2720 to the vibration component 2710 and reducing the output of the vibration component 2710 to the air, which is not conducive to improving the sensitivity of the loudspeaker. In order to improve the sensitivity of the loudspeaker, in some embodiments, the mass-spring-damping systems to which the air in the first rear cavity 27331 and the second rear cavity 27332 is equivalent may be adjusted to improve the sensitivity of the loudspeaker. In some embodiments, as a stiffness of the vibration component 2710 is smaller than a stiffness of the driving component 2720, the effect of the air spring systems to which the air in the first rear cavity 27331 and the second rear cavity 27332 is equivalent on the vibration component 2710 may be greater than the effect of the air spring systems to which the air in the first rear cavity 27331 and the second rear cavity 27332 is equivalent on the driving component 2720. For example, a reduction in the vibration displacement of the vibration component 2710 may be greater than a reduction in the vibration displacement of the driving component 2720.

In some embodiments, one or more through holes may be provided in the rear cavity plate 2736. The one or more rear cavities 2733 may be communicated through the one or more through holes to improve the sensitivity of the loudspeaker. In some embodiments, the one or more through holes may include one through hole or a plurality of through holes, i.e., one through hole or the plurality of through holes may be provided in the rear cavity plate 2736. In some embodiments, at least two rear cavities 2733 may be provided. The at least two rear cavities 2733 may be communicated through the one or more through holes. In some embodiments, the at least two rear cavities 2733 may include the first rear cavity 27331 and the second rear cavity 27332. The first rear cavity 27331 and the second rear cavity 27332 may be communicated through the one or more through holes, so that the additional stiffnesses of the air in the at least two rear cavities 2733 acting on the vibration component 2710 and the driving component 2720 may be adjusted (reduced) to increase the vibration displacements of vibration component 2710 and the driving component 2720, thereby improving the sensitivity of the loudspeaker 2800. Specifically, the one or more through holes may be provided in the rear cavity plate 2736 to communicate the first rear cavity 27331 with the second rear cavity 27332, which may increase the compressibility of the air in the at least two rear cavities 2733 (cavities formed by communication of the first rear cavity 27331 and the second rear cavity 27332), thereby reducing the additional stiffnesses of the air in the at least two rear cavities 2733 acting on the vibration component 2710 and the driving component 2720, as illustrated in FIG. 30.

FIG. 30 is a schematic diagram illustrating a loudspeaker and an equivalent model thereof according to some embodiments of the present disclosure.

As illustrated in FIG. 30, the rear cavity plate 2736 may be provided with one or more through holes 27361. The first rear cavity 27331 and the second rear cavity 27332 may be communicated through the one or more through holes 27361, so as to generally adjust (i.e., reduce) an additional stiffness of air in the one or more rear cavities 2733 acting on the vibration component 2710 and the driving component 2720, and increase vibration displacements of the vibration component 2710 and the driving component 2720, thereby improving the sensitivity of the loudspeaker 2800. Furthermore, when the first rear cavity 27331 and the second rear cavity 27332 are communicated to form one rear cavity 2733, the air in the one or more rear cavities 2733 may be equivalent to a mass-spring-damping system and have an equivalent mass M, equivalent stiffnesses $K_1$ and $K_2$, and equivalent damping $R_1$ and $R_2$. Air in the front cavity 2731 may be equivalent to a mass-spring-damping system and have an equivalent mass Ms, an equivalent stiffness $K_3$, and an equivalent damping $R_3$. The vibration component 2710 may be equivalent to a mass-spring-damping system and have an equivalent mass Mv, an equivalent stiffness Kv, and equivalent damping Rv, thereby forming a mass-spring-damping system Mv-Kv-Rv. The driving component 2720 may be equivalent to a mass-spring-damping system and have an equivalent mass Md, an equivalent stiffness Kd, and equivalent damping Rd. In the mass-spring-damping system to which the air in the one or more rear cavities 2733 is equivalent, the equivalent mass M may be an equivalent mass (a sum of equivalent masses of the air in the first rear cavity 27331 and the second rear cavity 27332) of the air in the rear cavity 2733. The equivalent stiffnesses $K_1$ and $K_2$ may be equivalent stiffnesses of the air in the first and second rear cavities 27331 and 27332, respectively. The equivalent damping $R_1$ and $R_2$ may be equivalent damping of the air in the first rear cavity 27331 and the second rear cavity 27332, respectively. Specifically, when the first rear cavity 27331 and the second rear cavity 27332 are communicated, the air in the one or more rear cavities 2733 may be more compressible, and the air may be easily compressed, causing an overall additional stiffness of the air in the one or more rear cavities 2733 acting on the vibration component 2710 and the driving component 2720 to be smaller, which increases the vibration displacements of the vibration component 2710 and the driving component 2720, thereby improving the sensitivity of the loudspeaker 2800.

It should be noted that the one or more rear cavities 2733 may also include more rear cavities (e.g., a third rear cavity, a fourth rear cavity, etc.). Every two adjacent rear cavities may be separated from each other by the rear cavity plate. The rear cavity plate configured to separate the adjacent rear cavities may be provided with one or more through holes to enable the adjacent rear cavities to be communicated.

In some embodiments, the housing 2730 may insulate at least two rear cavities to form an enclosed space. Furthermore, the housing 2730 may insulate the first rear cavity 27331 and the second rear cavity 27332 from the outside to form the enclosed space. In some embodiments, referring to FIG. 30, the housing 2730 of the loudspeaker may further include a rear cavity portion. In some embodiments, the rear cavity portion, the rear cavity plate 2736, and the driving component 2720 may enclose the first rear cavity 27331. The driving component 2720, the vibration component 2710, the rear cavity portion, and the rear cavity plate 2736 may enclose the second rear cavity 27332. In some embodiments, the rear cavity portion may include a sealing plate 2738 and a side plate 2737. In some embodiments, the sealing plate 2738 may be provided on a side of the driving component 2720 opposite the vibration component 2710. The sealing plate 2738, the side plate 2737, the rear cavity plate 2736, and the driving component 2720 may enclose the first rear cavity 27331. The driving component 2720, the vibration component 2710, the side plate 2737, and the rear cavity plate 2736 may enclose the second rear cavity 27332, thereby enabling the first rear cavity 27331 and the second rear cavity 27332 to form the enclosed space. In some embodiments, the sealing plate 2738 may be provided with one or more through holes to further reduce the additional stiffness of the air in the rear cavity 2733 acting on the vibration component 2710 and the driving component 2720, thereby further improving the sensitivity of the loudspeaker. In some embodiments, at least two rear cavities 2733 may communicate with the outside through one or more sound guiding holes disposed in the housing 2730. In some embodiments, the sealing plate 2738 may be provided with the one or more sound guiding holes to enable the first rear cavity 27331 and the second rear cavity 27332 to communicate with the outside. In some embodiments, the one or more through holes provided in the sealing plate 2738 may act as the one or more sound guiding holes to enable the first rear cavity 27331 and the second rear cavity 27332 to communicate with the outside. In some embodiments, the one or more sound guiding holes may also be provided in the side plate 2737 forming the first rear cavity 27331. In some embodiments, the sealing plate 2738 may not be disposed at a cavity opening of the first rear cavity 27331 away from the driving component 2720, thereby making a cavity space of the rear cavity 2733 an open space. The loudspeaker 2800 of which the sealing plate 2738 is not provided at the cavity opening of the first rear cavity 27331 away from the driving component 2720 will be described in detail below.

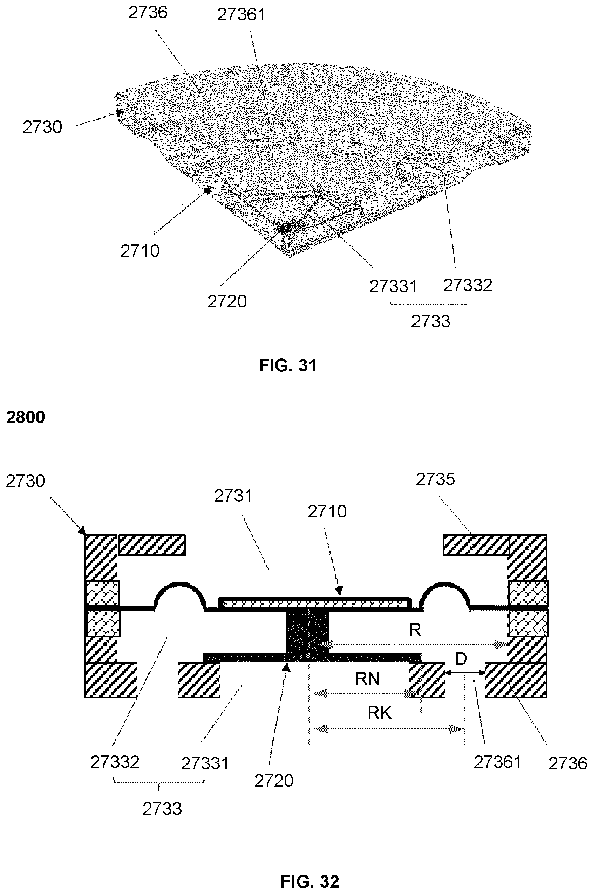

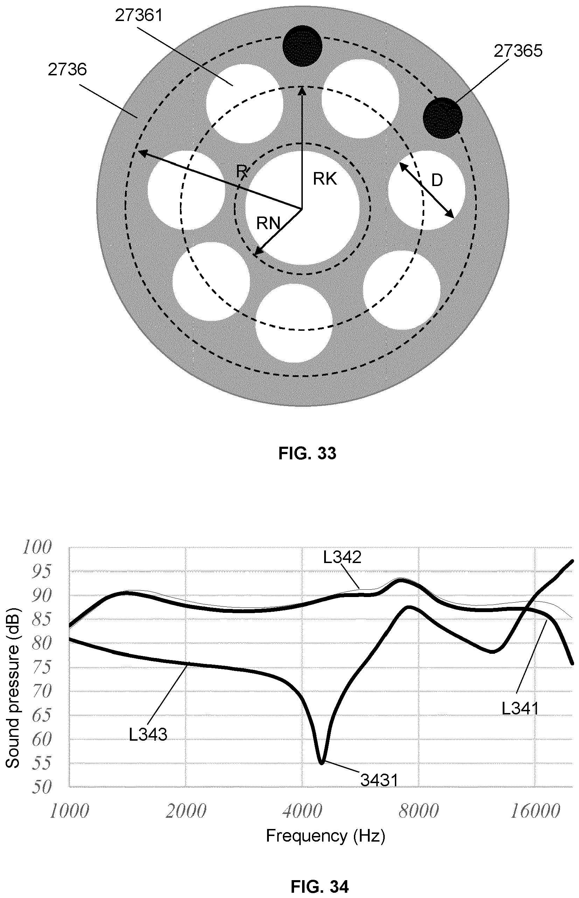

FIG. 31 is a schematic diagram illustrating a 1/4 stereoscopic structure of a loudspeaker according to some embodiments of the present disclosure. FIG. 32 is a cross-sectional view illustrating a loudspeaker parallel to an axial direction of a cavity of a housing according to some embodiments of the present disclosure. FIG. 33 is a view illustrating a loudspeaker perpendicular to an axial direction of a cavity of a housing according to some embodiments of the present disclosure.

Referring to FIG. 31- FIG. 33, the rear cavity plate 2736 may be provided with the one or more through holes 27361, which may reduce the additional stiffness of the air in the one or more rear cavities 2733 acting on the vibration component 2710 and the driving component 2720, and increase vibration displacements of the vibration component 2810 and the driving component 2820. In this case, the vibration component 2710 may push the air to vibrate more significantly, which in turn may enhance an output of the loudspeaker 2800, thereby improving the sensitivity of loudspeaker 2800. In some embodiments, as illustrated in FIG. 33, the rear cavity plate 2736 may be provided with solder joints 27365 (e.g., solder joints for electrical connection wires of the driving component 2720 on the rear cavity plate 2736). Positions of the one or more through holes 27361 on the rear cavity plate 2736 may be set based on positions of the solder joints 27365. For example, the one or more through holes 27361 may be set away from the positions of the solder joints 27365.

The effect of the one or more through holes 27361 in the rear cavity plate 2736 on the output of the loudspeaker 2800 will be specifically described below with reference to a frequency displacement curve of the driving unit and a frequency response curve of the loudspeaker 2800.

FIG. 49 is a schematic diagram illustrating a frequency displacement curve of a driving unit according to some embodiments of the present disclosure.

As illustrated in FIG. 49, curve L491 is a frequency displacement curve of the driving unit 2720 when the one or more through holes 27361 are provided in the rear cavity plate 2736, and curve L492 is a frequency displacement curve of the driving unit 2720 when the one or more through holes 27361 are not provided in the rear cavity plate 2736. It can be seen that designing the one or more through holes 27361 in the rear cavity plate 2736 has a significant effect on the output displacement of the driving unit 2720. Especially in a frequency range of less than 2000 Hz, the displacement of the driving unit 2720 is significantly increased, which further illustrates that by designing the one or more through holes 27361 in the rear cavity plate 2736, an additional stiffness acting on the driving unit 2720 is reduced, which greatly improves the displacement output of the driving unit 2720 under a same excitation voltage, and ultimately improves an overall output of the loudspeaker.

FIG. 34 is a schematic diagram illustrating a frequency response curve of a loudspeaker according to some embodiments of the present disclosure.

As illustrated in FIG. 34, curve L341 is a frequency response curve of the loudspeaker 2800 when one or more through holes are provided in the rear cavity plate 2736. Curve L342 is a frequency response curve of the loudspeaker 2800 when a volume of the rear cavity 2733 tends to be infinitely large (i.e., when the rear cavity 2733 is fully open, which may be regarded as that one or more infinitely large through holes are provided in the rear cavity plate 2736 or the rear cavity plate 2736 is eliminated). Curve L343 is a frequency response curve of the loudspeaker 2800 when the one or more through holes are not provided in the rear cavity plate 2636. By comparing the curves L341, L342, and L343, it can be seen that the curves L341 and L342 are smoother than the curve L343 (the curve L343 has a resonance valley). It can be seen that the loudspeaker 2800 is able to have a relatively flat sound pressure level output when the one or more through holes are provided in the rear cavity plate 2736 or the volume of the rear cavity 2733 tends to be infinitely large, thereby improving sound quality of the loudspeaker 2800. In addition, the curves L341 and L342 have a relatively large output sound pressure level (i.e., the amplitude) compared to the curve L343. It can be seen that the loudspeaker 2800 may have a higher sensitivity when the one or more through holes are provided in the rear cavity plate 2736 or the volume of the rear cavity 2733 tends to be infinitely large. It is more ideal to make the volume of the rear cavity 2733 tend to be infinitely large by providing the one or more infinitely large through holes in the rear cavity plate 2736, while eliminating the rear cavity plate 2736 may affect a structural strength of the loudspeaker 2800. Accordingly, in the actual design of the loudspeaker, by providing the one or more through holes in the rear cavity plate 2736 and reasonably designing parameters (e.g., a count, a shape, a dimension, a distribution, etc.) of the one or more through holes, the sound quality and the sensitivity of the loudspeaker can be effectively improved.

In some embodiments, as illustrated in FIG. 32, the one or more through holes 27361 may be round holes. In some embodiments, the one or more through holes 27361 may be other regularly or irregularly shaped holes. For example, the one or more through holes 27361 may be regular hexagonal holes, other polygons, ovals, irregular shapes, or the like.

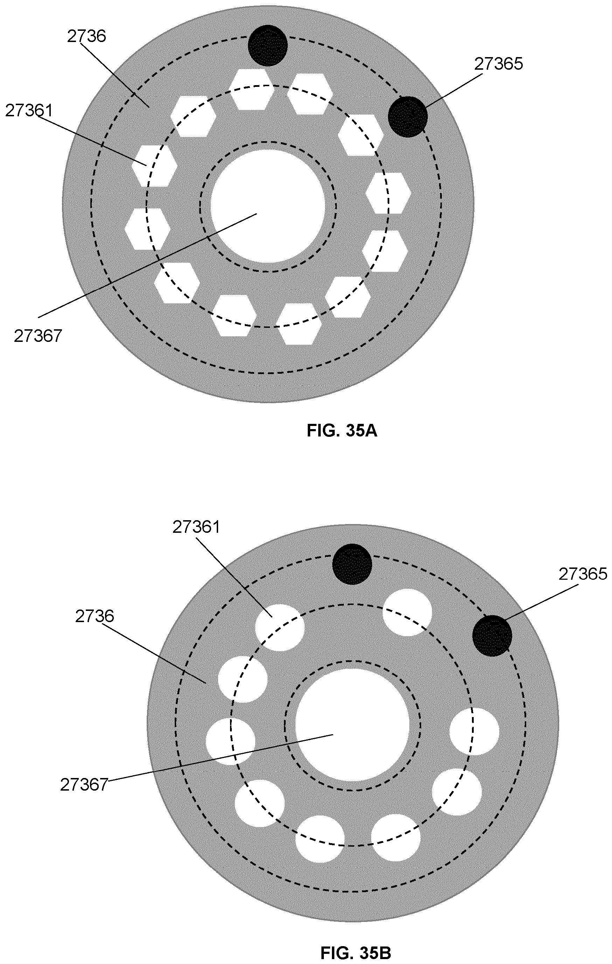

In some embodiments, as illustrated in FIG. 33 and FIG. 35A, the one or more through holes 27361 may be distributed in a ring on the rear cavity plate 2736 at equal space. In some embodiments, as illustrated in FIG. 35B, the one or more through holes 27361 may be distributed in a ring on the rear cavity plate 2736 at unequal spaces.

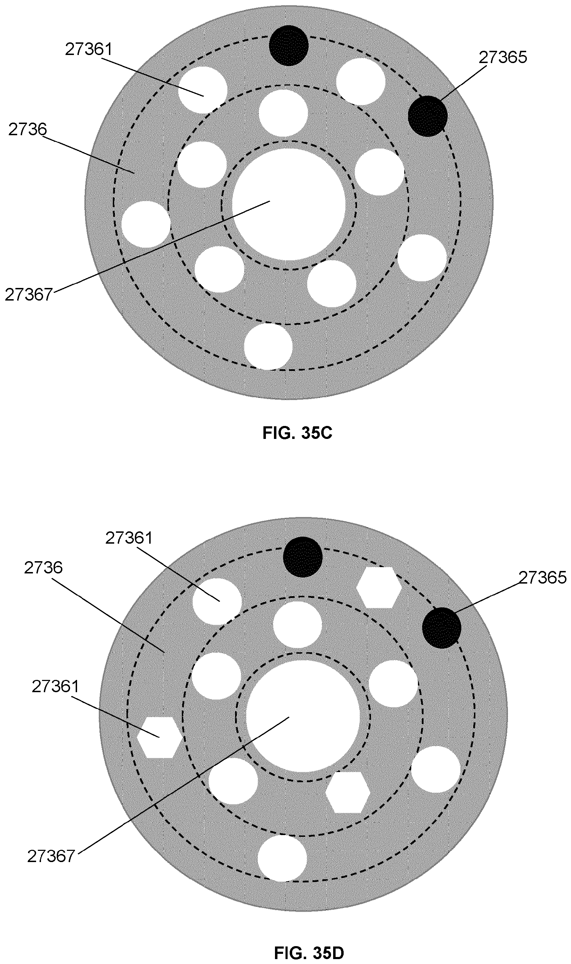

In some embodiments, as illustrated in FIG. 35C, the one or more through holes 27361 may be distributed in a plurality of rings (e.g., two rings in FIG. 35C) on the rear cavity plate 2736. In some embodiments, centers of circles corresponding to the plurality of ring distributions may coincide. In some embodiments, the one or more through holes 27361 may not be distributed in a ring or irregularly distributed on the rear cavity plate 2736. In some embodiments, circles corresponding to at least two of the plurality of ring distributions may be tangent. In some embodiments, the one or more through holes in each of the plurality of ring distributions may be equally spaced or unequally spaced. In some embodiments, when the one or more through holes in the plurality of ring distributions are unequally spaced, the one or more through holes 27361 may be arranged away from positions of the solder joints 27365 to ensure that there is sufficient area on a region of the rear cavity plate 2736 near the solder joints 27365 to arrange electrode leads and the solder joints 27365.

In some embodiments, the one or more through holes 27361 may include a plurality of different shaped through holes. In some embodiments, as illustrated in FIG. 35D, the one or more through holes 27361 may include a plurality of round holes and a plurality of regular hexagonal holes. The plurality of round holes and the plurality of regular hexagonal holes may be distributed in a same ring on the rear cavity plate 2736, or may be distributed in different rings. In some embodiments, the plurality of round holes and the plurality of regular hexagonal holes may respectively be distributed in a different ring on the rear cavity plate 2736, i.e., the plurality of round holes may be distributed in a ring, and the plurality of regular hexagonal holes may be distributed in another ring. In some embodiments, the plurality of round holes and the plurality of regular hexagonal holes may also be mixed to form a plurality of ring arrays, i.e., each of the plurality of ring arrays may include the round holes and the regular hexagonal holes.

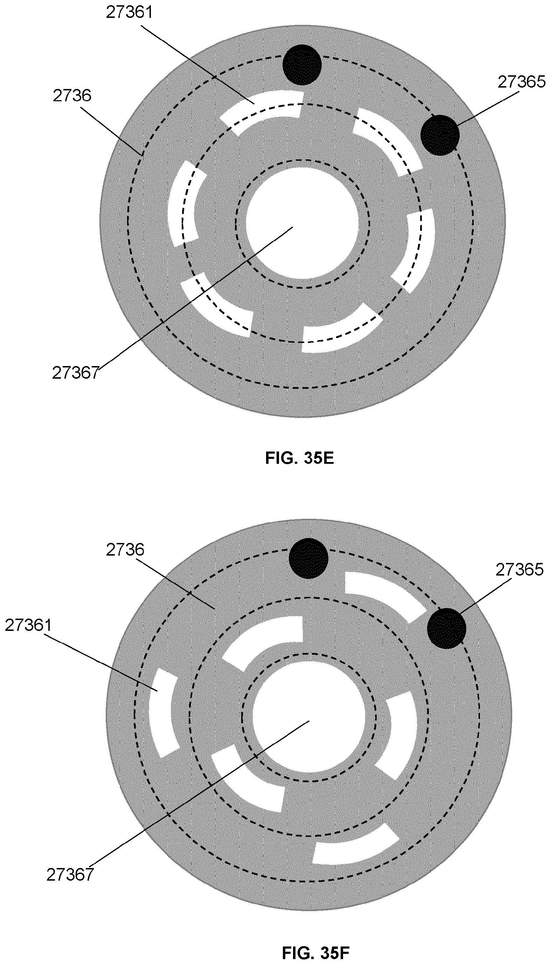

In some embodiments, as illustrated in FIG. 35E, the one or more through holes 27361 may all be fan ring holes. The one or more fan ring holes may be distributed in a ring on the rear cavity plate 2736 at equal space, i.e., the one or more fan ring holes on the rear cavity plate 2736 may be viewed as discontinuous ring holes. In some embodiments, as illustrated in FIG. 35F, the one or more fan ring holes may be distributed in a plurality of rings on the rear cavity plate 2736, i.e., the one or more fan ring holes on the rear cavity plate 2736 may be viewed as one or more concentric discontinuous ring holes.

It should be noted that shapes, distributions, or the like, of the one or more through holes 27361 in FIG. 33 and FIG. 35A- FIG. 35F are only examples and are not intended to be limited. For example, the shapes of the one or more through holes 27361 may also be regular or irregular shapes, such as a triangle, a rectangle, a regular pentagon, or the like. As another example, the one or more through holes 27361 may also be rectangularly distributed, linearly distributed, or the like, on the rear cavity plate 2736. In some embodiments, as illustrated in FIG. 33 and FIG. 35 A- FIG. 35 F, a central through hole 27367 may also be provided at the center of the rear cavity plate 2736. The central through hole 27367 may allow a deformation space for the driving component 2720.

In some embodiments, different positions of the one or more through holes 27361 on the rear cavity plate 2736 may have an effect on the performance of the loudspeaker. Accordingly, the loudspeaker may have better performance by reasonably arranging the positions of the one or more through holes 27361 on the rear cavity plate 2736.

The effect of the positions of the one or more through holes 27361 on the rear cavity plate 2736 on the performance (e.g., the sensitivity) of the loudspeaker will be described in detail below with reference to structures of the loudspeaker 2800 and the rear cavity plate 2736 in FIG. 32 and FIG. 33.

In some embodiments, as illustrated in FIG. 32 and FIG. 33, a position of at least one of the one or more through holes 2736 may be determined based on a distance from a centerline of the at least one of the one or more through holes 2736 to a centerline of the cavity of the housing 2730, an equivalent radius of the driving component, and an equivalent radius of the cavity of the housing 2730. In some embodiments, when the at least one of the one or more through holes 2736 is a round hole, the centerline of the at least one of the one or more through holes 2736 may be an axis of the round hole. When the at least one of the one or more through holes 2736 is a hole of another shape, the centerline of at least one of the one or more through holes 2736 may be a line that passes through a geometric center of a cross section of the at least one of the one or more through holes 2736 or a center of an equivalent circle and is parallel to the axis (e.g., the centerline of the cavity) of the cavity of the housing 2730. In some embodiments, when the shape of the cross section of the cavity of the housing 2730 is a circle, the centerline of the cavity of the housing 2730 may be the axis of the cavity, and the equivalent radius of the cavity of the housing 2730 may be a radius of the circle. When the shape of the cross section of the housing 2730 cavity is a non-circular shape, the centerline of the cavity of the housing 2730 may be a line that passes through a center of an equivalent circle of the non-circular shape and is perpendicular to a surface of the vibration component 2710 or the driving component 2720. In some embodiments, when a shape of a cross section of the driving component 2720 is a circle, an equivalent radius of the driving component 2720 may be a radius of the circle. When the shape of the cross section of the driving component 2720 is a non-circular shape, the equivalent radius of the driving component 2720 may be a radius of an equivalent circle of the non-circular shape. It should be understood that the cross sections of the at least one of the one or more through holes 27361, the cavity of the housing 2730, and the driving component 2720 may be cross sections of the at least one of the one or more through holes 27361, the cavity of the housing 2730, and the driving component 2720 perpendicular to the centerline of the cavity of the housing 2730. The equivalent circle of the non-circular shape refers to a circumcircle of the non-circular shape.

Furthermore, a difference between a distance RK from the centerline of the at least one of the one or more through holes 27361 to the centerline of the cavity and an equivalent radius RN of the driving component 2720 and a difference between an equivalent radius R of the cavity and the equivalent radius RN of the driving component 2720 may have a first preset ratio $\alpha$, wherein $\alpha$=(RK-RN)/(R-RN). In some embodiments, the position of the at least one of the one or more through holes 27361 on the rear cavity plate 2736 may be represented by the first preset ratio $\alpha$. Specifically, the first preset ratio $\alpha$ may be related to the performance of the loudspeaker.

Frequency response curves of the loudspeaker at different first preset ratios $\alpha$ may be described in detail below.

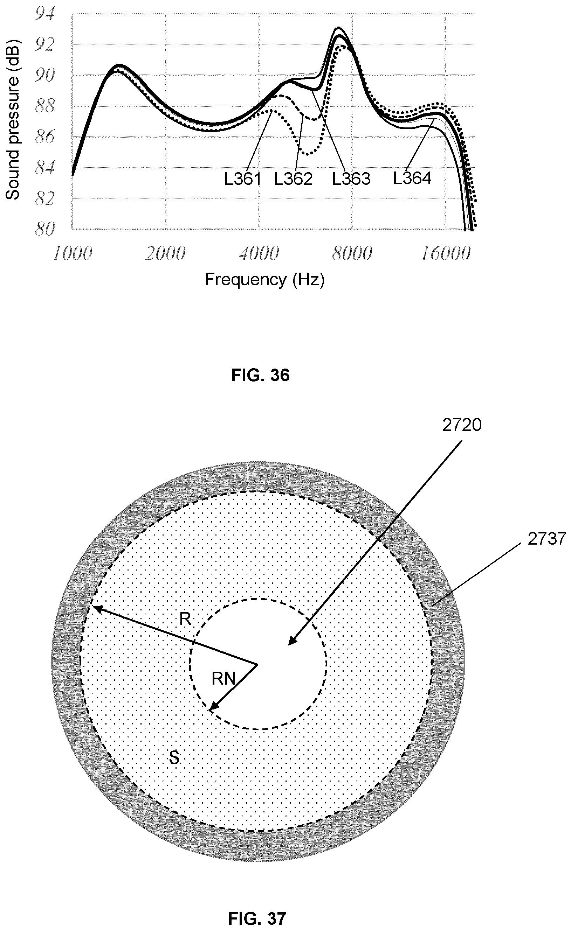

FIG. 36 is a diagram of frequency response curves of a loudspeaker at different first preset ratios $\alpha$ according to some embodiments of the present disclosure.

As illustrated in FIG. 36, curve L361 is a frequency response curve of loudspeaker 2800 when the first preset ratio $\alpha$ is 0.23. Curve L362 is a frequency response curve of the loudspeaker 2800 when the first preset ratio $\alpha$ is 0.39. Curve L363 is a frequency response curve of the loudspeaker 2800 when the first preset ratio $\alpha$ is 0.55. Curve L364 is a frequency response curve of the loudspeaker 2800 when the first preset ratio $\alpha$ is 0.71. It can be seen from the curves L361, L362, L363, and L364 that in the frequency response curve of the loudspeaker, an output sound pressure level first increases and then decreases in a mid-frequency range (e.g., 1 kHz-4 kHz) with the increase in the first preset ratio $\alpha$, first increases and then decreases in a mid-high range (e.g., 4 kHz-8 kHz) with the increase in the first preset ratio $\alpha$, and first increases and then decreases in a high frequency range (e.g., 10 kHz and above) with the gradual increase in the first preset ratio $\alpha$. Accordingly, it can be seen that either too large or too small first preset ratio $\alpha$ is not conducive to improving the sensitivity of the loudspeaker.

In some embodiments, in order to ensure that a frequency response curve of the loudspeaker in a full frequency range (e.g., 20 Hz-20 kHz within an audible range of human ears) has a relatively high output sound pressure level, so that the loudspeaker has a relatively high sensitivity in the full frequency range, the first preset ratio $\alpha$ may be within a range of 0.3-0.9. In some embodiments, in order to ensure that the frequency response curve of the loudspeaker in the full frequency range has a relatively high output sound pressure level, so that the loudspeaker has a relatively high sensitivity in the full frequency range and has a good sound quality, the first preset ratio $\alpha$ may be within a range of 0.4-0.75.

In some embodiments, different areas of the one or more through holes 27361 on the rear cavity plate 2736 may have an effect on the performance of the loudspeaker. Therefore, better performance of the loudspeaker may be achieved by reasonably setting the areas of the one or more through holes 27361 on the rear cavity plate 2736. Specifically, better performance of the loudspeaker may be achieved by designing a ratio of a sum of projection areas of the one or more through holes 2736 on a plane perpendicular to a centerline of the cavity to a difference between a projection area of the cavity on the plane perpendicular to the centerline of the cavity and a projection area of the driving component 2720 on the plane perpendicular to the centerline of the cavity.

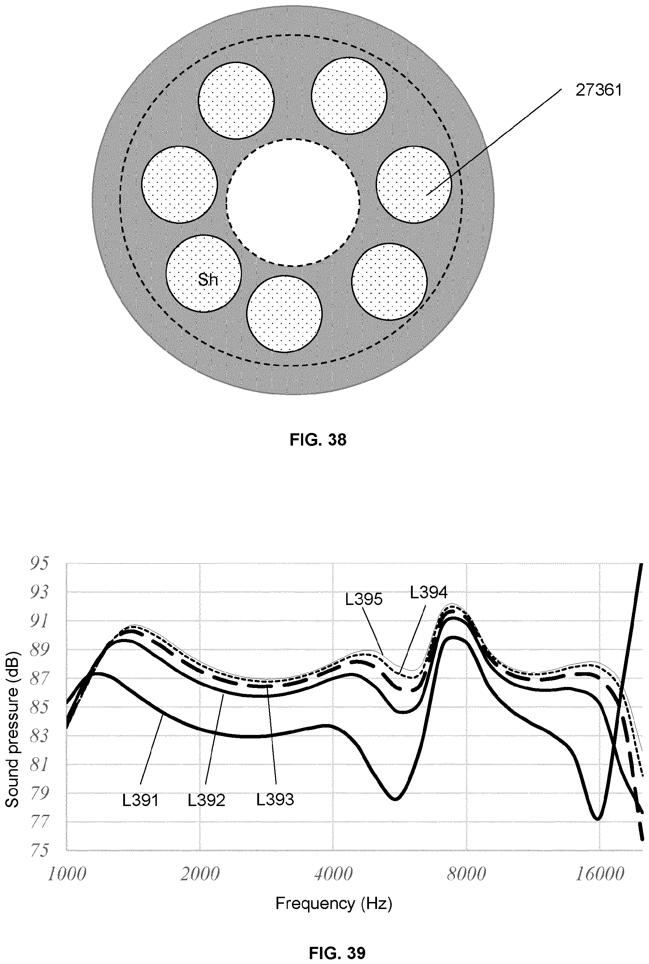

FIG. 37 and FIG. 38 are views illustrating a loudspeaker perpendicular to an axial direction of a cavity of a housing according to some embodiments of the present disclosure.

As illustrated in FIG. 37 and FIG. 38, on the plane perpendicular to the centerline of the cavity, a sum Sh of the projection areas of the one or more through holes on the plane and a difference S between the projection area of the cavity on the plane and the projection area of the driving component 2720 on the plane may have a preset ratio β. In some embodiments, when the cross sections of the cavity and the driving component 2720 are circles, $S = \pi R^2 - \pi RN^2$. Therefore, $\beta = Sh/(\pi R^2 - \pi RN^2)$. Specifically, the second preset ratio β may be related to the performance of the loudspeaker.

Frequency response curves of the loudspeaker at different first preset ratios β may be described in detail below.

FIG. 39 is a schematic diagram illustrating frequency response curves of a loudspeaker at different second preset ratios β when one or more through holes are round holes according to some embodiments of the present disclosure.

As illustrated in FIG. 39, curve L391 is a frequency response curve of the loudspeaker 2800 when the second preset ratio β is 0.012. Curve L392 is a frequency response curve of the loudspeaker 2800 when the second preset ratio β is 0.036. Curve L393 is a frequency response curve of the loudspeaker 2800 when the second preset ratio β is 0.06. Curve L394 is a frequency response curve of the loudspeaker 2800 when the second preset ratio β is 0.11. Curve L395 is a frequency response curve of the loudspeaker 2800 when the second preset ratio β is 0.14. It can be seen from the curves L391, L392, L393, L394, and L395 that when the one or more through hole are the round holes, an output sound pressure level of the frequency response curve of the loudspeaker increases with an increase of the second preset ratio β. Therefore, it can be seen that the larger the second preset ratio β is designed, the more favorable it is for improving the sensitivity of the loudspeaker. For example, it can be seen from the curves L391 and L393 that in the same frequency range, the output sound pressure level of the frequency response curve of the loudspeaker at a second preset ratio β of 0.06 is higher than that at a second preset ratio β of 0.012. Accordingly, in the same frequency range, the sensitivity of the loudspeaker at the second preset ratio β of 0.06 is higher than that at the second preset ratio β of 0.012. Furthermore, the frequency response curve of the loudspeaker at the second preset ratio β of 0.012 has an obvious resonance valley with respect to the frequency response curve at the second preset ratio β of 0.06. In other words, the frequency response curve of the loudspeaker at the second preset ratio β of 0.06 is smoother than the frequency response curve at the second preset ratio β of 0.012, i.e., the sound pressure output is flatter at the second preset ratio β of 0.06 than that at the second preset ratio β of 0.012. In some embodiments, when the one or more through holes are round holes, in order to ensure that the frequency response curve of the loudspeaker has a relatively high output sound pressure level, and to ensure that the loudspeaker has a relatively high sensitivity, the second preset ratio β may be within a range of 0.02-1. In some embodiments, when the one or more through holes are round holes, in order to ensure that the frequency response curve of the loudspeaker has a relatively high output sound pressure level and a relatively flat sound pressure level output, the second preset ratio β may be within a range of 0.06-0.5. In some embodiments, when the one or more through holes are round holes, in order to ensure that the frequency response curve of the loudspeaker has a relatively high output sound pressure level and a relatively flat sound pressure level output and to avoid that too large areas of the one or more through holes affect the structural strength of the rear cavity plate 2736, the second preset ratio β may be within a range of 0.1-0.4.

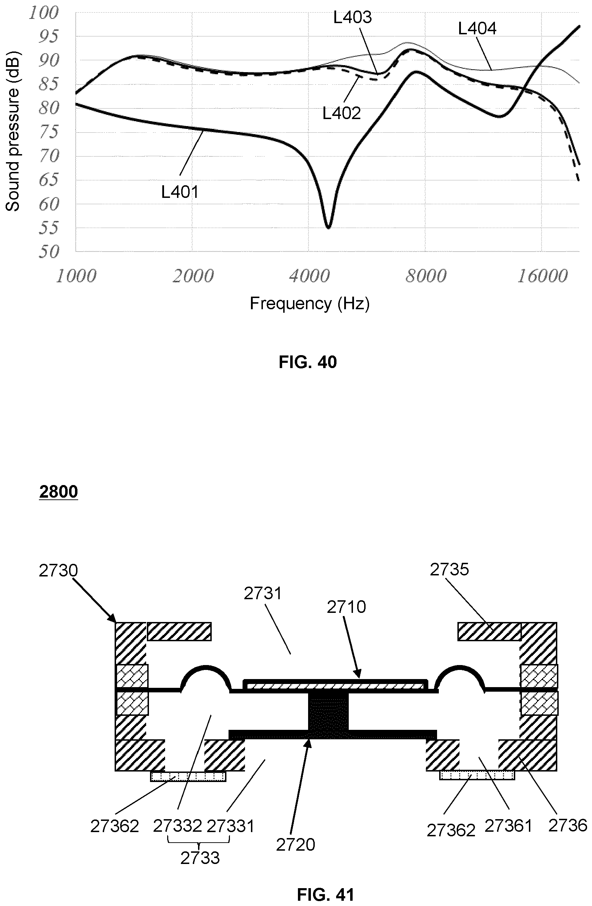

FIG. 40 is a schematic diagram illustrating frequency response curves of a loudspeaker at different second preset ratios β when one or more through holes are fan ring holes (e.g., the fan ring holes in FIG. 35E) according to some embodiments of the present disclosure.

As illustrated in FIG. 40, curve L401 is a frequency response curve of the loudspeaker 2800 when a second preset ratio β is 0 (i.e., no through hole is provided in the rear cavity plate 2736). Curve L402 is a frequency response curve of the loudspeaker 2800 when the second preset ratio β is 0.12. Curve L403 is a frequency response curve of the loudspeaker 2800 when the second preset ratio β is 0.25. Curve L404 is a frequency response curve of the loudspeaker 2800 when the second preset ratio β is 1. It can be seen from the curves L401, L402, L403, and L404 that when the one or more through holes are fan ring holes, an output sound pressure level of the frequency response curve of the loudspeaker increases with an increase of the second preset ratio β. Therefore, it can be seen that the larger the second preset ratio β is designed, the more favorable it is for improving the sensitivity of the loudspeaker. In some embodiments, when the one or more through holes are fan ring holes, in order to ensure that the frequency response curve of the loudspeaker has a relatively high output sound pressure level and to ensure that the loudspeaker has a relatively high sensitivity, the second preset ratio β may be within a range of 0.1-1. In some embodiments, when the one or more through holes are fan ring holes, in order to ensure that the frequency response curve of the loudspeaker has a relatively high output sound pressure level and a relatively flat sound pressure level output, the second preset ratio β may be within a range of 0.1-0.5. In some embodiments, when the one or more through holes are fan ring holes, in order to ensure that the frequency response curve of the loudspeaker has a relatively high output sound pressure level and a relatively flat sound pressure level output, and to avoid that too large areas of the one or more through holes affect the structural strength of the rear cavity plate 2736, the second preset ratio β may be within a range of 0.1-0.4.

In some embodiments, it can be seen from FIG. 39 and FIG. 40 that in order to ensure that the loudspeaker has better performance, the second preset ratio β when the one or more through holes are the round holes and the second preset ratio β when the one or more through holes are the fan ring holes may be within a same range. Therefore, it can be seen that when the performance of the loudspeaker is improved by providing the one or more through holes in the rear cavity plate 2736, the performance of the loudspeaker may mainly depend on the value of the second preset ratio β, and may not be significantly related to shapes of the one or more through holes. Therefore, in some embodiments, the range of the second preset ratio β when the one or more through holes are round holes or fan ring holes is applicable when the one or more through holes are regular or irregular shapes such as a triangle, a rectangle, a regular hexagon, or the like.

In some embodiments, referring to FIG. 32- FIG. 33, when the one or more through holes 27361 are round holes of the same size, a sum of projection areas of the one or more through holes on a plane perpendicular to the centerline of the cavity may be denoted as $Sh=n(\pi(D/2)^2)$, wherein n denotes a count of the one or more through holes 27361 and D denotes the aperture diameter of the one or more through holes 27361. In some embodiments, it can be seen that the larger the aperture diameter D of the one or more through holes 27361, the larger the sum Sh of the projection areas of the one or more through holes on the plane perpendicular to the centerline of the cavity, and the larger the second preset ratio β, the more conducive it is to improve the sensitivity of the loudspeaker. However, if the aperture diameter D of the one or more through holes 27361 is too large, the strength of the rear cavity plate 2736 may be insufficient, which may increase the difficulty in dust and waterproofing for the rear cavity plate 2736. Therefore, in some embodiments, the aperture diameter D of the one or more through holes 27361 may be within a range of 0.2 mm-2 mm, which ensures that the loudspeaker has better performance (e.g., relatively high sensitivity) while ensuring that the rear cavity plate has sufficient strength. In some embodiments, the aperture diameter D of the one or more through holes 27361 may be within a range of 0.4 mm-1 mm, which ensures that the loudspeaker has better performance (e.g., relatively high sensitivity) and the rear cavity plate has sufficient strength, while ensuring that the rear cavity plate 2736 has better dust and waterproof performance.

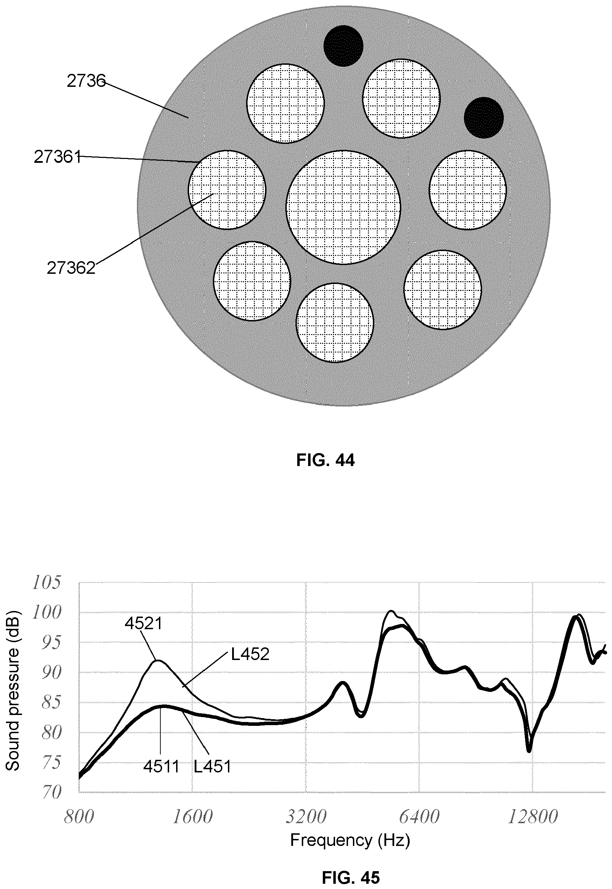

FIG. 41- FIG. 43 are cross-sectional views illustrating a loudspeaker parallel to an axial direction of a cavity of a housing according to some embodiments of the present disclosure. FIG. 44 is a cross-sectional view illustrating a loudspeaker perpendicular to an axial direction of a cavity of a housing according to some embodiments of the present disclosure.

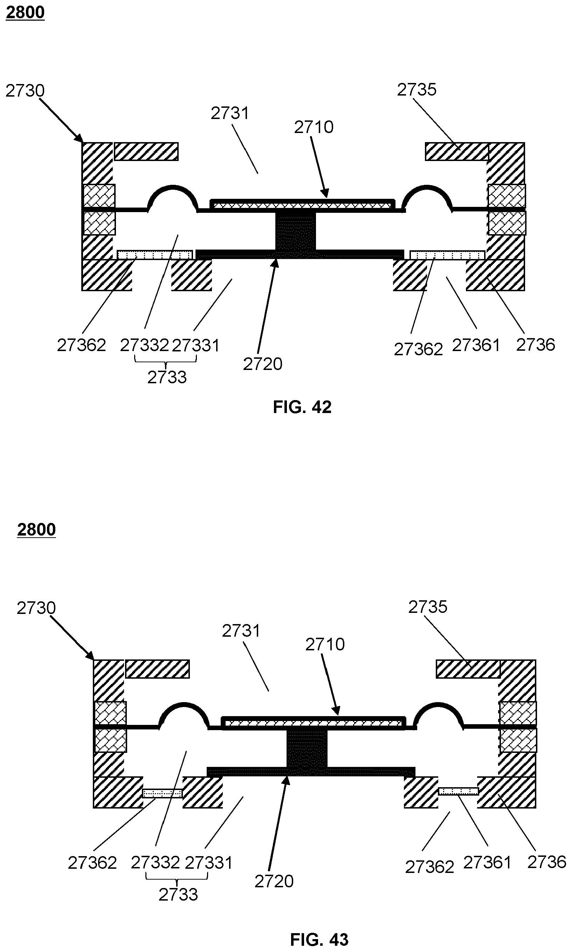

In some embodiments, as illustrated in FIG. 41-FIG. 44, at least one of the one or more through holes 27361 may be provided with a damping net 27362. By providing the damping net 27362, Q values of resonance peaks of the loudspeaker in different frequency ranges may be reduced, so that the resonance peaks may be less steep, which results in better smoothing of a frequency response curve of the loudspeaker, and a better sound quality of the loudspeaker. In some embodiments, as illustrated in FIG. 41, the damping net 27362 may be disposed at a hole opening at a side of the at least one of the one or more through holes 27361 away from the driving component 2720. In some embodiments, as illustrated in FIG. 42, the damping net 27362 may be disposed at a hole opening at a side of the at least one of the one or more through holes 27361 close to the driving component 2720. In some embodiments, as illustrated in FIG. 43, the damping net 27362 may be disposed in the at least one of the one or more through holes 27361. For example, an edge of the damping net 27362 may be connected with an inner wall of the at least one of the one or more through holes 27361 to be fixed in the at least one of the one or more through holes 27361.

The effect of the damping net provided on the at least one of the one or more through holes 27361 on a frequency response curve of the loudspeaker 2800 will be described in detail with reference to FIG. 45.

FIG. 45 is a schematic diagram illustrating a frequency response curve of a loudspeaker according to some embodiments of the present disclosure.

As illustrated in FIG. 45, curve L451 is a frequency response curve of the loudspeaker when the at least one of the one or more through holes 27361 is provided with the damping net 27362. Curve L452 is a frequency response curve of the loudspeaker when the at least one of the one or more through holes 27361 is not provided with the damping net 27362. It can be seen from the curves L451 and L452 that a resonance peak 4511 in the curve L451 is flatter than a resonance peak 4521 in the curve L452, a Q value of the resonance peak 4511 is smaller than that of the resonance peak 4521, and the curve L451 is smoother than the curve L452. It can be seen that by providing the damping net 27362 on the at least one of the one or more through holes 27361, the loudspeaker may have a relatively flat sound pressure level output, thereby ensuring that the loudspeaker has a better sound quality.

In some embodiments, the Q value of the resonance peak in the frequency response curve of the loudspeaker may be related to an acoustic impedance of the damping net 27362. The higher the acoustic impedance of the damping net 27362, the lower the Q value of the resonance peak. In some embodiments, in order to make the resonance peak in the frequency response curve of the loudspeaker have a relatively small Q value to ensure that the loudspeaker has better sound quality, the acoustic impedance of the damping net 27362 may be within a range of 3-10000 MKS rayls.

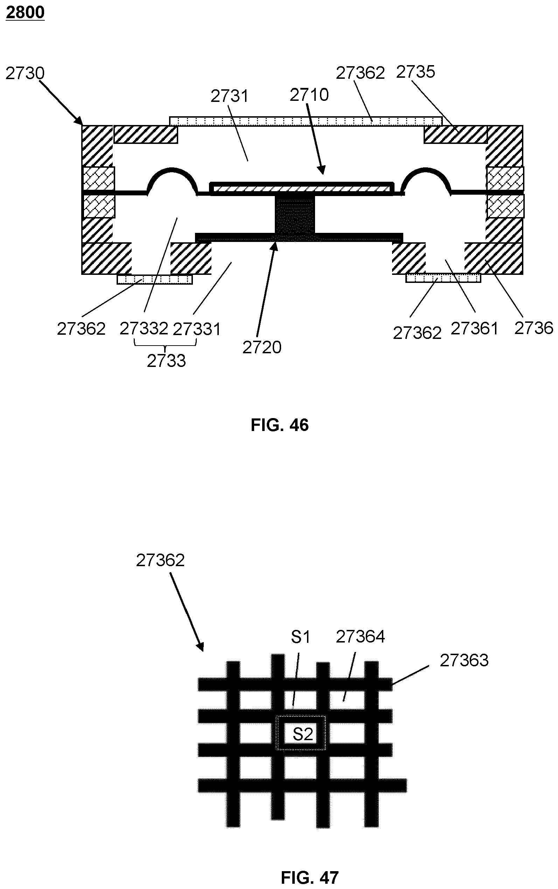

FIG. 46 is a cross-sectional view illustrating a loudspeaker parallel to an axial direction of a cavity of a housing according to some embodiments of the present disclosure.

In some embodiments, as illustrated in FIG. 46, in addition to providing the damping net 27362 at a corresponding position of the at least one of the one or more through holes 27361, the damping net 27362 may also be provided on the front cavity plate 2735. For example, by providing the damping net 27362 corresponding to a first hole portion (the first hole portion 2732 illustrated in FIG. 27), a Q value of a resonance peak in a frequency response curve of the loudspeaker may be further reduced, thereby further making the loudspeaker have better sound quality.

FIG. 47 is a schematic structural diagram illustrating a damping net according to some embodiments of the present disclosure.

In some embodiments, as illustrated in FIG. 47, the damping net 27362 may be woven from a plurality of gauze wires 27363. Pores 27364 of the damping net 27362 may be formed among the plurality of gauze wires 27363. In some embodiments, an acoustic impedance of the damping net 27362 may be related to the porosity of the damping net 27362. The porosity of the damping net 27362 refers to a ratio of area S1 of the pore 27364 to the area S2 of a region enclosed along a centerline of the gauze wires 27366. In some embodiments, the smaller the porosity of the damping net 27362, the greater the acoustic impedance of the damping net 27362. In some embodiments, in order to make the damping net 27362 have a relatively large acoustic impedance to reduce the Q value of a resonance peak in a frequency response curve of the loudspeaker and ensure that the loudspeaker has a better sound quality, the porosity of the damping net may be within a range of 13%-44%. In some embodiments, the acoustic impedance of the damping net 27362 may be related to the size of the pore 27364. In some embodiments, the smaller the size of the pore 27364, the greater the acoustic impedance of the damping net 27362. It should be understood that when the shape of each of the pores 27364 is a circle, the size of each of the pores 27364 refers to the diameter of the circle. When the shape of each of the pores is a rectangle, the size of each of the pores 27364 refers to the length or width of the rectangle. In some embodiments, in order to provide the damping net 27362 with a relatively high acoustic impedance for reducing the Q value of the resonance peak in the frequency response curve of the loudspeaker and ensuring the better sound quality of the loudspeaker, the size of each of the pores 27364 may be within a range of 18-285 $\mu$m.

It should be noted that different embodiments may produce different beneficial effects. In different embodiments, the beneficial effects may be any combination of the above, or other possible beneficial effects.

The basic concept has been described above. Obviously, for those skilled in the art, the above detailed disclosure is only an example, and does not constitute a limitation to the present disclosure. Although not explicitly stated here, those skilled in the art may make various modifications, improvements, and amendments to the present disclosure. These alterations, improvements, and modifications are intended to be suggested by this disclosure and are within the spirit and scope of the exemplary embodiments of this disclosure.

Moreover, certain terminology has been used to describe embodiments of the present disclosure. For example, "one embodiment," "an embodiment," and/or "some embodiments" refer to a certain feature, structure, or characteristic related to at least one embodiment of the present disclosure. Therefore, it should be emphasized and noted that references to "one embodiment," "an embodiment," or "an alternative embodiment" two or more times in different places in the present disclosure do not necessarily refer to the same embodiment. In addition, some features, structures, or features in the present disclosure of one or more embodiments may be appropriately combined.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that the present disclosure object requires more features than the features mentioned in the claims. Rather, claimed subject matter may lie in less than all features of a single foregoing disclosed embodiment.

In some embodiments, counts describing the quantity of components and attributes are used. It should be understood that such counts used in the description of the embodiments use the modifiers "about," "approximately" or "substantially" in some examples. Unless otherwise stated, "about," "approximately" or "substantially" indicates that the stated figure allows for a variation of ±20%. Accordingly, in some embodiments, the numerical parameters used in the disclosure and claims are approximations that can vary depending on the desired characteristics of individual embodiments. In some embodiments, numerical parameters should consider the specified significant digits and adopt the general digit retention method. Although the numerical ranges and parameters used in some embodiments of the present disclosure to confirm the breadth of the range are approximations, in specific embodiments, such numerical values are set as precisely as practicable.

In closing, it is to be understood that the embodiments of the application disclosed herein are illustrative of the principles of the embodiments of the application. Other modifications that may be employed may be within the scope of the application. Thus, by way of example, but not of limitation, alternative configurations of the embodiments of the application may be utilized in accordance with the teachings herein. Accordingly, embodiments of the present application are not limited to that precisely as shown and described.

## Claims

1. A loudspeaker, comprising:

   a driving component configured to generate a vibration based on an electrical signal;
   a vibration component configured to receive the vibration of the driving component to vibrate; and
   a housing, wherein the driving component and the vibration component are disposed in a cavity formed by the housing; wherein

   the cavity includes a front cavity disposed at one side of the vibration component and one or more rear cavities disposed at another side of the vibration component,
   the housing includes a rear cavity plate,
   at least one of the one or more rear cavities is at least enclosed by the driving component, the vibration component, and the rear cavity plate, and
   the rear cavity plate is provided with one or more through holes.

2. The loudspeaker of claim 1, wherein a vibration surface of the driving component forms at least a portion of a sidewall of the at least one of the one or more rear cavities.

3. The loudspeaker of claim 2, wherein the driving component includes a piezoelectric acoustic driver.

4. The loudspeaker of claim 3, wherein the piezoelectric acoustic driver includes cantilever beams.

5. The loudspeaker of claim 4, wherein a gap between adjacent cantilever beams is not greater than 25 $\mu$m.

6. The loudspeaker of claim 2, wherein no less than 90% of a surface region on the vibration surface of the driving component is continuous.

7. The loudspeaker of claim 6, wherein the driving component includes a piezoelectric membrane.

8. The loudspeaker of claim 1, wherein the one or more rear cavities include at least two rear cavities, and the at least two rear cavities communicate with each other through the one or more through holes.

9. The loudspeaker of claim 8, wherein

   the housing includes a rear cavity portion, wherein the rear cavity portion, the rear cavity plate, and the driving component enclose a first rear cavity; and
   the driving component, the vibration component, the rear cavity portion, and the rear cavity plate enclose a second rear cavity.

10. The loudspeaker of claim 9, wherein the rear cavity portion includes a side plate and a sealing plate.

11. The loudspeaker of claim 9, wherein the at least two rear cavities communicate with an outside through one or more sound guiding holes disposed on the rear cavity portion.

12. The loudspeaker of claim 1, wherein a difference between a distance from a centerline of at least one of the one or more through holes to a centerline of the cavity and an equivalent radius of the driving component and a difference between an equivalent radius of the cavity and the equivalent radius of the driving component has a first preset ratio, and the first preset ratio is within a range of 0.3-0.9.

13. The loudspeaker of claim 1, wherein in a plane perpendicular to a centerline of the cavity, a sum of projection areas of the one or more through holes in the plane and a difference between a projection area of the cavity in the plane and a projection area of the driving component in the plane has a second preset ratio, and the second preset ratio is within a range of 0.02-1.

14. The loudspeaker of claim 1, wherein an aperture diameter of at least one of the one or more through holes is within a range of 0.2 mm-2 mm.

15. The loudspeaker of claim 1, wherein at least one of the one or more through holes is provided with a damping net.

16. The loudspeaker of claim 15, wherein an acoustic impedance of the damping net is within a range of 3 MKS rayls-10000 MKS rayls.

17. The loudspeaker of claim 15, wherein a size of each of pores of the damping net is within a range of 18

μm-285 μm.

**18.** The loudspeaker of claim 15, wherein a porosity of the damping net is within a range of 13%-44%.

**100**

**FIG. 1**

**FIG. 2**

Driving part

Deformation position

124

122

Driving part

Deformation position

114     116

124

A-A

**FIG. 3**

Driving part

Deformation position

114     116

124     124

Driving part

Deformation position

124

A-A

**FIG. 4**

100

Driving part

1121    114    116

122

122

B-B

**FIG. 5**

230

240

△f1

△f2

SPL

1000    10000

Hz

**FIG. 6**

FIG. 7A

FIG. 7B

FIG. 7C

FIG. 7D

$S_s$

$S_e$

$S_v$

100

120

1121

114

**FIG. 8A**

810

220

820

$—\alpha=8190mm$ $—\alpha=7146mm$

**FIG. 8B**

**FIG. 9A**

**FIG. 9B**

940  950  960

220

$$\theta=0.3 \qquad \theta=0.19 \qquad - - - \theta=0.27$$

**FIG. 9C**

$S_i$

C

C

100

Deformation
position  122  1121  114  116

C-C

**FIG. 10A**

FIG. 10B

**FIG. 10C**

FIG. 11

**FIG. 12A**

**FIG. 12B**

**FIG. 13A**

**FIG. 13B**

**FIG. 14A**

**FIG. 14B**

100
120
112
114
122
124

**FIG. 14C**

100
120
112
114
122
124

**FIG. 14D**

**FIG. 15A**

**FIG. 15B**

120

θ

124

122

**FIG. 16A**

120

θ

124

122

**FIG. 16B**

**FIG. 16C**

**FIG. 16D**

**FIG. 16E**

**FIG. 16F**

**FIG. 17A**

**FIG. 17B**

FIG. 17C

FIG. 18A

FIG. 18B

FIG. 18C

FIG. 19

**FIG. 20A**

**FIG. 20B**

FIG. 21A

FIG. 21B

FIG. 21C

110
120
1121
114

**FIG. 21D**

110
120
1121
114

**FIG. 21E**

FIG. 22

FIG. 23

**FIG. 24A**

D-D

**FIG. 24B**

FIG. 24C

FIG. 25A

**FIG. 25B**

**FIG. 25C**

**FIG. 26A**

FIG. 26B

FIG. 26C

**FIG. 26D**

**FIG. 26E**

FIG. 27

FIG. 28

**2800**

**FIG. 29**

**2800**

**FIG. 30**

**FIG. 31**

<u>2800</u>

**FIG. 32**

**FIG. 33**

**FIG. 34**

**FIG. 35A**

**FIG. 35B**

FIG. 35C

FIG. 35D

27361

2736

27365

27367

**FIG. 35E**

2736

27365

27361

27367

**FIG. 35F**

**FIG. 36**

**FIG. 37**

27361

**FIG. 38**

L395    L394

L391    L392    L393

Frequency (Hz)

**FIG. 39**

**FIG. 40**

**2800**

**FIG. 41**

**2800**

FIG. 42

**2800**

FIG. 43

FIG. 44

FIG. 45

2800

FIG. 46

FIG. 47

**2720**

**FIG. 48**

**FIG. 49**

## INTERNATIONAL SEARCH REPORT

| | International application No. |
|---|---|
| | **PCT/CN2022/108479** |

| A. | CLASSIFICATION OF SUBJECT MATTER |
|---|---|

H04R 17/00(2006.01)i

According to International Patent Classification (IPC) or to both national classification and IPC

| B. | FIELDS SEARCHED |
|---|---|

Minimum documentation searched (classification system followed by classification symbols)

H04R

Documentation searched other than minimum documentation to the extent that such documents are included in the fields searched

Electronic data base consulted during the international search (name of data base and, where practicable, search terms used)

CNPAT, CNKI, WPI, EPODOC: 扬声器, 喇叭, 发声, 振膜, 振动膜, 振动板, 前, 后, 背, 声腔, 音腔, 室, 孔, 通道, 压电, 阻尼, 网, 孔隙, speaker, diaphragm, vibrating plate, front, back, acoustic cavity, chamber, hole?, channel, piezo, damping

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 207124746 U (GOERTEK TECHNOLOGY CO., LTD.) 20 March 2018 (2018-03-20) description, paragraphs 0030-0059, and figures 1-6 | 1-18 |
| X | CN 206181371 U (CHANGZHOU AMT CO., LTD.) 17 May 2017 (2017-05-17) description, paragraphs 0021-0029, and figure 1 | 1-18 |
| A | CN 113079441 A (BEIJING XIAOMI MOBILE SOFTWARE CO., LTD.) 06 July 2021 (2021-07-06) entire document | 1-18 |
| A | US 2020177996 A1 (MERRY ELECTRONICS (SHENZHEN) CO., LTD.) 04 June 2020 (2020-06-04) entire document | 1-18 |
| A | US 2011085684 A1 (SAMSUNG ELECTRONICS CO., LTD.) 14 April 2011 (2011-04-14) entire document | 1-10 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **17 November 2022** | **25 November 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/108479**

| Patent document cited in search report | | | Publication date (day/month/year) | Patent family member(s) | | | Publication date (day/month/year) |
|---|---|---|---|---|---|---|---|
| CN | 207124746 | U | 20 March 2018 | None | | | |
| CN | 206181371 | U | 17 May 2017 | None | | | |
| CN | 113079441 | A | 06 July 2021 | None | | | |
| US | 2020177996 | A1 | 04 June 2020 | TW | I683460 | B | 21 January 2020 |
| | | | | CN | 109905824 | A | 18 June 2019 |
| US | 2011085684 | A1 | 14 April 2011 | KR | 20110039815 | A | 20 April 2011 |

Form PCT/ISA/210 (patent family annex) (January 2015)

**REFERENCES CITED IN THE DESCRIPTION**

**Patent documents cited in the description**

- CN 202210707415